(19) Europäisches Patentamt
European Patent Office
Office européen des brevets

(11) EP 4 343 875 A1

(12) EUROPEAN PATENT APPLICATION
published in accordance with Art. 153(4) EPC

(43) Date of publication:
27.03.2024 Bulletin 2024/13

(21) Application number: 22804420.2

(22) Date of filing: 30.03.2022

(51) International Patent Classification (IPC):
*H01L 51/50* (2006.01)

(52) Cooperative Patent Classification (CPC):
H10K 50/00

(86) International application number:
PCT/JP2022/015886

(87) International publication number:
WO 2022/244503 (24.11.2022 Gazette 2022/47)

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
KH MA MD TN

(30) Priority: 20.05.2021 JP 2021085129

(71) Applicant: Kyulux, Inc.
Fukuoka-shi, Fukuoka 819-0388 (JP)

(72) Inventors:
- YOSHIZAKI, Makoto
Fukuoka-shi, Fukuoka 819-0388 (JP)
- ENDO, Ayataka
Fukuoka-shi, Fukuoka 819-0388 (JP)

(74) Representative: Zimmermann & Partner Patentanwälte mbB
Postfach 330 920
80069 München (DE)

# (54) ORGANIC LIGHT EMITTING ELEMENT

(57) An organic light emitting device containing: a light emitting layer having a first organic compound (1), a second organic compound (2) which is a delayed fluorescent material, and a third organic compound (3); and an adjacent layer adjacent to the light emitting layer, and satisfying $E_{S1}(1)>E_{S1}(2)>E_{S1}(3)$, has a long emission lifetime and high light emission efficiency. Esi represents a lowest excited singlet energy.

FIG. 1

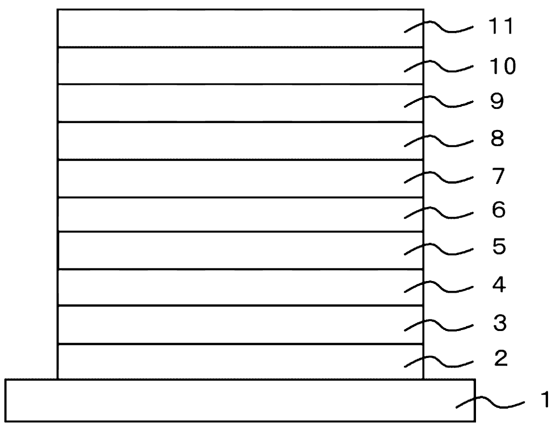


EP 4 343 875 A1

## Description

### Technical Field

The present invention relates to an organic light emitting device using a delayed fluorescent material.

### Background Art

Studies for enhancing the light emission efficiency of organic light-emitting devices such as organic electroluminescent devices (organic EL devices) are being made actively. In particular, various kinds of efforts have been made for increasing light emission efficiency by newly developing and combining an electron transporting material, a hole transporting material, a host material and a light emitting material to constitute an organic electroluminescent device. Among them, there are seen studies relating to an organic light emitting device that utilizes a delayed fluorescent material.

A delayed fluorescent material is a material which, in an excited state, after having undergone reverse intersystem crossing from an excited triplet state to an excited singlet state, emits fluorescence when returning back from the excited singlet state to a ground state thereof. Fluorescence through the route is observed later than fluorescence from the excited singlet state directly occurring from the ground state (ordinary fluorescence), and is therefore referred to as delayed fluorescence. Here, for example, in the case where a light-emitting compound is excited through carrier injection thereinto, the occurring probability of the excited singlet state to the excited triplet state is statistically 25%/75%, and therefore improvement of light emission efficiency by the fluorescence alone from the directly occurring excited singlet state is limited. On the other hand, in a delayed fluorescent material, not only the excited singlet state thereof but also the excited triplet state can be utilized for fluorescent emission through the route via the above-mentioned reverse intersystem crossing, and therefore as compared with an ordinary fluorescent material, a delayed fluorescent material can realize a higher emission efficiency.

As such a delayed fluorescent material, there has been proposed a benzene derivative having a heteroaryl group such as a carbazolyl group or a diphenylamino group, and at least two cyano groups, and it has been confirmed that an organic EL device using the benzene derivative in a light emitting layer provides a high emission efficiency (see PTL 1).

Also, NPL 1 reports that a carbazolyldicyanobenzene derivative (4CzTPN) is a thermally activated delayed fluorescent material and that an organic electroluminescent device using the carbazolyldicyanobenzene derivative attained a high internal EL quantum efficiency.

On the other hand, using a delayed fluorescent material in a light emitting layer as an assist dopant but not as a light emitting material therein has been reported (see PTL 2). This describes adding, in addition to a host material and a fluorescent material, a delayed fluorescent material having an intermediate lowest excited singlet energy between the host material and the fluorescent light emitting material to the light emitting layer to improve emission efficiency.

### Citation List

#### Patent Literature

PTL 1: JP2014-43541A
PTL 2: JP2015-179809A

#### Non-Patent Literature

NPL 1: H. Uoyama, et al., Nature 492, 234 (2012)

### Summary of Invention

#### Technical Problem

As described above, in the Patent literature 1, the Patent literature 2 and the Non-patent literature 1, it has been reported that the organic electroluminescent device using a delayed fluorescent material obtained a high light emission efficiency. On the other hand, in order to provide an organic electroluminescent device having high practicality, it is necessary to further increase the light emission efficiency and extend the device lifetime. However, it is not easy to further improve the light emission efficiency and the device lifetime, and its course of action has not been cleared.

Under these circumstances, the present inventors carried out intensive studies with the aim of improving the light emission efficiency and device lifetime of the organic light emitting device using the delayed fluorescent material.

Solution to Problem

As a result of the intensive studies to achieve the above aim, the present inventors found that the organic light emitting device having the high light emission efficiency and the long device lifetime can be obtained by using the materials satisfying the specific condition in the light emitting layer and the adjacent layer. The present invention is proposed based on these findings, and specifically has the following configuration.

[1] An organic light emitting device containing:

a light emitting layer having a first organic compound, a second organic compound, and third organic compound, satisfying the following condition (a); and
an adjacent layer adjacent to the light emitting layer,

in which the second organic compound is a delayed fluorescent material,
in which the adjacent layer contains the first organic compound,

$$\text{condition (a): } E_{S1}(1)>E_{S1}(2)>E_{S1}(3),$$

wherein $E_{S1}(1)$ represents a lowest excited singlet energy of the first organic compound,
Esi(2) represents a lowest excited singlet energy of the second organic compound, and
Esi(3) represents a lowest excited singlet energy of the third organic compound.

[2] The organic light emitting device according to the item [1],
in which the adjacent layer is composed only of the first organic compound.
[3] The organic light emitting device according to item the [1] or [2],
in which the emitting layer is between an anode and a cathode, and the adjacent layer is adjacent to the anode side of the light emitting layer.
[4] The organic light emitting device according to any one of the items [1] to [3], in which a thickness of the adjacent layer is less than 10 nm.
[5] The organic light emitting device according to any one of the items [1] to [4], in which the thickness of the adjacent layer is less than one-sixth of the thickness of the light emitting layer.
[6] The organic light emitting device according to any one of the items [1] to [5], in which a difference $\Delta E_{st}$ between the lowest excited singlet state energy and the lowest excited triplet state energy at 77K of the second organic compound is 0.3 eV or less.
[7] The organic light emitting device according to any one of the items [1] to [6], in which a difference $\Delta E_{st}$ between the lowest excited singlet state energy and the lowest excited triplet state energy at 77K of the third organic compound is 0.3 eV or less.
[8] The organic light emitting device according to any one of the items [1] to [7], in which the first organic compound, the second organic compound and the third organic compound satisfy the following condition (b),

$$\text{condition (b): } E_{T1}(1)>E_{T1}(2)>E_{T1}(3),$$

in which $E_{T1}(1)$ represents a lowest excited triplet energy at 77K of the first organic compound,
$E_{T1}(2)$ represents a lowest excited triplet energy at 77K of the second organic compound, and
$E_{T1}(3)$ represents a lowest excited triplet energy at 77K of the third organic compound.

[9] The organic light emitting device according to any one of the items [1] to [8], in which the light emitting layer is composed only of a compound containing atoms selected from the group consisting of carbon atom, hydrogen atom, deuterium atom, nitrogen atom, boron atom, oxygen atom and sulfur atom.
[10] The organic light emitting device according to any one of the items [1] to [9],
in which the first organic compound is a compound containing atoms selected from the group consisting of carbon atom, hydrogen atom, deuterium atom, nitrogen atom, and oxygen atom.

[11] The organic light emitting device according to any one of the items [1] to [10], in which the second organic compound is a compound containing atoms selected from the group consisting of carbon atom, hydrogen atom, deuterium atom, nitrogen atom, oxygen atom and sulfur atom.

[12] The organic light emitting device according to any one of the items [1] to [11],
in which the third organic compound is a compound containing atoms selected from the group consisting of carbon atom, hydrogen atom, deuterium atom, nitrogen atom, boron atom, oxygen atom and sulfur atom.

[13] The organic light emitting device according to any of the items [1] to [12], in which the second organic compound contains a cyano-benzene structure.

[14] A method of producing an organic light emitting device containing:

forming a light emitting layer having a first organic compound, a second organic compound which is a delayed fluorescent material, and a third organic compound, and forming an adjacent layer having the first organic compound so as to be adjacent to the light emitting layer,
or,
forming an adjacent layer having a first organic compound, and forming a light emitting layer having the first organic compound, a second organic compound which is a delayed fluorescent material, and a third organic compound so as to be adjacent to the adjacent layer,

in which the first organic compound, the second organic compound and the third organic compound satisfy the following condition (a),

$$\text{condition (a): } E_{S1}(1)>E_{S1}(2)>E_{S1}(3),$$

wherein $E_{S1}(1)$ represents a lowest excited singlet energy of the first organic compound,
Esi(2) represents a lowest excited singlet energy of the second organic compound, and
Esi(3) represents a lowest excited singlet energy of the third organic compound.

Advantageous Effects of Invention

The organic light emitting device of the present invention has long device lifetime and high light emission efficiency. In addition, by using the producing method of the present invention, the organic light emitting device having long device lifetime and high light emission efficiency, can be easily produced.

Brief Description of Drawings

[FIG. 1] This is a cross-sectional view showing a layer configuration example of an organic electroluminescent device.
[FIG. 2] This is a flowchart showing processes for carrying out a method of producing an organic light emitting device.

Description of Embodiments

The contents of the present invention will be explained in detail below. The constituent elements may be described below with reference to representative embodiments and specific examples of the present invention, but the present invention is not limited to the embodiments and the examples. In this description, a numerical range expressed as "to" means a range which includes the numerical values described before and after "to" as the lower limit value and the upper limit value. Further, in this description, "consisting of" means that it contains only what is described before "consisting of" and does not contain anything else. Furthermore, some or all of the hydrogen atom that is present in the compounds used in the present invention can be substituted with deuterium atom ($^2H$, deuterium D). In the chemical structural formulas in this description, the hydrogen atoms are indicated as H or their indications are omitted. For example, when an indication of an atom bonded to the carbon atom constituting the ring skeleton of a benzene ring is omitted, it is assumed that H is bonded to the carbon atom constituting the ring skeleton of a benzene ring, at the position where the indication is omitted. In this description, the term "substituent" means an atom or group pf atoms other than a hydrogen atom and a deuterium atom. On the other hand, the term "substituted or unsubstituted" means that a hydrogen atom can be substituted by a deuterium atom or a substituent.

(Characteristics of organic light emitting device)

The organic light emitting device of the present invention contains a light emitting layer having a first organic compound, a second organic compound, and a third organic compound, and an adjacent layer adjacent to the light emitting layer. The adjacent layer contains the first organic compound which is the same as what is contained in the light emitting layer.

The second organic compound is a delayed fluorescent material, and the first organic compound, the second organic compound, and the third organic compound satisfy the following condition (a).

$$\text{condition (a): } E_{S1}(1)>E_{S1}(2)>E_{S1}(3),$$

In this description, Esi(1) represents a lowest excited singlet energy of the first organic compound, Esi(2) represents a lowest excited singlet energy of the second organic compound, and Esi(3) represents a lowest excited singlet energy of the third organic compound. In this description, eV is used as the unit.

The difference Esi(1)-Esi(2), between the lowest excited singlet energy of the first organic compound and the second compound, can be in the range of 0.3 eV or higher, in the range of 0.5 eV or higher, or in the range of 0.7 eV or higher, and can be in the range of 1.6 eV or lower, in the range of 1.3 eV or lower, or in the range of 0.9 eV or lower.

The difference Esi(2)-Esi(3), between the lowest excited singlet energy of the second organic compound and the third compound, can be in the range of 0.03 eV or higher, or in the range of 0.06 eV or higher, and can be in the range of 0.6 eV or lower, in the range of 0.3 eV or lower, or in the range of 0.1 eV or lower.

In one preferred embodiment of the present invention, the first organic compound, the second organic compound, and the third organic compound satisfy the following condition (b).

$$\text{condition (b): } E_{T1}(1)>E_{T1}(2)>E_{T1}(3),$$

$E_{T1}(1)$ represents a lowest excited triplet energy at 77K (Kelvin) of the above described first organic compound, $E_{T1}(2)$ represents a lowest excited triplet energy at 77K of the above described second organic compound, $E_{T1}(3)$ represents a lowest excited triplet energy at 77 K of the above described third organic compound, and $E_{T1}(Q)$ represents a lowest excited triplet energy at 77K of the above described third organic compound. In this description, eV is used as the unit.

The difference Esi(1)-Esi(2), between the lowest excited singlet energy of the first organic compound and the second organic compound, can be in the range of 0.3 eV or higher, in the range of 0.5 eV or higher, or in the range of 0.7 eV or higher, and can be in the range of 1.6 eV or lower, in the range of 1.3 eV or lower, or in the range of 0.9 eV or lower.

The difference between the lowest excited singlet energy of the second organic compound and the third organic compound, Esi(2)-Esi(3), can be in the range of 0.03 eV or higher, or in the range of 0.06 eV or higher, and can be in the range of 0.6 eV or lower, in the range of 0.3 eV or lower, or in the range of 0.1 eV or lower.

The contents of the first organic compound, the second organic compound, and the third organic compound contained in the light emitting layer of the organic light emitting device of the present invention preferably satisfy the following the condition (c).

$$\text{Condition(c): Conc(1)>Conc(2)>Conc(3)}$$

Conc(1) represents a concentration of the first organic compound in the light emitting layer, Conc(2) represents a concentration of the second compound in the light emitting layer, and Conc(3) represents a concentration of the third organic compound in the light emitting layer. In this description, % by weight is used as the unit.

In the organic light emitting device of the present invention, Conc(1) is preferably 30 % by weight or more, and can be in the range of 50 % by weight or more, or in the range of 65 % by weight or more, and can be in the range of 99 % by weight or less, in the range of 85 % by weight or less, or in the range of 75 % by weight or less.

In the organic light emitting device of the present invention, Conc(2) is preferably 10 % by weight or more, and can be in the range of 20 % by weight or more, or in the range of 30 % by weight or more, and can be in the range of 45 % by weight or less, in the range of 40 % by weight or less, or in the range of 35 % by weight or less.

In the organic light emitting device of the present invention, Conc(3) is preferably 5 % by weight or less, more preferably 3 % by weight or less. Conc(3) can be in the range of 1 % by weight or less, or in the range of 0.5 % by weight or less, and can be in the range of 0.01 % by weight or more, in the range of 0.1 % by weight, or in the range of 0.3 % by weight or more. In addition, it is preferably that the following condition (d) is satisfied.

Condition(d): Conc(2)/Conc(3)>5

Conc(2)/Conc(3) can be in the range of 10 or more, in the range of 30 or more, or in the range of 50 or more, and can be in the range of 500 or less, in the range of 300 or less, or in the range of 100 or less.

The organic light emitting device of the present invention contains the first organic compound in the adjacent layer adjacent to the light emitting layer. Adjacent described here means that the light emitting layer and the adjacent layer is in the stacked state, and means that the surface of the light emitting layer and the surface of the adjacent layer are directly contacted. The adjacent layer may be stacked on the light emitting layer, or the light emitting layer may be stacked on the adjacent layer.

In the preferred embodiment of the present invention, the organic light emitting device has a structure having an organic layer containing a light emitting layer between an anode and a cathode, formed so that the adjacent layer containing the first organic compound is adjacent to the anode side of the light emitting layer. In this case, the layer adjacent to the cathode side of the light emitting layer does not contain the first organic compound.

The adjacent layer is preferably composed only of the first organic compound, but may also be the layer which mainly contains the first organic compound, and also contains a compound having a lowest excited singlet energy and a lowest excited triplet energy, which are close to the lowest excited singlet energy (Esi) and the lowest excited triplet energy ($E_{T1}$) of the first organic compound. Close energy described here means that the difference of energy is less than 0.1eV, and is preferably less than 0.05 eV, more preferably less than 0.03 eV, still more preferably less than 0.01 eV The concentration of the first organic compound in the adjacent layer is preferably 90 % by weight or more, more preferably 99 % by weight or more, and for example, can be 99.9 % by weight or more, or 99.99 % by weight or more.

The thickness of the adjacent layer is preferably 1nm or more, more preferably 3 nm or more, and for example can be 5 nm or more. The thickness of the adjacent layer is preferably less than 20nm, more preferably less than 10 nm,and for example can be less than 7 nm.

The thickness of the adj acent layer is preferably smaller than the thickness of the light emitting layer. The thickness of the adjacent layer is preferably one-second of the light emitting layer or less, more preferably one-fourth or less, and for example can be one-sixth or less. In addition, it is preferably one-twentieth or more, and for example can be one-tenth or more.

(First Organic Compound)

The first organic compound is an organic compound having larger lowest excited singlet energy than the second organic compound and the third organic compound. The first organic compound has a function as a host material responsible for transporting a carrier, and a function of confining the energy of the second organic compound and the third organic compound. Thereby, energy generated by re-bonding a hole and an electron in a molecule can be efficiently converted into the light emission.

The HOMO (Highest Occupied Molecular Orbital) level of the first organic compound is preferably deeper (lower energy) than HOMO level of the charge transfer material contained in the organic layer in which the adjacent layer is adjacent to the light emitting layer on the opposite side. For example, the HOMO level of the first organic compound is preferably 0.1 eV or more deeper than the HOMO level of the charge transfer material contained in the adjacent organic layer, and for example can be 0.2 eV or more deeper or 0.25 eV or more deeper. The upper limit can be, for example, less than 0.5 eV, or less than 0.3 eV The HOMO level of the first organic compound is preferably close to the HOMO level of the second organic compound. The difference is preferably less than 0.3 eV, more preferably less than 0.2 eV, and for example can be less than 0.1 eV, or less than 0.05 eV In the preferred embodiment of the present invention, the HOMO level of the first organic compound is deeper than the HOMO level of the second organic compound.

The first organic compound is preferably an organic compound having a hole transporting ability and an electron transporting ability, preventing the light emission from being a longer wavelength, and having a high glass transition temperature. In addition, in the preferred embodiment of the present invention, the first organic compound is selected from compounds which do not emit delayed fluorescence.

The first organic compound is preferably a compound composed only of atoms selected from the group consisting of carbon atom, hydrogen atom, deuterium atom, nitrogen atom, oxygen atom and sulfur atom. For example, the first organic compound may be a compound composed only of atoms selected from the group consisting of carbon atom, hydrogen atom, deuterium atom, nitrogen atom, and oxygen atom. For example, the first organic compound may be a compound containing only carbon atom, hydrogen atom, nitrogen atom, and oxygen atom. Further, the first organic compound may be a compound composed only of atoms selected from the group consisting of carbon atom, hydrogen atom, deuterium atom, nitrogen atom, and sulfur atom. Further, the first organic compound may be a compound composed only of atoms selected from the group consisting of carbon atom, hydrogen atom, deuterium atom, and nitrogen atom. The first organic compound may be a compound which does not contain a cyano group. The first organic compound

may be a compound which contain only one carbazole ring. The first organic compound may be a compound which contain only one methaphenylene group. The first organic compound may be a compound which contain a dibenzofuran structure or a dibenzothiophene structure. The first organic compound may be a compound other than 3,3'-di(9H-carbazol-9-yl)biphenyl (mCBP).

Preferred compound examples for use as the first organic compound are shown below.

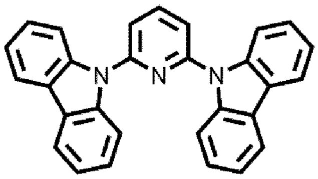

H1

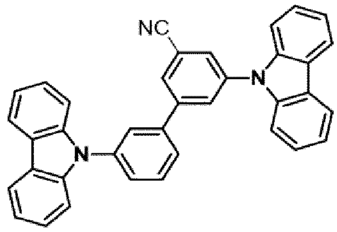

H2

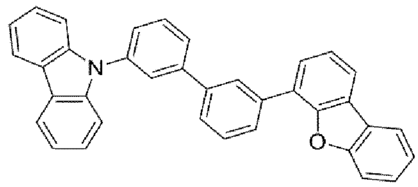

H3

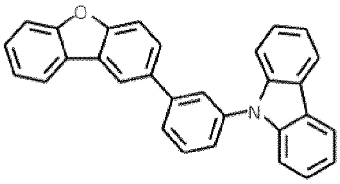

H4

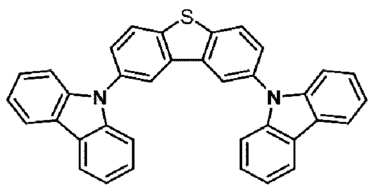

H5

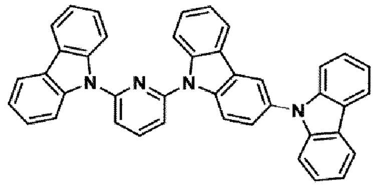

H6

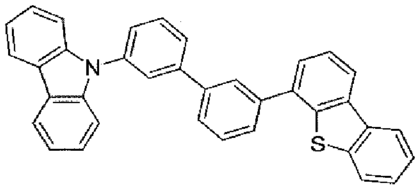

H7

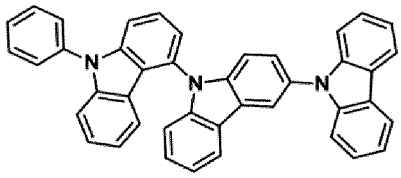

H8

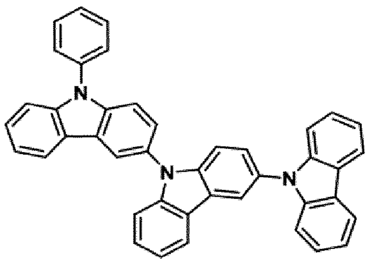

H9

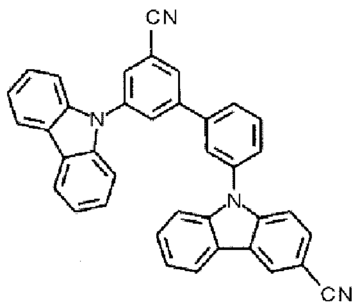

H10

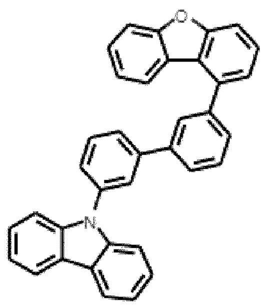

H11

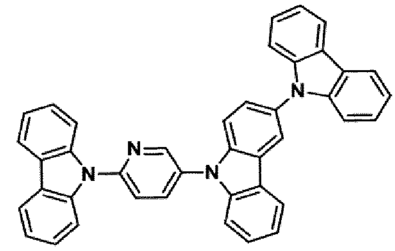

H12

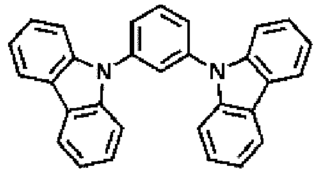

H13

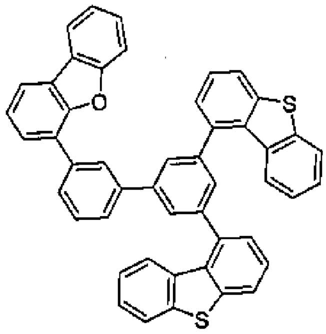

H14

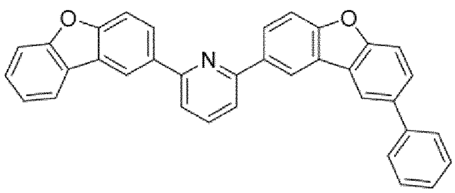

H15

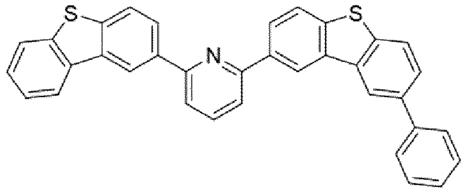

H16

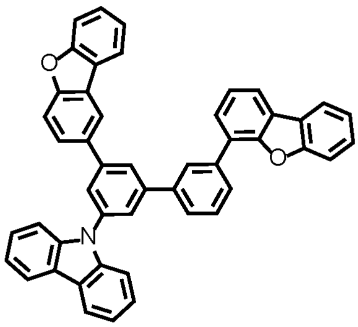

H17

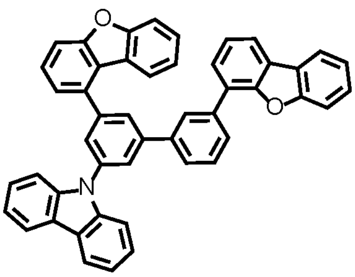

H18

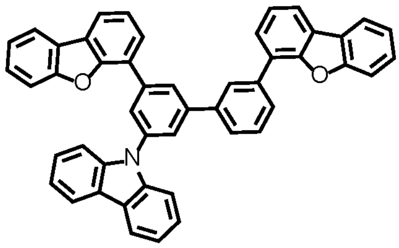

H19

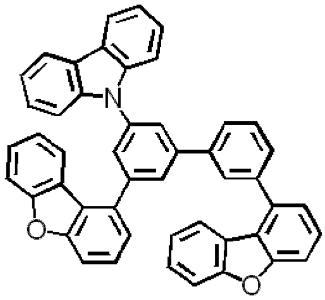

H20

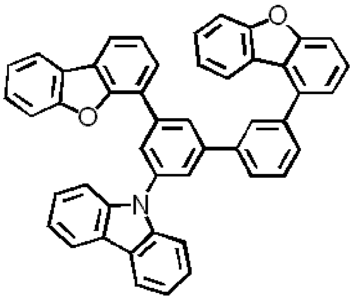

H21

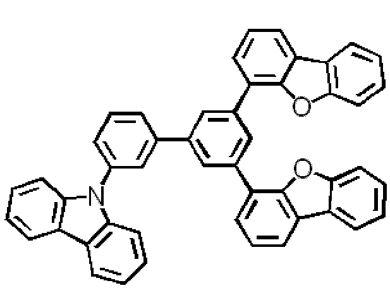

H22

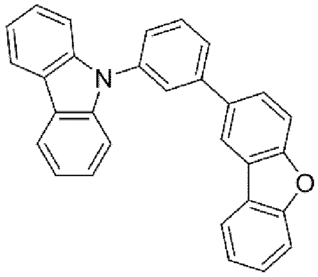

**H23**

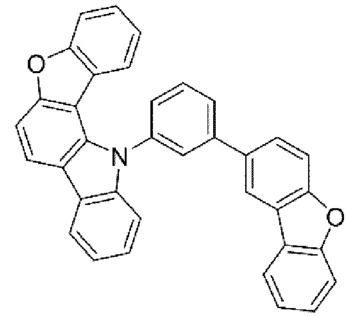

**H24**

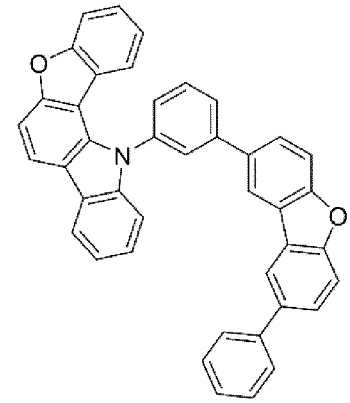

**H25**

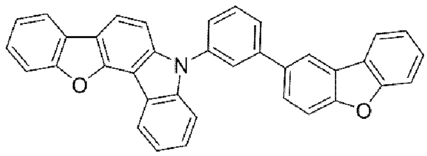

**H26**

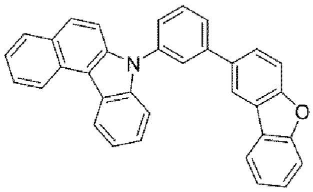

**H27**

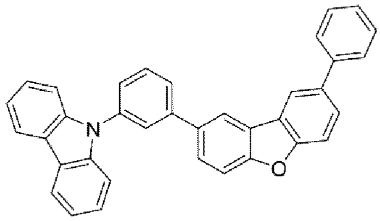

**H28**

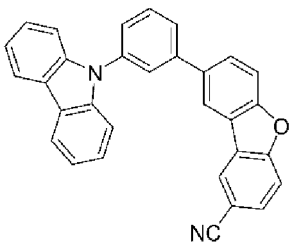

**H29**

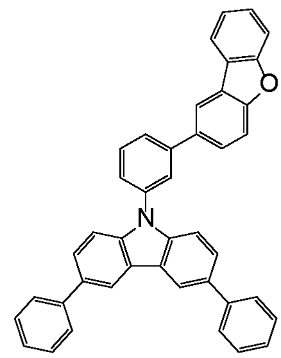

**H30**

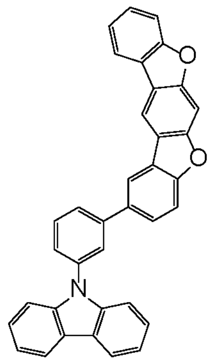

**H31**

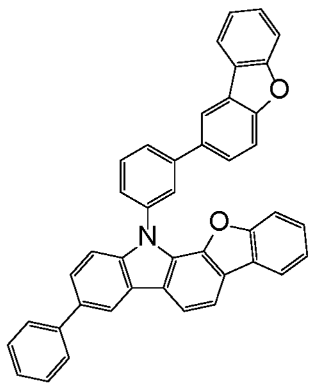

**H32**

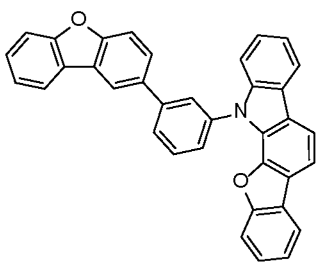

**H33**

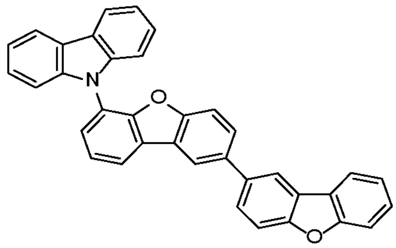

**H34**

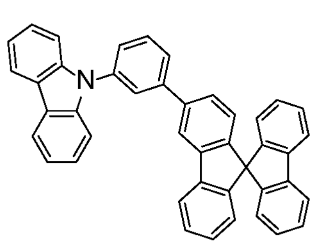

**H35**

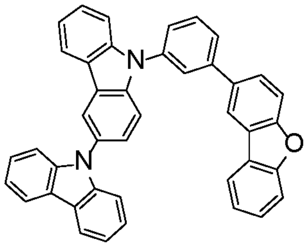

**H36**

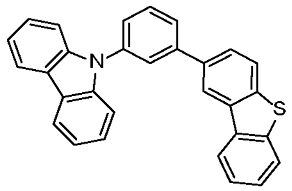

**H37**

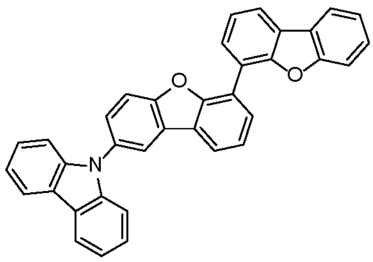

**H38**

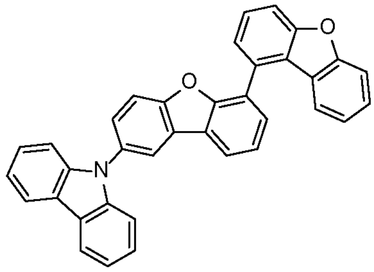

**H39**

(Second Organic Compound)

The second organic compound used in the organic light emitting device of the present invention is a delayed fluorescent material. "Delayed fluorescent material" in the present invention is an organic compound which, in an excited state, undergoes reverse intersystem crossing from an excited triplet state to an excited singlet state, and which emits fluorescence (delayed fluorescence) in returning back from the excited singlet state to a ground state. In the present invention, a compound which gives fluorescence having an emission lifetime of 100 ns (nanoseconds) or longer, when the emission lifetime is measured with a fluorescence lifetime measuring system (e.g., streak camera system by Hamamatsu Photonics KK), is referred to as a delayed fluorescent material.

The second organic compound is preferably such that the difference $\Delta E_{ST}(2)$ between the lowest excited singlet energy and the lowest excited triplet energy at 77K is 0.3 eV or less, more preferably 0.25 eV or less, even more preferably 0.2 eV or less, further more preferably 0.15 eV or less, further more preferably 0.1 eV or less, further more preferably 0.07 eV or less, further more preferably 0.05 eV or less, further more preferably 0.03 eV or less, particularly preferably 0.01 eV or less.

When $\Delta E_{ST}(2)$ is smaller, reverse intersystem crossing from an excited triplet state to an excited singlet state can more readily occur through thermal energy absorption, and therefore the second organic compound can function as a thermal activation type delayed fluorescent material. A thermal activation type delayed fluorescent material can absorb heat generated by a device to relatively readily undergo reverse intersystem crossing from an excited triplet state to an excited singlet state, and can make the excited triplet energy efficiently contribute toward light emission.

In the invention, the difference $\Delta E_{ST}$ between a lowest excited singlet energy level (Esi) and a lowest excited triplet energy level ($E_{T1}$) of a compound is determined according to the following process. $\Delta E_{ST}$ is a value determined by calculating Esi - $E_{T1}$. (1) Lowest excited singlet energy (Esi)

A thin film or a toluene solution (concentration: $10^{-5}$ mol/L) of the targeted compound is prepared as a measurement sample. The fluorescent spectrum of the sample is measured at room temperature (300 K). For the fluorescent spectrum, the emission intensity is on the vertical axis and the wavelength is on the horizontal axis. A tangnt line is drawn to the rising of the emission spectrum on the short wavelength side, and the wavelength value λedge [nm] at the intersection between the tangent line and the horizontal axis is read. The wavelength value is converted into an energy value according to the following conversion expression to calculate Esi.

$$\text{Conversion Expression: } E_{S1}\ [\text{eV}] = 1239.85/\lambda\text{edge}$$

For the measurement of the emission spectrum in Examples given below, an LED light source (by Thorlabs Corporation, M340L4) was used as an excitation light source along with a detector (by Hamamatsu Photonics K.K., PMA-12 Multichannel Spectroscope C 1 0027 -01).

(2) Lowest excited triplet energy ($E_{T1}$)

The same sample as that for measurement of the lowest excited singlet energy (Esi) is cooled to 77 [K] with liquid nitrogen, and the sample for phosphorescence measurement is irradiated with excitation light (300 nm), and using a detector, the phosphorescence thereof is measured. The emission after 100 milliseconds from irradiation with the excitation light is drawn as a phosphorescent spectrum. A tangent line is drawn to the rising of the phosphorescent spectrum on the short wavelength side, and the wavelength value λedge [nm] at the intersection between the tangent line and the horizontal axis is read. The wavelength value is converted into an energy value according to the following conversion expression to calculate $E_{T1}$.

$$\text{Conversion Expression: } E_{T1}\ [\text{eV}] = 1239.85/\lambda\text{edge}$$

The tangent line to the rising of the phosphorescent spectrum on the short wavelength side is drawn as follows. While moving on the spectral curve from the short wavelength side of the phosphorescent spectrum toward the maximum value on the shortest wavelength side among the maximum values of the spectrum, a tangent line at each point on the curve toward the long wavelength side is taken into consideration. With rising thereof (that is, with increase in the vertical axis), the inclination of the tangent line increases. The tangent line drawn at the point at which the inclination value has a maximum value is referred to as the tangent line to the rising on the short wavelength side of the phosphorescent spectrum.

The maximum point having a peak intensity of 10% or less of the maximum peak intensity of the spectrum is not included in the maximum value on the above-mentioned shortest wavelength side, and the tangent line drawn at the point which is closest to the maximum value on the shortest wavelength side and at which the inclination value has a maximum value is referred to as the tangent line to the rising on the short wavelength side of the phosphorescent spectrum.

The second organic compound is a delayed fluorescent material which has a smaller lowest excited singlet energy than the first organic compound, and larger lowest excited singlet energy than the third organic compound. The second organic compound may be a compound which can emit a delayed fluorescence under some conditions. In the organic light emitting device of the present invention, it is not essential to emit a delayed fluorescence derived from the second organic compound, and the light emission from the third organic compound is a main light emission. In the organic light emitting device of the present invention, the second organic compound receives energy from the first organic compound that are in excited singlet state, and transits to an excited singlet state. In addition, the second organic compound may receive energy from the first organic compound that are in excited triplet state, and may transit to an excited triplet state. Since the second organic compound has a small $\Delta E_{ST}$, the second organic compound of the excited triplet state is easy to undergo reverse intersystem crossing to the excited singlet state of the second organic compound. The second organic compound, that is in excited singlet state, generated through the route gives energy to the third organic compound, which makes the third organic compound transit to the excited singlet state.

In the preferred embodiment of the present invention, the respective compounds are selected and combined so that there is an overlap between the emission wavelength region of the first organic compound and the absorption wavelength region of the second organic compound. In particularly, it is preferably that the edge of the emission spectrum of the first organic compound on the short wavelength side and the edge of the absorption spectrum of the second organic compound on the long wavelength side are overlapped (crossed).

The second organic compound is preferably a compound composed only of atoms selected from the group consisting of carbon atom, hydrogen atom, deuterium atom, nitrogen atom, oxygen atom and sulfur atom. For example, the second organic compound may be a compound composed only of atoms selected from the group consisting of carbon atom, hydrogen atom, deuterium atom, nitrogen atom, and oxygen atom. For example, the second organic compound may be a compound containing only carbon atom, hydrogen atom, nitrogen atom, and oxygen atom. Further, the second organic compound may be a compound composed only of atoms selected from the group consisting of carbon atom, hydrogen atom, deuterium atom, nitrogen atom, and sulfur atom. Further, the second organic compound may be a compound composed only of atoms selected from the group consisting of carbon atom, hydrogen atom, deuterium atom, and nitrogen atom. The second organic compound may be a compound which contains one cyano group. The second organic compound may be a compound which contains two cyano groups. Furthermore, the second organic compound may be a compound which does not contain a cyano group. The second organic compound may be a compound which contains a carbazole ring. The second organic compound may be a compound which contains a substituent carbazolyl group and an unsubstituted carbazolyl group. The second organic compound may be a compound which contains a dibenzofuran structure or a dibenzothiophene structure. The second organic compound may be a compound which contains a triazine ring.

Preferred compound examples for use as the second organic compound are shown below. In the structural formulas of the following exemplary compounds, t-Bu represents a tertiary butyl group.

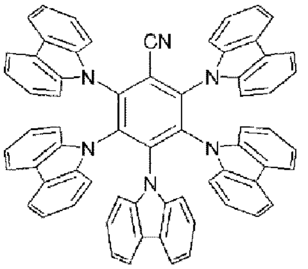

**T1**

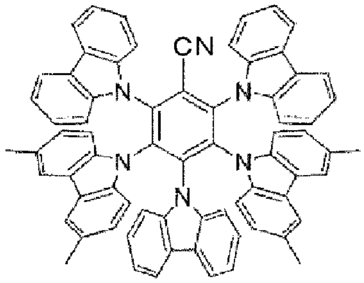

**T2**

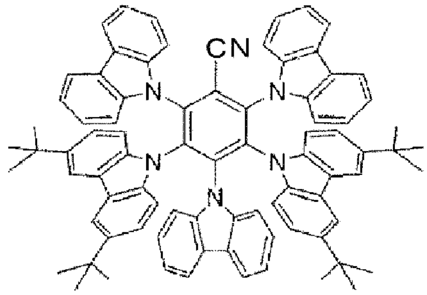

**T3**

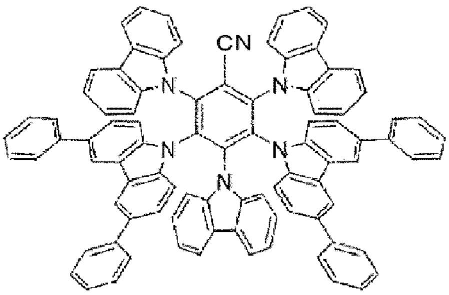

**T4**

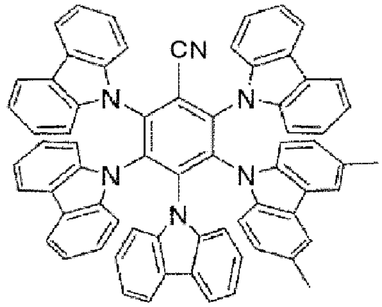

**T5**

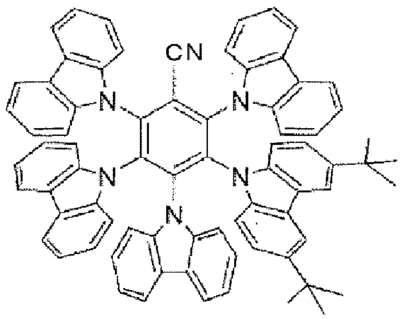

**T6**

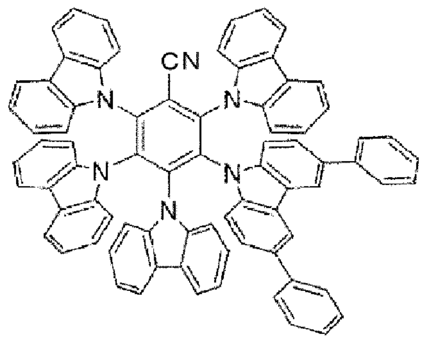

**T7**

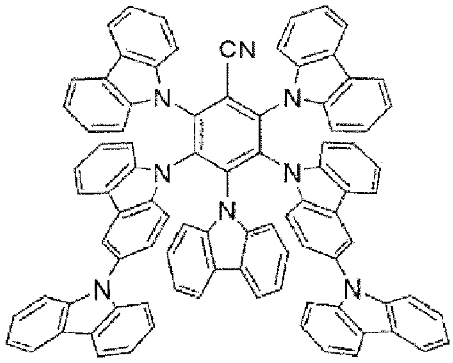

**T8**

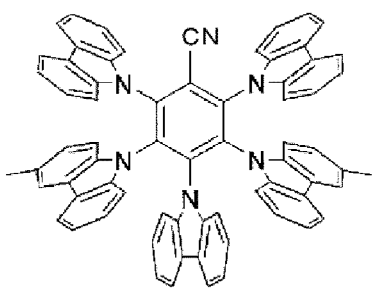

**T9**

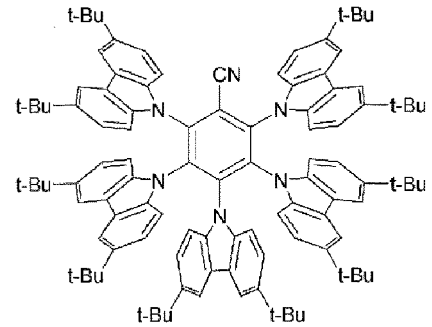

**T10**

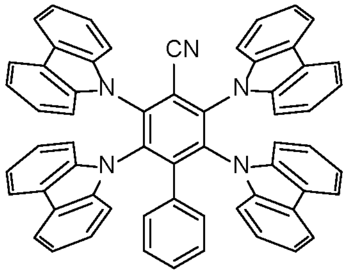

**T11**

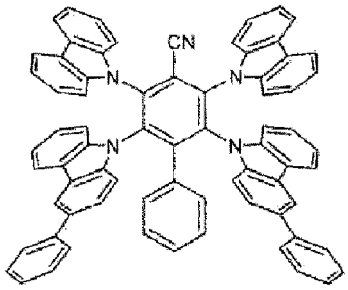

**T12**

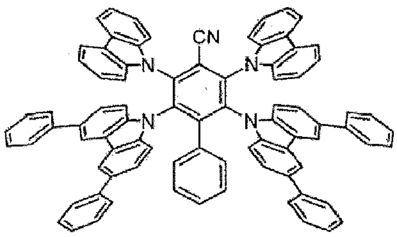

**T13**

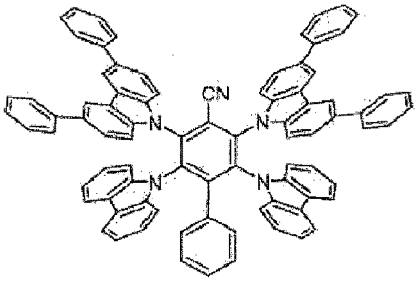

**T14**

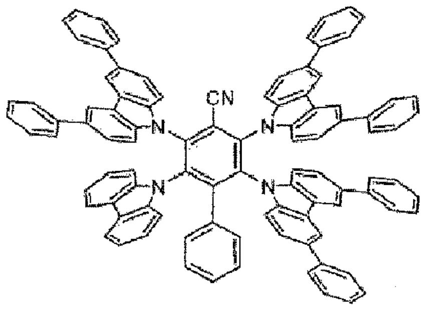

**T15**

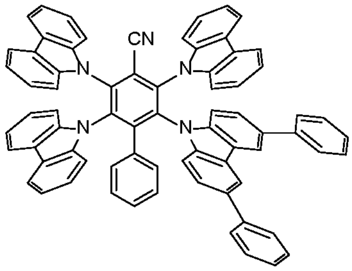

**T16**

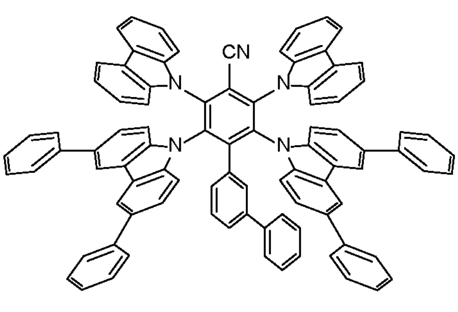

**T17**

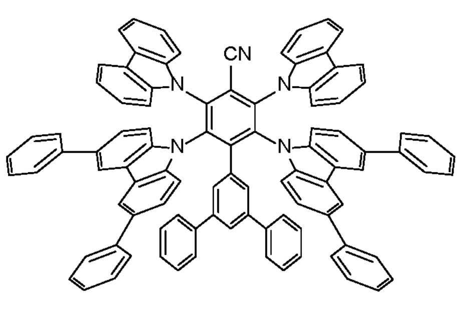

**T18**

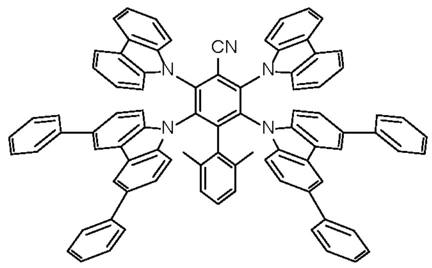

**T19**

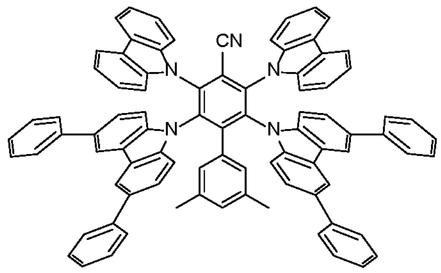

**T20**

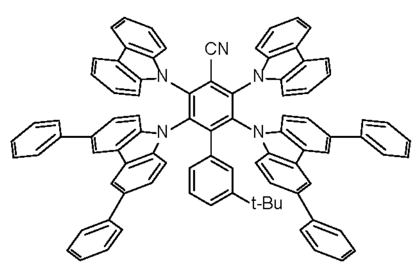

**T21**

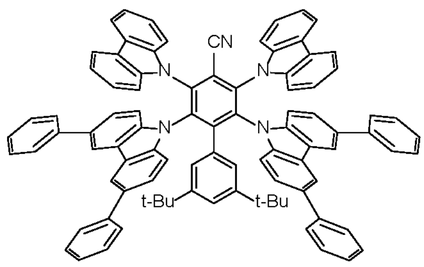

**T22**

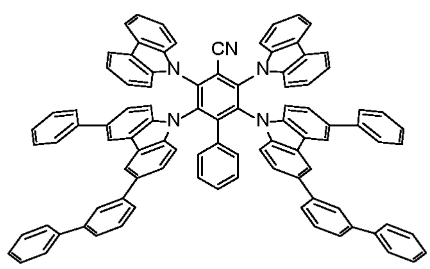

**T23**

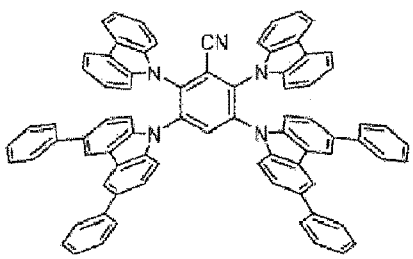

**T24**

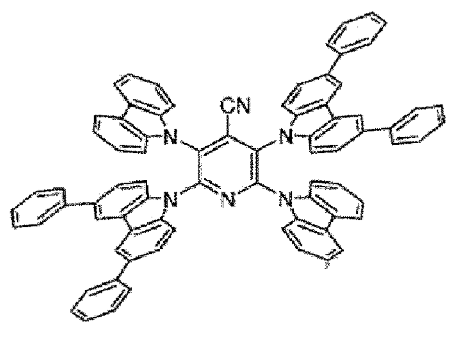

**T25**

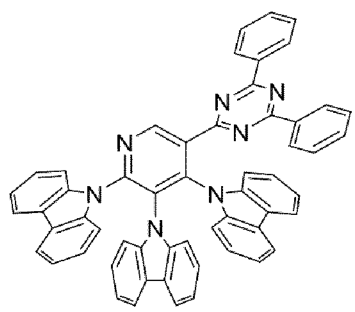

**T26**

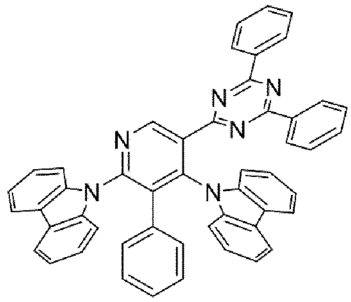

**T27**

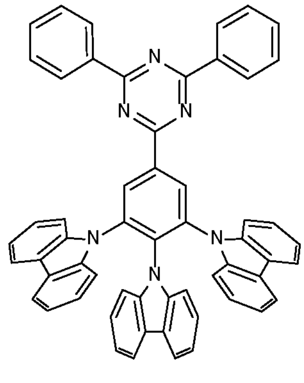

**T28**

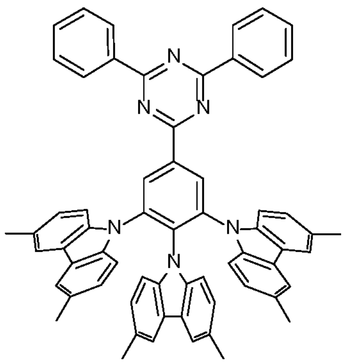

**T29**

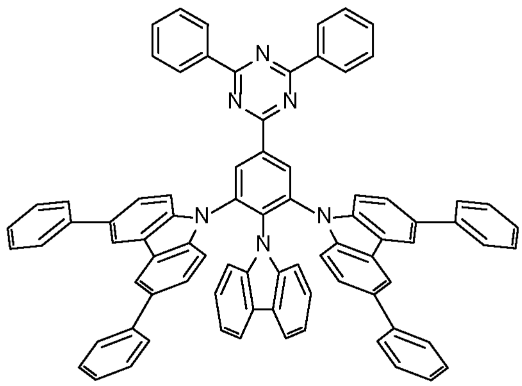

**T30**

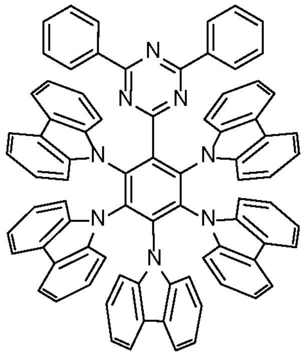

**T31**

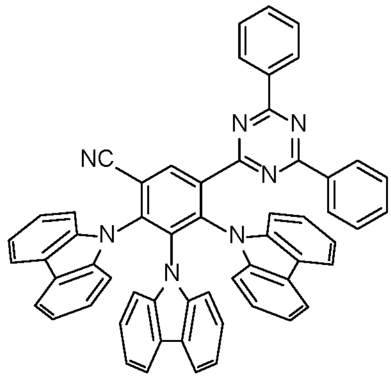

**T32**

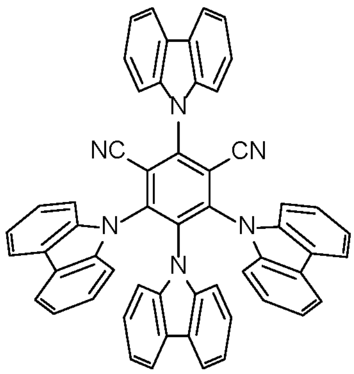

**T33**

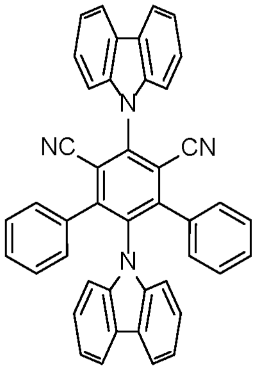

**T34**

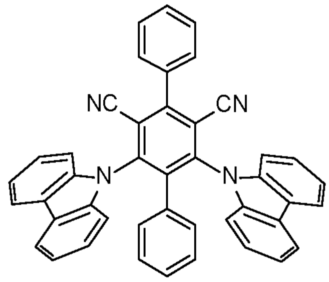

**T35**

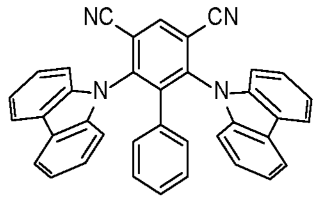

**T36**

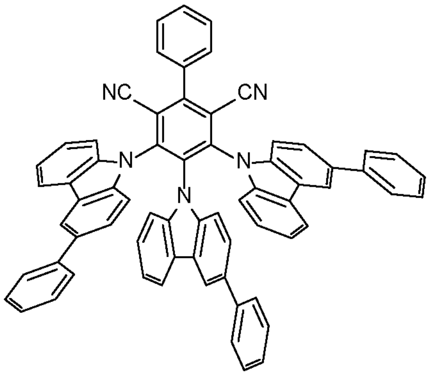

**T37**

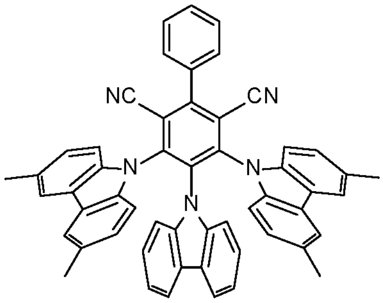

**T38**

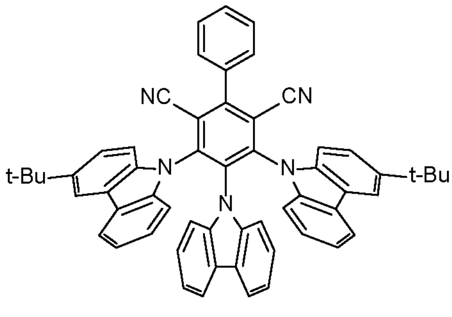

**T39**

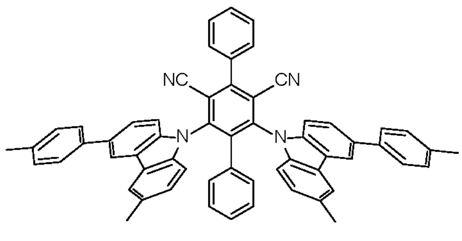

**T40**

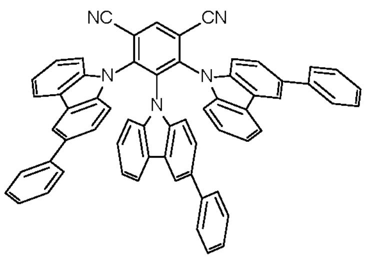

**T41**

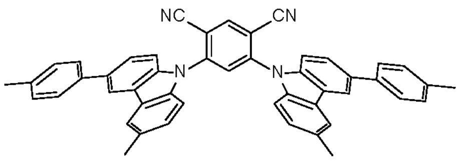

**T42**

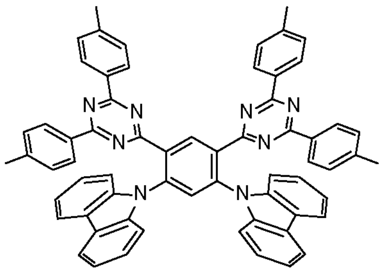

T43

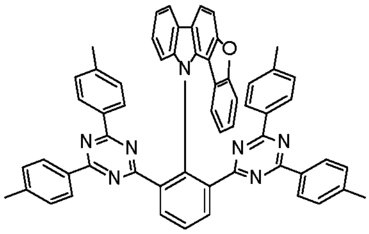

T44

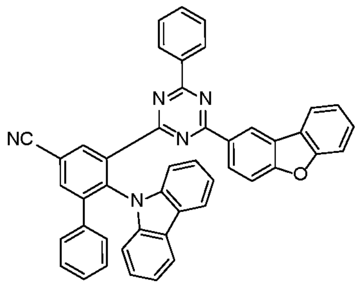

T45

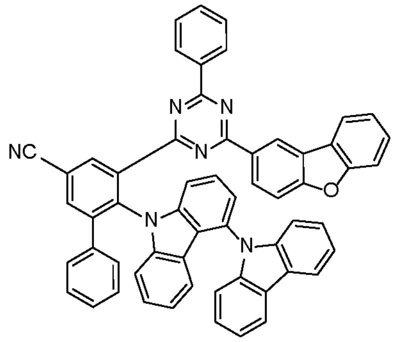

T46

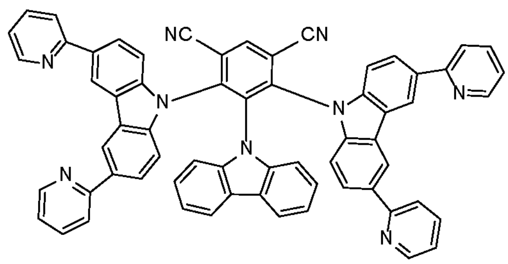

T47

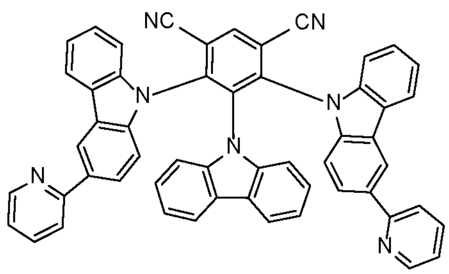

T48

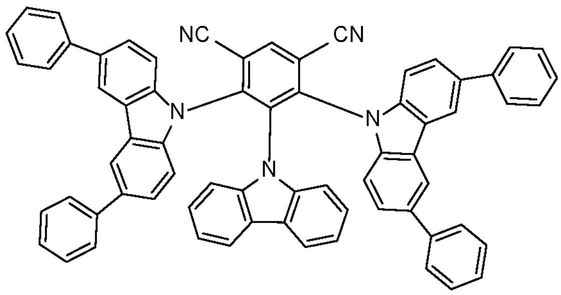

T49

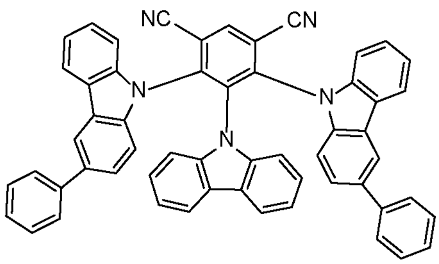

T50

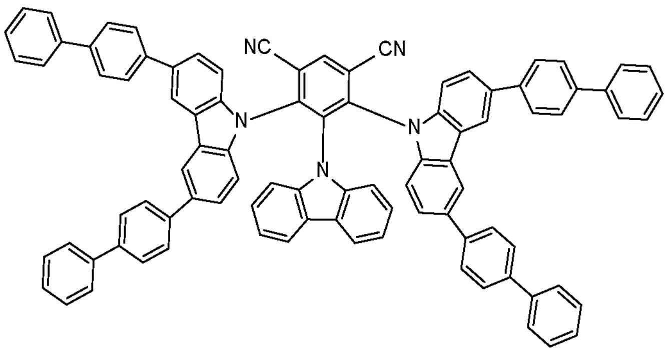

T51

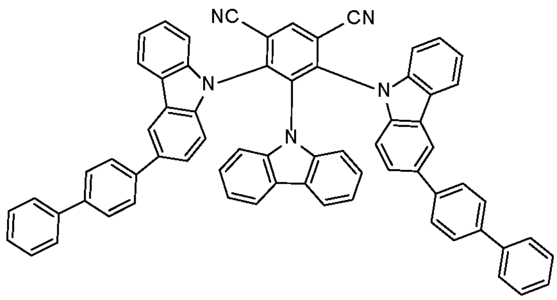

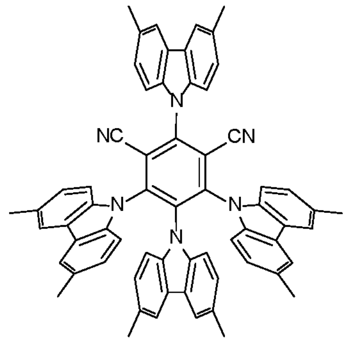

T52

T53

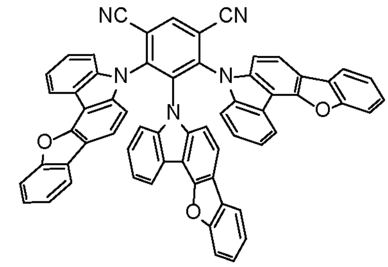

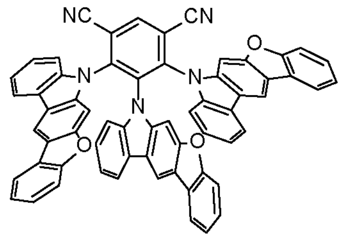

T54

T55

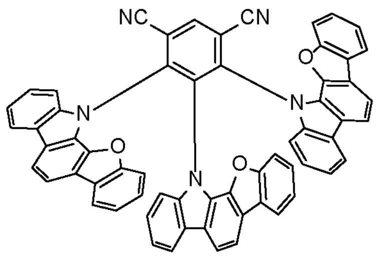

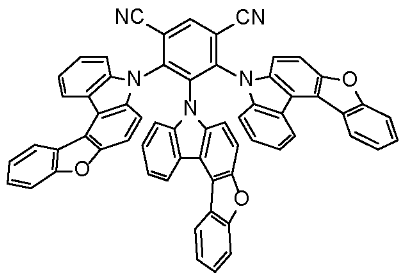

T56

T57

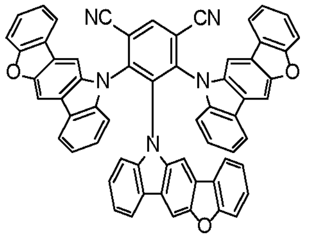

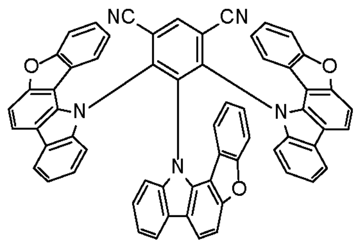

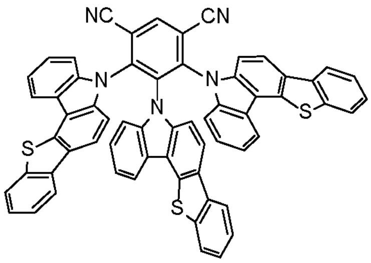

T58

T59

T60

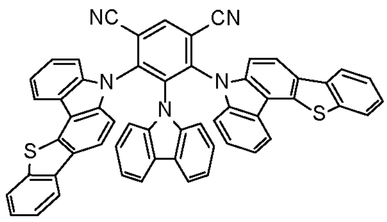

**T61**

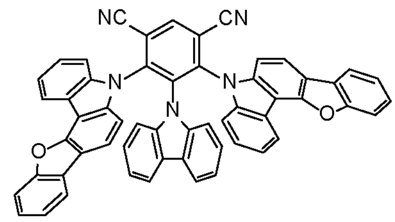

**T62**

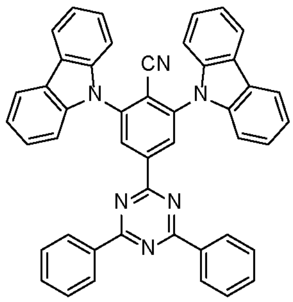

**T63**

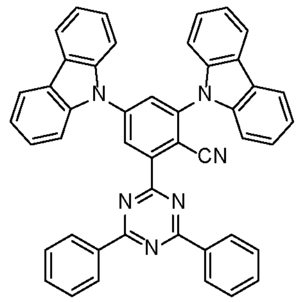

**T64**

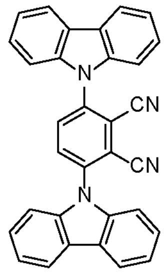

**T65**

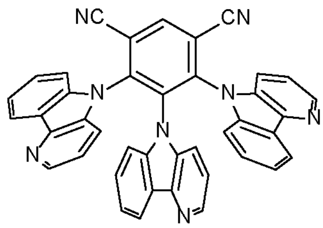

**T66**

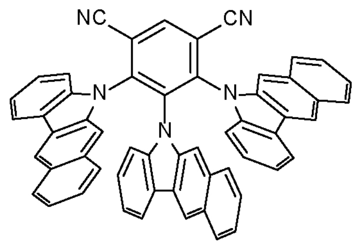

**T67**

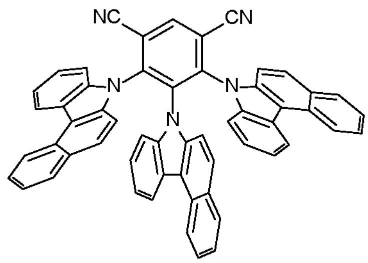

**T68**

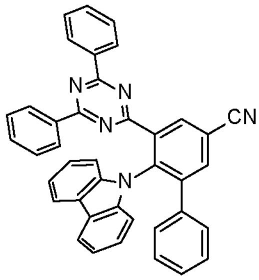

**T69**

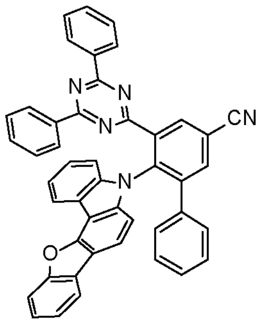

**T70**

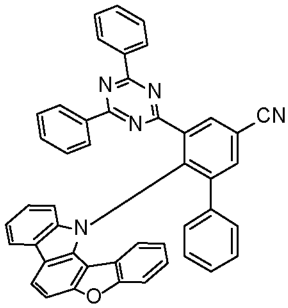

**T71**

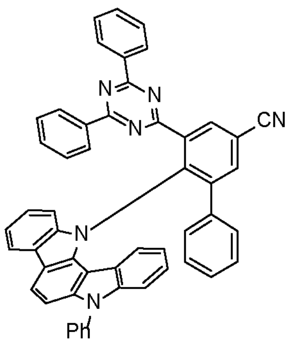

**T72**

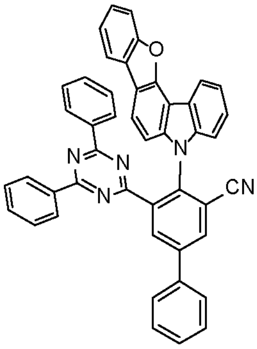 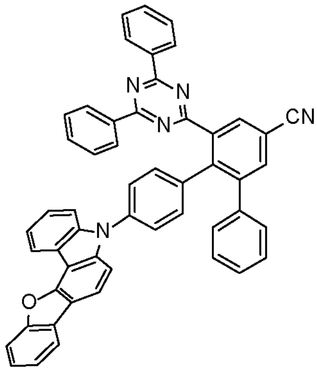 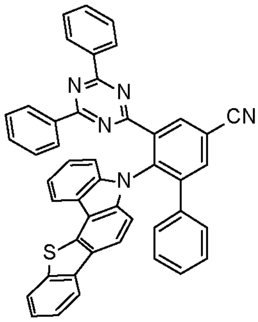 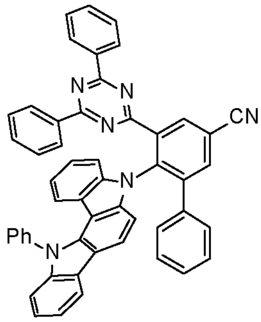

**T73** **T74** **T75** **T76**

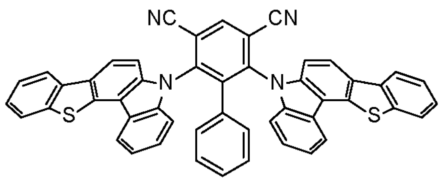 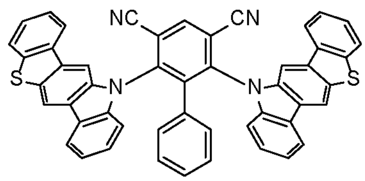

**T77** **T78**

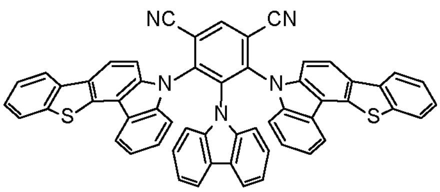 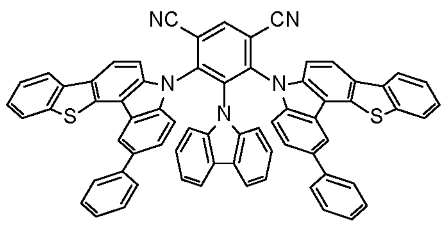

**T79** **T80**

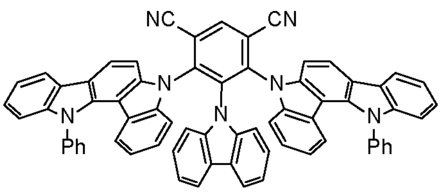 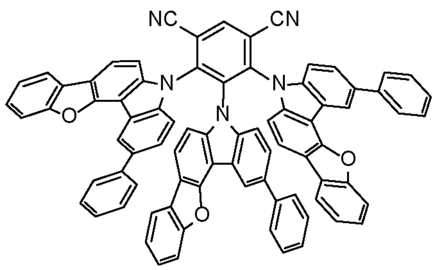

**T81** **T82**

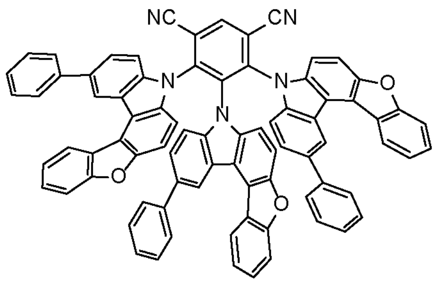

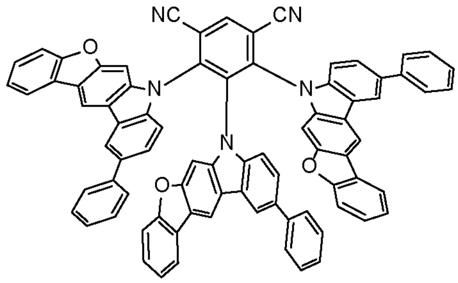

**T83** **T84**

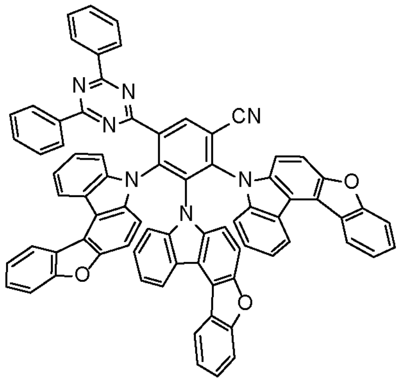

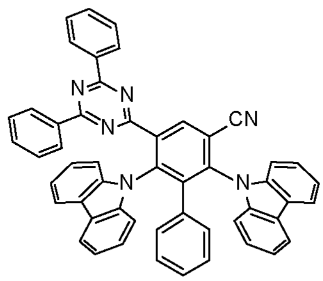

**T85** **T86**

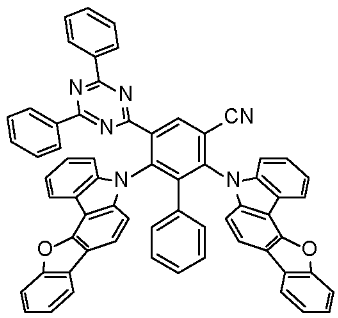

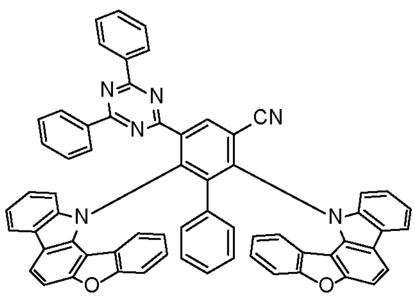

**T87** **T88**

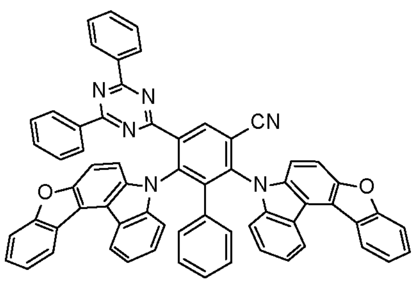

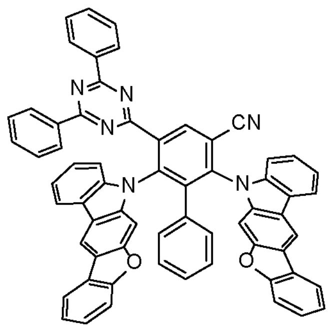

**T89** **T90**

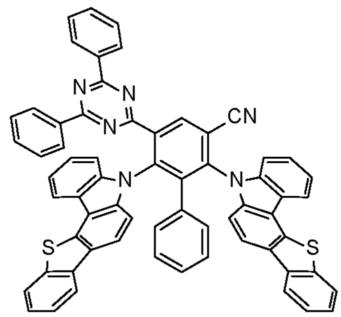

**T91**

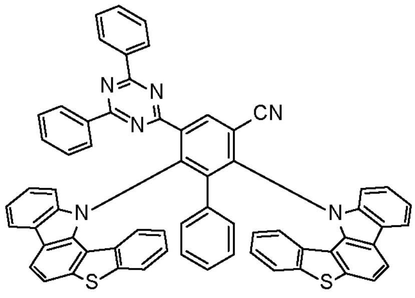

**T92**

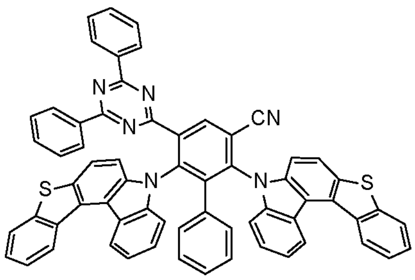

**T93**

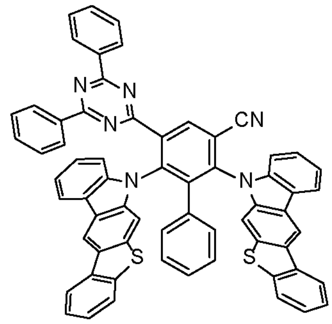

**T94**

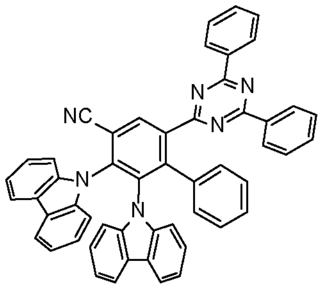

**T95**

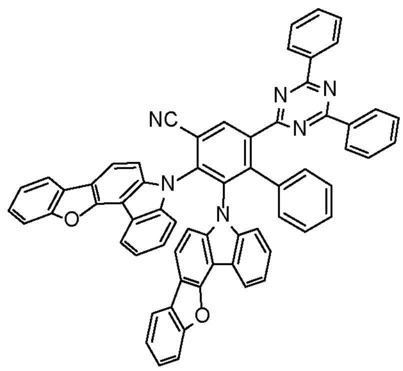

**T96**

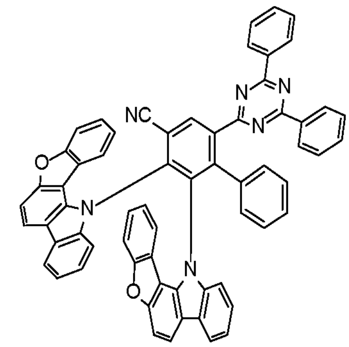

**T97**

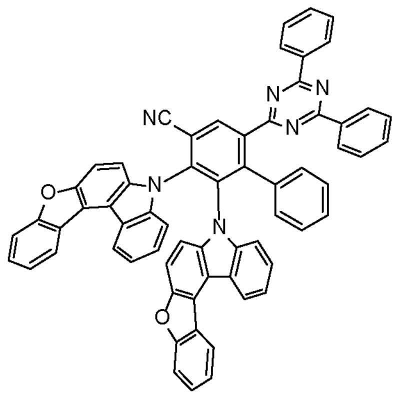

**T98**

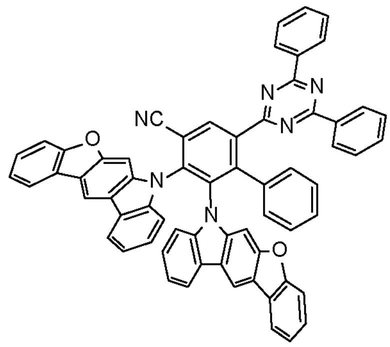

**T99**

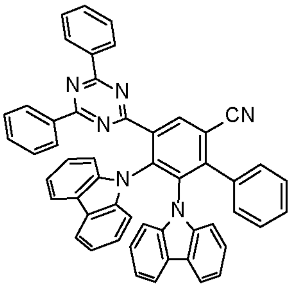

**T100**

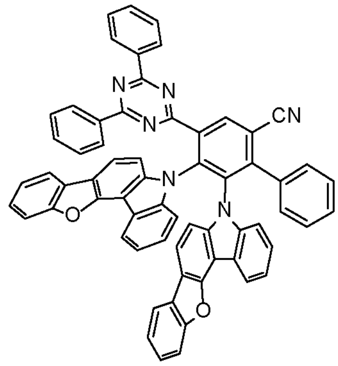

**T101**

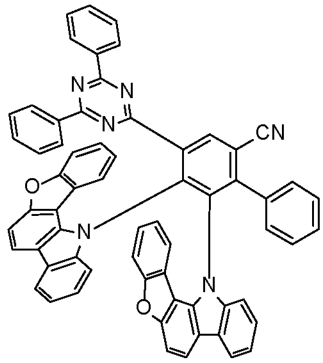

**T102**

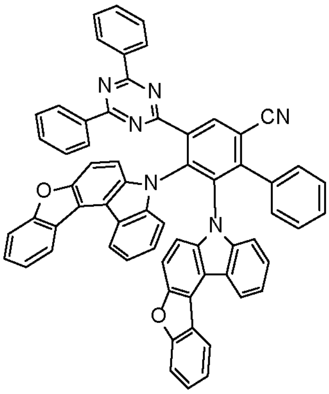

**T103**

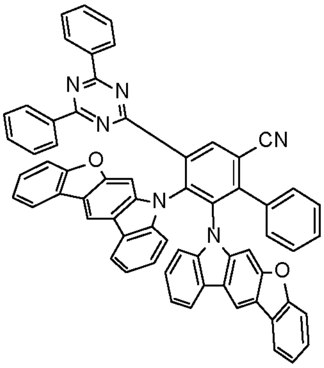

**T104**

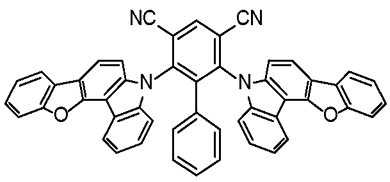

**T105**

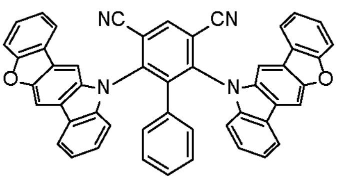

**T106**

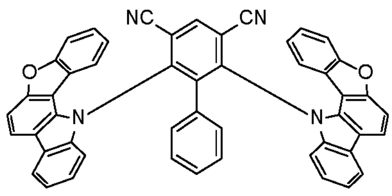

**T107**

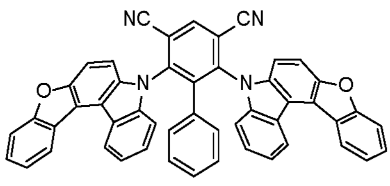

**T108**

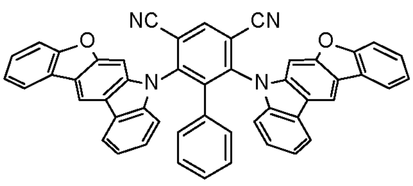

**T109**

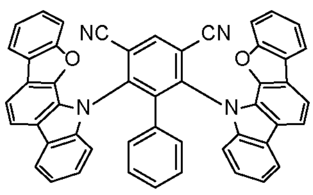

**T110**

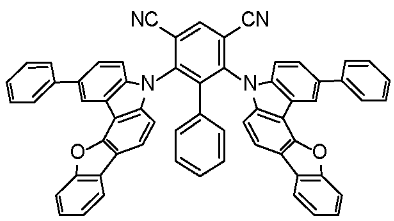

T111

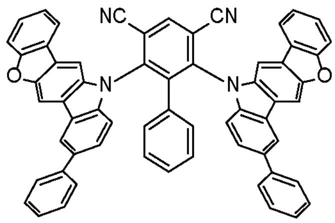

T112

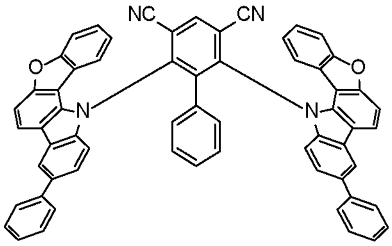

T113

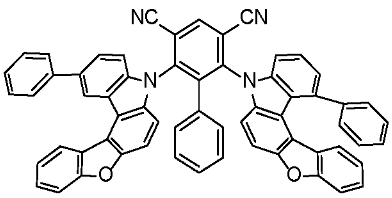

T114

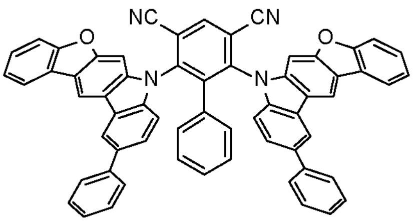

T115

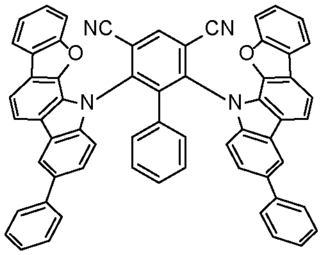

T116

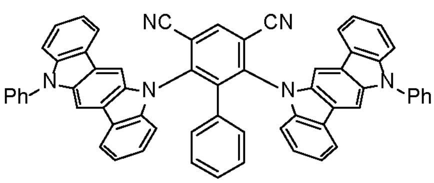

T117

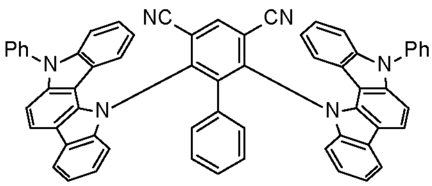

T118

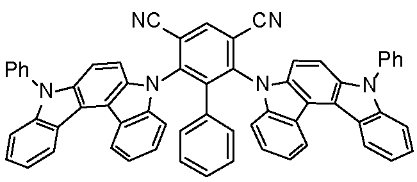

T119

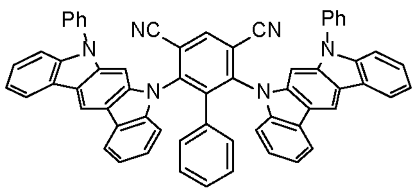

T120

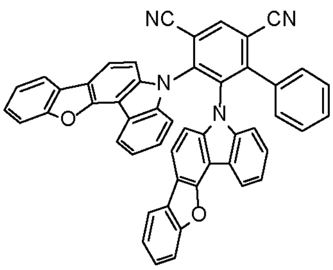

T121

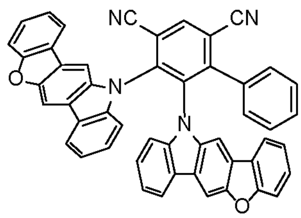

T122

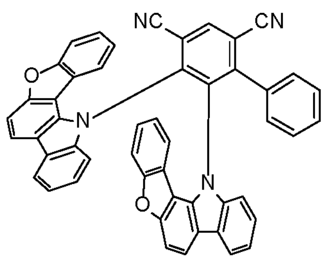

T123

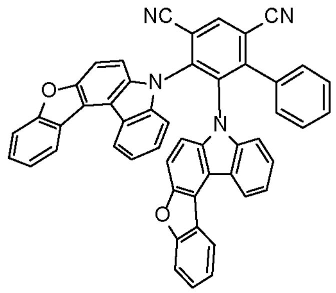

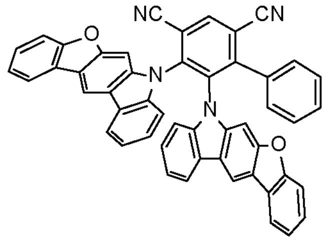

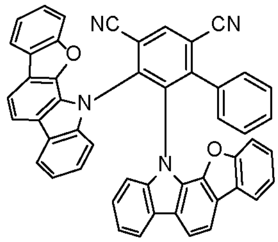

T124 T125 T126

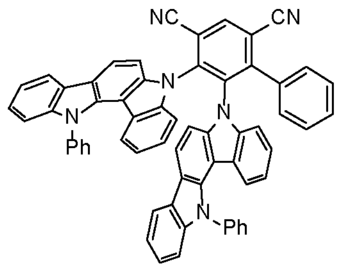

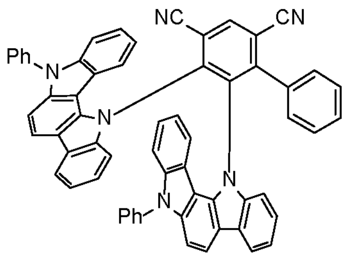

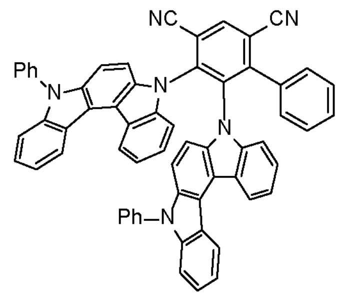

T127 T128 T129

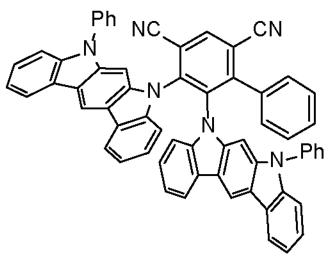

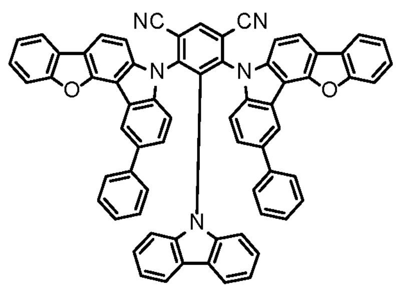

T130 T131

Any other known delayed fluorescent materials than the above can be appropriately combined and used as the second organic compound. In addition, unknown delayed fluorescent materials can also be used.

As preferred delayed fluorescent materials, there can be mentioned compounds included in the general formulae described in WO2013/154064, paragraphs 0008 to 0048 and 0095 to 0133; WO2013/011954, paragraphs 0007 to 0047 and 0073~0085; WO2013/011955, paragraphs 0007 to 0033 and 0059 to 0066; WO2013/081088, paragraphs 0008 to 0071 and 0118 to 0133; JP 2013-256490 A, paragraphs 0009 to 0046 and 0093 to 0134; JP 2013-116975 A, paragraphs 0008 to 0020 and 0038 to 0040; WO2013/133359, paragraphs 0007 to 0032 and 0079 to 0084; WO2013/161437, paragraphs 0008 to 0054 and 0101~0121; JP 2014-9352 A, paragraphs 0007 to 0041 and 0060 to 0069; and JP 2014-9224 A, paragraphs 0008 to 0048 and 0067 to 0076; JP 2017-119663 A, paragraphs 0013 to 0025; JP 2017-119664 A, paragraphs 0013 to 0026; JP 2017-222623 A, paragraphs 0012 to 0025; JP 2017-226838 A, paragraphs 0010 to 0050; JP 2018-100411 A, paragraphs 0012 to 0043; WO2018/047853, paragraphs 0016 to 0044; and especially, exemplary compounds therein capable of emitting delayed fluorescence. In addition, also preferably employable here are light emitting materials capable of emitting delayed fluorescence, as described in JP 2013-253121 A, WO2013/133359, WO2014/034535, WO2014/115743, WO2014/122895, WO2014/126200, WO2014/136758, WO2014/133121, WO2014/136860, WO2014/196585, WO2014/189122, WO2014/168101, WO2015/008580, WO2014/203840, WO2015/002213, WO2015/016200, WO2015/019725, WO2015/072470, WO2015/108049, WO2015/080182, WO2015/072537, WO2015/080183, JP 2015-129240 A, WO2015/129714, WO2015/129715, WO2015/133501, WO2015/136880, WO2015/137244, WO2015/137202, WO2015/137136, WO2015/146541 and WO2015/159541. These patent publications described in this paragraph are hereby incorporated as a part of this description by reference.

A compound represented by the following general formula (1) and capable of emitting delayed fluorescence is preferably employed as the delayed fluorescent material in the present invention. In a preferred embodiment of the present invention, the compound represented by the general formula (1) can be employed as the second organic compound.

General Formula (1)

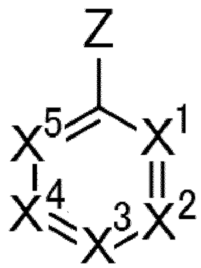

In the general formula (1), $X^1$ to $X^5$ each represent N or C-R. R represents a hydrogen atom, a deuterium atom or a substituent. When at least two of $X^1$ to $X^5$ are (C-R)'s, these (C-R)'s can be the same as or different from each other. However, at least one of $X^1$ to $X^5$ is C-D (where D represents a donor group). When all $X^1$ to $X^5$ are (C-R)'s, Z represents an acceptor group, and at least one of $X^1$ to $X^5$ is N, Z represents a hydrogen atom, a deuterium atom or a substituent.

Of the compound represented by the general formula (1), especially preferred is a compound represented by the following general formula (2).

General Formula (2)

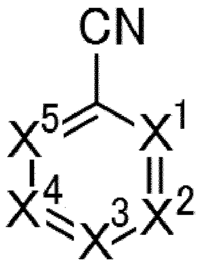

In the general formula (2), $X^1$ to $X^5$ each represent N or C-R. R represents a hydrogen atom, a deuterium atom or a substituent. When at least two of $X^1$ to $X^5$ are (C-R)'s, these (C-R)'s can be the same as or different from each other. However, at least one of $X^1$ to $X^5$ is C-D (where D represents a donor group).

In one preferred embodiment of the present invention, none of $X^1$ to $X^5$ is not C-CN. In another preferred embodiment of the present invention, only $X^2$ represents C-CN, and $X^1$ and $X^3$ to $X^5$ are not C-CN. In another one preferred embodiment of the present invention, only $X^3$ represents C-CN, and $X^1$, $X^2$, $X^4$, $X^5$ are not C-CN.

Regarding the description and the preferred range of the substituent that Z in the general formula (1) represents, reference can be made to the description and the preferred range of the substituent in the general formula (7) to be mentioned hereinunder. The acceptor group that Z in the general formula (1) represents is a group that donates an electron to the ring to which Z bonds, and for example, can be selected from groups having a positive Hammett's $\sigma_p$ value. The donor group that D in the general formula (1) and the general formula (2) represents is a group that attracts an electron from the ring to which D bonds, and for example, can be selected from groups having a negative Hammett's $\sigma_p$ value. Hereinafter the acceptor group can be referred to as A.

Here, "Hammett's $\sigma_p$ value" is one propounded by L. P. Hammett, and is one to quantify the influence of a substituent on the reaction rate or the equilibrium of a para-substituted benzene derivative. Specifically, the value is a constant ($\sigma_p$) peculiar to the substituent in the following equation that is established between a substituent and a reaction rate constant or an equilibrium constant in a para-substituted benzene derivative:

$$\log(k/k_0) = \rho\sigma_p$$

or

$\log(K/K_0) = \rho\sigma_p$ In the above equations, k represents a rate constant of a benzene derivative not having a substituent; $k_0$ represents a rate constant of a benzene derivative substituted with a substituent; K represents an equilibrium constant of a benzene derivative not having a substituent; $K_0$ represents an equilibrium constant of a benzene derivative substituted with a substituent; ρ represents a reaction constant to be determined by the kind and the condition of reaction. Regarding the description relating to the "Hammett's $\sigma_p$ value" and the numerical value of each substituent, reference may be made to the description relating to $\sigma_p$ value in Hansch, C. et. al., Chem. Rev., 91, 165-195 (1991).

As the specific examples of the acceptor group, reference may be made to a cyano group, and the acceptor groups preferable as A in the general formulas (12) to (14) to be mentioned hereinunder. As the specific examples of the donor group, reference may be made to the donor groups preferable as D in the general formulas (12) to (14) to be mentioned hereinunder.

In the general formula (1) and the general formula (2), $X^1$ to $X^5$ each represent N or C-R and at least one of them is C-D. The number of N's of $X^1$ to $X^5$ is 0 to 4, and for example, a case where $X^1$ and $X^3$ and $X^5$, $X^1$ and $X^3$, $X^1$ and $X^4$, $X^2$ and $X^3$, $X^1$ and $X^5$, $X^2$ and $X^4$, $X^1$ alone, $X^2$ alone, or $X^3$ alone are/is N('s) can be exemplified. The number of (C-D)'s of $X^1$ to $X^5$ is 1 to 5, and is preferably 2 to 5. For example, a case where $X^1$ and $X^2$ and $X^3$ and $X^4$ and $X^5$, $X^1$ and $X^2$ and $X^4$ and $X^5$, $X^1$ and $X^2$ and $X^3$ and $X^4$, $X^1$ and $X^3$ and $X^4$ and $X^5$, $X^1$ and $X^3$ and $X^5$, $X^1$ and $X^2$ and $X^5$, $X^1$ and $X^2$ and $X^4$, $X^1$ and $X^3$ and $X^4$, $X^1$ and $X^3$, $X^1$ and $X^4$, $X^2$ and $X^3$, $X^1$ and $X^5$, $X^2$ and $X^4$, $X^1$ alone, $X^2$ alone, or $X^3$ alone are/is (C-D)('s) can be exemplified. At least one of $X^1$ to $X^5$ can be C-A. Here, A represents an acceptor group. The number of (C-A)'s of $X^1$ to $X^5$ is preferably 0 to 2, more preferably 0 or 1. A of C-A is preferably a cyano group, or an unsaturated, nitrogen atom-having heterocyclic aromatic group. $X^1$ to $X^5$ each can be independently C-D or C-A.

When the neighboring two of $X^1$ to $X^5$ are (C-R)'s, the two R's can bond to each other to form a cyclic structure. The cyclic structure to be formed by bonding can be an aromatic ring or an aliphatic ring, or can contain a hetero atom, and further, the cyclic structure can also be a condensed ring of two or more rings. Here the hetero atom is preferably selected from the group consisting of a nitrogen atom, an oxygen atom and a sulfur atom. Examples of the cyclic structure to be formed include a benzene ring, a naphthalene ring, a pyridine ring, a pyridazine ring, a pyrimidine ring, a pyrazine ring, a pyrrole ring, an imidazole ring, a pyrazole ring, an imidazoline ring, an oxazole ring, an isoxazole ring, a thiazole ring, an isothiazole ring, a cyclohexadiene ring, a cyclohexene ring, a cyclopentaene ring, a cycloheptatriene ring, a cycloheptadiene ring, a cycloheptaene ring, a furan ring, a thiophene ring, a naphthyridine ring, a quinoxaline ring, and a quinoline ring. Many rings can be condensed to form a ring such as a phenanthrene ring or a triphenylene ring.

The donor group D in the general formula (1) and the general formula (2) is preferably a group represented by, for example, the following general formula (3).

General Formula (3)

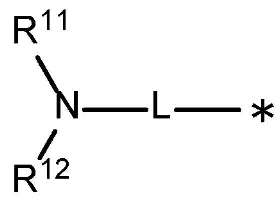

In the general formula (3), $R^{11}$ and $R^{12}$ each independently represent a substituted or unsubstituted alkyl group, a substituted or unsubstituted alkenyl group, a substituted or unsubstituted aryl group, or a substituted or unsubstituted heteroaryl group. $R^{11}$ and $R^{12}$ can bond to each other to form a cyclic structure. L represents a single bond, a substituted or unsubstituted arylene group, or a substituted or unsubstituted heteroarylene group. The substituent that can be introduced into the arylene group or the heteroarylene group of L can be the group represented by the general formula (1) or the general formula (2), or cab be a group represented by the general formulae (3) to (6) to be mentioned hereinunder. The groups represented by these (1) to (6) can be introduced in an amount up to the maximum number of the groups capable of being introduced into L. In the case where plural groups of the general formulae (1) to (6) are introduced, these substituents can be the same as or different from each other. * indicates the bonding position to the carbon atom (C) that constitutes the ring skeleton of the ring in the general formula (1) or the general formula (2).

Here, "alkyl group" can be linear, branched or cyclic. Two or more of a linear moiety, a cyclic moiety and a branched moiety can be in the group as mixed. The carbon number of the alkyl group can be, for example, 1 or more, 2 or more, or 4 or more. The carbon number can also be 30 or less, 20 or less, 10 or less, 6 or less, or 4 or less. Specific examples of the alkyl group include a methyl group, an ethyl group, an n-propyl group, an isopropyl group, an n-butyl group, an isobutyl group, a tert-butyl group, an n-pentyl group, an isopentyl group, an n-hexyl group, an isohexyl group, a 2-ethylhexyl group, an n-heptyl group, an isoheptyl group, an n-octyl group, an isooctyl group, an n-nonyl group, an

isononyl group, an n-decanyl group, an isodecanyl group, a cyclopentyl group, a cyclohexyl group, and a cycloheptyl group. The alkyl group of a substituent can be further substituted with an aryl group.

"Alkenyl group" can be linear, branched or cyclic. Two or more of a linear moiety, a cyclic moiety and a branched moiety can be in the group as mixed. The carbon number of the alkyl group can be, for example, 2 or more, or 4 or more. The carbon number can also be 30 or less, 20 or less, 10 or less, 6 or less, or 4 or less. Specific examples of the alkenyl group include an ethenyl group, an n-propenyl group, an isopropenyl group, an n-butenyl group, an isobutenyl group, an n-pentenyl group, an isopentenyl group, an n-hexenyl group, an isohexenyl group, and a 2-ethylhexenyl group. The alkenyl group to be a substituent can be further substituted with an aryl group.

"Aryl group" and "Heteroaryl group" each can be a single ring or can be a condensed ring of two or more kinds of rings. In the case of a condensed ring, the number of the rings that are condensed is preferably 2 to 6, and, for example, can be selected from 2 to 4. Specific examples of the ring include a benzene ring, a pyridine ring, a pyrimidine ring, a triazine ring, a naphthalene ring, an anthracene ring, a phenanthrene ring, a triphenylene ring, a quinoline ring, a pyrazine ring, a quinoxaline ring, and a naphthyridine ring. Specific examples of the aryl ring or the heteroaryl ring include a phenyl group, a 1-naphthyl group, a 2-naphthyl group, a 1-anthracenyl group, a 2-anthracenyl group, a 9-anthracenyl group, a 2-pyridyl group, a 3-pyridyl group, and a 4-pyridyl group. For "arylene group" and "heteroarylene group", the valance of the aryl group and the heteroaryl group is exchanged from 1 to 2, and the thus-exchanged description can be referred to.

The substituent means a monovalent group that can substitute for a hydrogen atom, a deuterium atom and does not mean a concept of condensation. Regarding the description and the preferred range of the substituent, reference can be made to the description and the preferred range of the substituent in the general formula (7) to be mentioned hereinunder.

The group represented by the general formula (3) is preferably a group represented by any of the following general formulae (4) to (6).

General Formula (4)

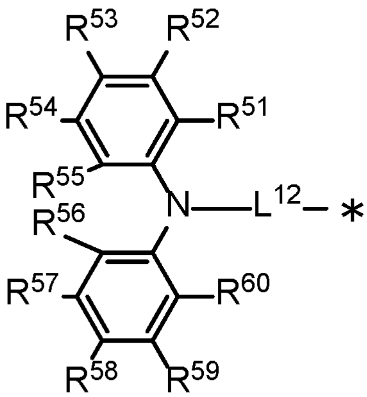

General Formula (5)

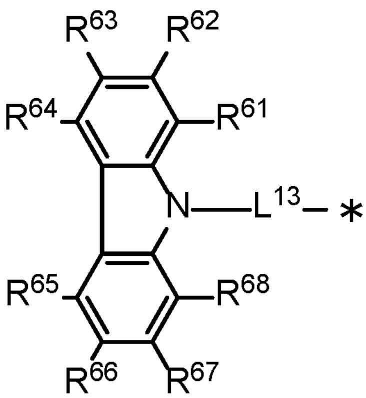

General Formula (6)

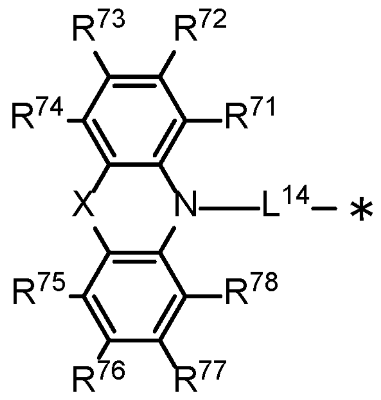

In the general formulae (4) to (6), $R^{51}$ to $R^{60}$, $R^{61}$ to $R^{68}$, and $R^{71}$ to $R^{78}$ each independently represent a hydrogen atom, a deuterium atom or a substituent. Regarding the description and the preferred range of the substituent as referred to herein, reference can be made to the description and the preferred range of the substituent in the general formula (7) to be mentioned hereinunder. $R^{51}$ to $R^{60}$, $R^{61}$ to $R^{68}$, and $R^{71}$ to $R^{78}$ each are also preferably a group represented by any of the above-mentioned general formulae (4) to (6). The number of the substituents in the general formulae (4) to (6) is not specifically limited. Cases where all are unsubstituted (that is, all are hydrogen atoms or deuterium atoms) are also preferred. In the case where each of the general formulae (4) to (6) has two or more substituents, these substituents can be the same or different. When the general formulae (4) to (6) have substituents, the substituents are preferably any of $R^{52}$ to $R^{59}$ in the case of the general formula (4), or any of $R^{62}$ to $R^{67}$ in the case of the general formula (5), or any of $R^{72}$ to $R^{77}$ in the case of the general formula (6).

In the general formulae (4) to (6), $R^{51}$ and $R^{52}$, $R^{52}$ and $R^{53}$, $R^{53}$ and $R^{54}$, $R^{54}$ and $R^{55}$, $R^{55}$ and $R^{56}$, $R^{56}$ and $R^{57}$, $R^{57}$ and $R^{58}$, $R^{58}$ and $R^{59}$, $R^{59}$ and $R^{60}$, $R^{61}$ and $R^{62}$, $R^{62}$ and $R^{63}$ , $R^{63}$ and $R^{64}$, $R^{65}$ and $R^{66}$, $R^{66}$ and $R^{67}$, $R^{67}$ and $R^{68}$, $R^{71}$ and $R^{72}$, $R^{72}$ and $R^{73}$, $R^{73}$ and $R^{74}$, $R^{75}$ and $R^{76}$, $R^{76}$ and $R^{77}$, and $R^{77}$ and $R^{78}$ each can bond to each other to form a cyclic structure. Regarding the description and the preferred examples of the cyclic structure, reference can be made to the description and the preferred examples of the cyclic structure for $X^1$ to $X^5$ in the above-mentioned general formula (1) and general formula (2).

In the general formula (6), X represents an oxygen atom, a sulfur atom, a substituted or unsubstituted nitrogen atom, a substituted or unsubstituted carbon atom, a substituted or unsubstituted silicon atom or a carbonyl group that is divalent and has a linking chain length of one atom, or represents a substituted or unsubstituted ethylene group, a substituted or unsubstituted vinylene group, a substituted or unsubstituted o-arylene group or a substituted or unsubstituted heteroarylene group that is divalent and has a linking chain length of two atoms. Regarding the specific examples and the preferred range of the substituents, reference can be made to the description of the substituents in the general formula (1) and the general formula (2).

In the general formulae (4) to (6), $L^{12}$ to $L^{14}$ each represent a single bond, a substituted or unsubstituted arylene group or a substituted or unsubstituted heteroarylene group. Regarding the description and the preferred range of the arylene group and the heteroarylene group that $L^{12}$ to $L^{14}$ represent, reference can be made to the description and the preferred range of the arylene group and the heteroarylene group that L represents. $L^{12}$ to $L^{14}$ each are preferably a single bond, or a substituted or unsubstituted arylene group. Here the substituent for the arylene group and the heteroarylene group can be the group represented by the general formulae (1) to (6). The group represented by the general formulae (1) to (6) can be introduced into $L^{12}$ to $L^{14}$ in an amount up to the maximum number of the substituents that can be introduced thereinto. In the case where plural groups of the general formulae (1) to (6) are introduced, these substituents can be the same as or different from each other. * indicates the bonding position to the carbon atom (C) that constitutes the ring skeleton of the ring in the general formula (1) or the general formula (2).

A compound represented by the following general formula (7) and capable of emitting delayed fluorescence can be especially preferably used as the delayed fluorescent material in the present invention. In a preferred embodiment of the present invention, the compound represented by the general formula (7) can be employed as the second organic compound.

General Formula (7)

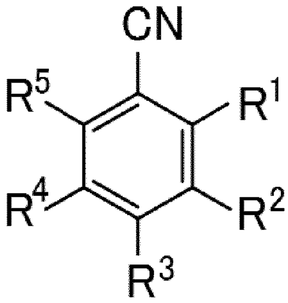

In the general formula (7), 0 to 4 of $R^1$ to $R^5$ each represent a cyano group, at least one of $R^1$ to $R^5$ represents a substituted amino group, and the remaining $R^1$ to $R^5$ are hydrogen atoms, a deuterium atom or represent any other substituent than a cyano group and a substituted amino group.

Here the substituted amino group is preferably a substituted or unsubstituted diarylamino group, and the two aryl groups constituting the substituted or unsubstituted diarylamino group can bond to each other. The bonding can be made via a single bond (in such a case, a carbazole ring is formed), or via a linking group such as -O-, -S-, - N($R^6$)-, -C($R^7$)($R^8$)-, or -Si($R^9$)($R^{10}$)-. Here, $R^6$ to $R^{10}$ each represent a hydrogen atom, a deuterium atom or a substituent, and $R^7$ and $R^8$, and $R^9$ and $R^{10}$ each can bond to each other to form a cyclic structure.

A substituted amino group can be any of $R^1$ to $R^5$, and for example, $R^1$ and $R^2$, $R^1$ and $R^3$, $R^1$ and $R^4$, $R^1$ and $R^5$ , $R^2$ and $R^3$, $R^2$ and $R^4$, $R^1$ and $R^2$ and $R^3$, $R^1$ and $R^2$ and $R^4$, $R^1$ and $R^2$ and $R^5$ , $R^1$ and $R^3$ and $R^4$, $R^1$ and $R^3$ and $R^5$ , $R^2$ and $R^3$ and $R^4$, $R^1$ and $R^2$ and $R^3$ and $R^4$, $R^1$ and $R^2$ and $R^3$ and $R^5$, $R^1$ and $R^2$ and $R^4$ and $R^5$, and $R^1$ and $R^2$ and $R^3$ and $R^4$ and $R^5$ each can be a substituted amino group. A cyano group can also be any of $R^1$ to $R^5$, and for example, $R^1$, $R^2$, $R^3$, $R^1$ and $R^2$, $R^1$ and $R^3$, $R^1$ and $R^4$, $R^1$ and $R^5$, $R^2$ and $R^3$, $R^2$ and $R^4$, $R^1$ and $R^2$ and $R^3$, $R^1$ and $R^2$ and $R^4$, $R^1$ and $R^2$ and $R^5$ , $R^1$ and $R^3$ and $R^4$, $R^1$ and $R^3$ and $R^5$, and $R^2$ and $R^3$ and $R^4$ each can be a cyano group.

$R^1$ to $R^5$ that are neither a cyano group nor a substituted amino group each represent a hydrogen atom, a deuterium atom or a substituent. Examples of the substituent referred to herein include a substituent group A that contains a hydroxy group, a halogen atom (e.g., fluorine atom, chlorine atom, bromine atom, iodine atom), an alkyl group (for example, having 1 to 40 carbon atoms), an alkoxy group (for example, having 1 to 40 carbon atoms), an alkylthio group (for example, having 1 to 40 carbon atoms), an aryl group (for example, having 6 to 30 carbon atoms), an aryloxy group (for example, having 6 to 30 carbon atoms), an arylthio group (for example, having 6 to 30 carbon atoms), a heteroaryl group (for example, having 5 to 30 ring skeleton constituting atoms), a heteroaryloxy group (for example, having 5 to 30 ring skeleton constituting atoms), a heteroarylthio group (for example, having 5 to 30 ring skeleton constituting atoms), an acyl group (for example, having 1 to 40 carbon atoms), an alkenyl group (for example, having 1 to 40 carbon atoms), an alkynyl group (for example, having 1 tot 40 carbon atoms), an alkoxycarbonyl group (for example, having 1 to 40 carbon atoms), an aryloxycarbonyl group (for example, having 1 to 40 carbon atoms), a heteroaryloxycarbonyl group (for example, having 1 to 40 carbon atoms), a silyl group (for example, trialkylsilyl group having 1 to 40 carbon atoms), a nitro group, and groups listed herein and substituted with one or more groups also listed herein. Preferred examples of the substituent of the diarylamino group in which the aryl group is substituted also include the substituents of the substituent group A, and further include a cyano group and a substituted amino group.

Regarding the compound group included in the general formula (7) and specific examples of the compounds, reference can be made to WO2013/154064, paragraphs 0008 to 0048; WO2015/080183, paragraphs 0009 to 0030; WO2015/129715, paragraphs 0006 to 0019; JP2017-119663A, paragraphs 0013 to 0025; JP2017-119664A, paragraphs 0013 to 0026; which are hereby incorporated by reference as a part of the present specification.

Further a compound represented by the following general formula (8) and capable of emitting delayed fluorescence can also be especially preferably used as the delayed fluorescent material in the present invention. In a preferred embodiment of the present invention, the compound represented by the general formula (8) can be employed as the second organic compound.

General Formula (8)

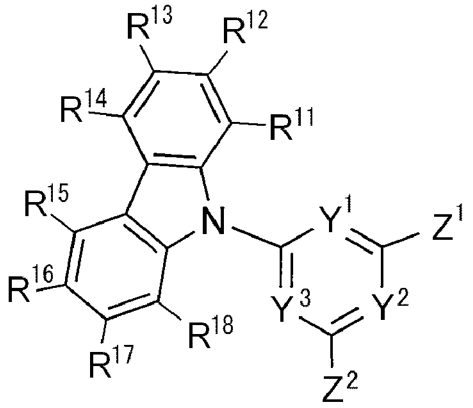

In the general formula (8), any two of $Y^1$, $Y^2$ and $Y^3$ are nitrogen atoms and the remaining one is a methine group, or all of $Y^1$, $Y^2$ and $Y^3$ are nitrogen atoms. $Z^1$ and $Z^2$ each independently represent a hydrogen atom, a deuterium atom or a substituent. $R^{11}$ to $R^{18}$ each independently represent a hydrogen atom, a deuterium atom or a substituent, and at least one of $R^{11}$ to $R^{18}$ is preferably a substituted or unsubstituted arylamino group or a substituted or unsubstituted carbazolyl group. The benzene ring to constitute the arylamino group and the benzene ring to constitute the carbazolyl group each can form a single bond or a linking group together with any of $R^{11}$ to $R^{18}$. The compound represented by the general formula (8) contains at least two carbazole structures in the molecule. Examples of the substituent that $Z^1$ and $Z^2$ can take include the substituents in the above-mentioned substituent group A. Specific examples of the substituent that $R^{11}$ to $R^{18}$, the arylamino group and the carbazolyl group can take include the substituents in the substituent group A, and a cyano group, a substituted arylamino group and a substituted alkylamino group. $R^{11}$ and $R^{12}$, $R^{12}$ and $R^{13}$, $R^{13}$ and $R^{14}$, $R^{15}$ and $R^{16}$, $R^{16}$ and $R^{17}$, and $R^{17}$ and $R^{18}$ each can bond to each other to form a cyclic structure.

Among the compounds represented by the general formula (8), those represented by the following general formula (9) are especially useful.

General Formula (9)

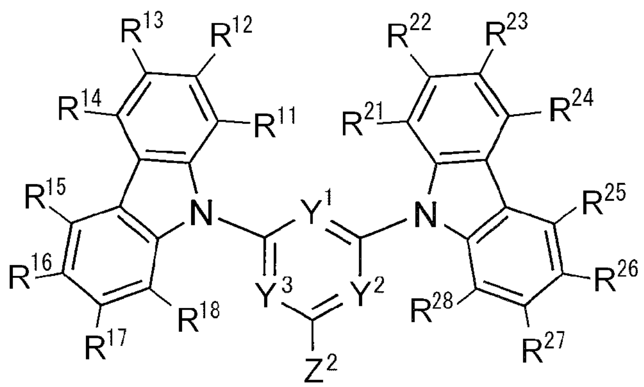

In the general formula (9), any two of $Y^1$, $Y^2$ and $Y^3$ are nitrogen atoms and the remaining one is a methine group, or all of $Y^1$, $Y^2$ and $Y^3$ are nitrogen atoms. $Z^2$ represents a hydrogen atom, a deuterium atom or a substituent. $R^{11}$ to $R^{18}$ and $R^{21}$ to $R^{28}$ each independently represent a hydrogen atom, a deuterium atom or a substituent. At least one of $R^{11}$ to $R^{18}$ and/or at least one of $R^{21}$ to $R^{28}$ are/is preferably a substituted or unsubstituted arylamino group or a substituted or unsubstituted carbazolyl group. The benzene ring to constitute the arylamino group and the benzene ring to constitute the carbazolyl group each can form a single bond or a linking group together with any of $R^{11}$ to $R^{18}$ or $R^{21}$ to $R^{28}$. Examples of the substituent that $Z^2$ can take include the substituents in the above-mentioned substituent group A. Specific examples of the substituent that $R^{11}$ to $R^{18}$, $R^{21}$ to $R^{28}$, the arylamino group and the carbazolyl group can take include the substituents in the substituent group A, and a cyano group, a substituted arylamino group and a substituted alkylamino group. $R^{11}$ and $R^{12}$, $R^{12}$ and $R^{13}$, $R^{13}$ and $R^{14}$, $R^{15}$ and $R^{16}$, $R^{16}$ and $R^{17}$, $R^{17}$ and $R^{18}$, $R^{21}$ and $R^{22}$, $R^{22}$ and $R^{23}$, $R^{23}$ and $R^{24}$, $R^{25}$ and $R^{26}$, $R^{26}$ and $R^{27}$, and $R^{27}$ and $R^{28}$ each can bond to each other to form a cyclic structure.

Regarding the compound group included in the general formula (9) and specific examples of the compounds, reference can be made to the compounds described in WO2013/081088, paragraphs 0020 0062 that is hereby incorporated by reference as a part of the present invention, and in Appl. Phys. Let, 98, 083302 (2011).

Also a compound represented by the following general formula (10) and capable of emitting delayed fluorescence can be especially preferably used as the delayed fluorescent material in the present invention.

General Formula (10)

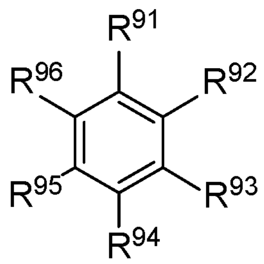

In the general formula (10), $R^{91}$ to $R^{96}$ each independently represent a hydrogen atom, a deuterium atom a donor group, or an acceptor group, and at least one of them is a donor group and at least two are acceptor groups. The substitution positions of at least two acceptor groups are not specifically limited, but preferably include two acceptor groups that are in a meta-position relationship. For example, when $R^{91}$ is a donor group, preferred examples include a structure where at least $R^{92}$ and $R^{94}$ are acceptor groups, or a structure where at least $R^{92}$ and $R^{96}$ are acceptor groups. The acceptor groups existing in the molecule can be all the same as or different from each other, but a structure where all have the same structure can be selected. The number of the acceptor groups is preferably 2 to 3, and for example, 2 can be selected. Two or more donor groups can exist, and in that case, all the donor groups can be the same as or different from each other. The number of the donor groups is preferably 1 to 3, and for example, it can be one only or can be two. Regarding the description and a preferred range of the donor group and the acceptor group, reference can be made to the description and the preferred range of D and Z in the general formula (1). In particular, the donor group in the general formula (10) is preferably represented by the general formula (3), and the acceptor group is preferably a cyano group or is represented by the following general formula (11).

General Formula (11)

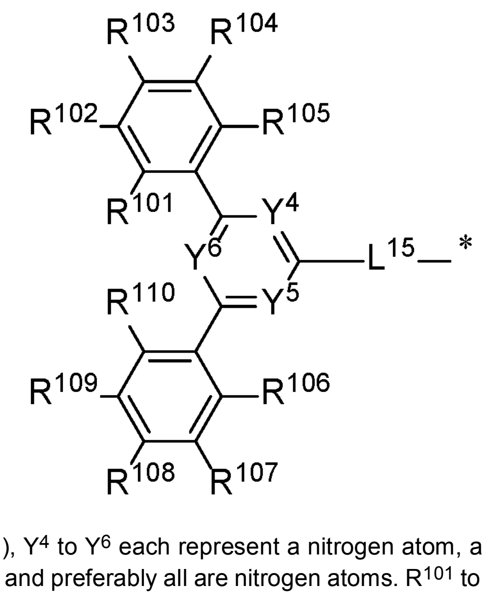

In the general formula (11), $Y^4$ to $Y^6$ each represent a nitrogen atom, a deuterium atom or a methine group, and at least one is a nitrogen atom, and preferably all are nitrogen atoms. $R^{101}$ to $R^{110}$ each independently represent a hydrogen atom or a substituent, and at least one is preferably an alkyl group. Regarding the description and a preferred range of the substituent as referred to herein, reference can be made to the description and the preferred range of the substituent in the general formula (7) mentioned hereinabove. $L^{15}$ represents a single bond or a linking group, for which reference can be made to the description and the preferred range of L in the general formula (3) mentioned hereinabove.

In one preferred embodiment of the present invention, $L^{15}$ in the general formula (11) is a single bond. * indicates a bonding position to the carbon atom (C) that constitutes the ring skeleton of the ring in the general formula (10).

In another preferred embodiment of the present invention, a compound represented by the following general formula (12) can be employed as the second organic compound.

General Formula (12)

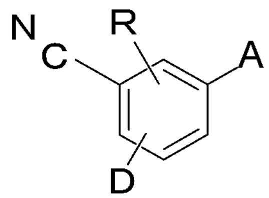

Among the compounds represented by the general formula (12), preferred are the compound represented by the following general formula (13) and the compound represented by the following general formula (14).

General Formula (13)

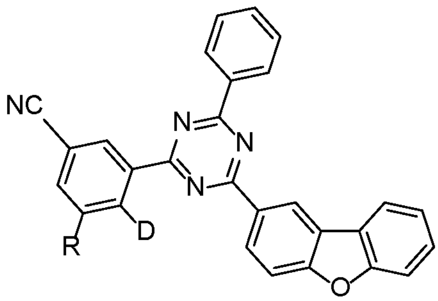

General Formula (14)

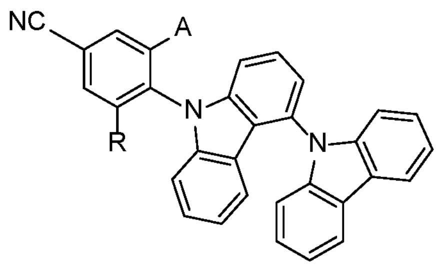

In the general formulae (12) to (14), D represents a donor group, A represents an acceptor group, R represents a hydrogen atom or a substituent. Regarding the description and a preferred range of the donor group and the acceptor group, reference can be made to the corresponding description and the preferred range of the general formula (1) mentioned above. Examples of the substituent of R include an alkyl group, and an aryl group optionally substituted with one group or a combination of two or more selected from the group consisting of an alkyl group and an aryl group.

Specific preferred examples of the donor group of D in the general formulae (12) to (14) are shown below. In the following specific examples, * indicates a bonding position, and "D" represents deuterium.

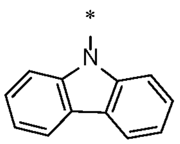

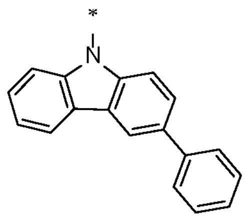

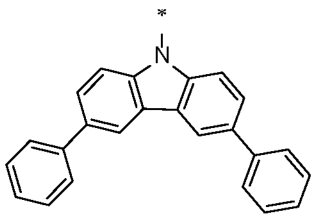

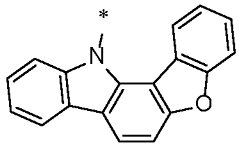

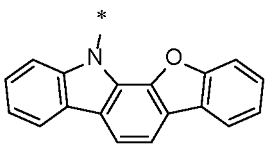

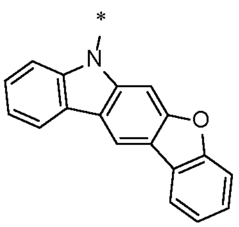

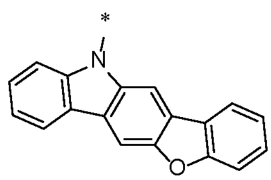

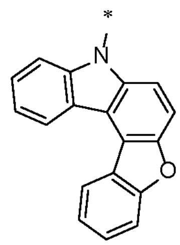

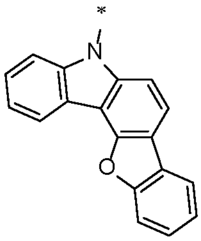
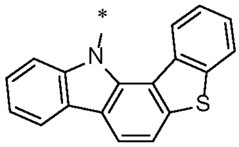
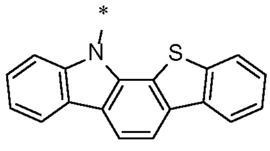
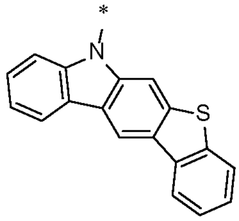

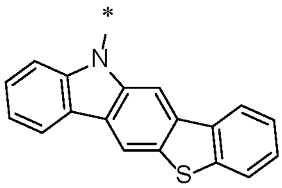
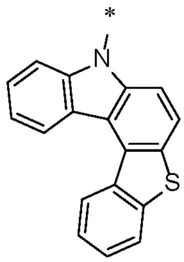
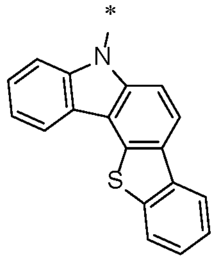
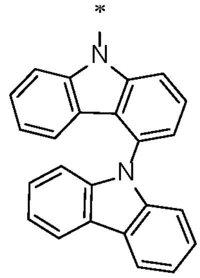

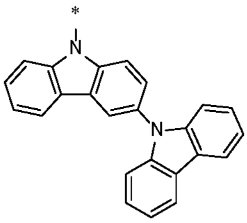
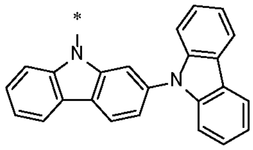
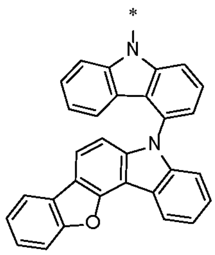
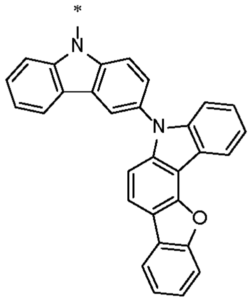

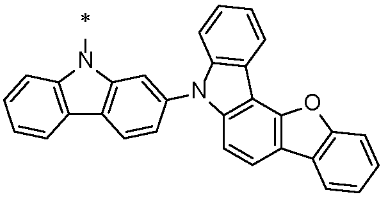
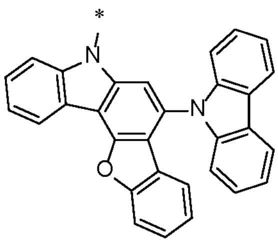
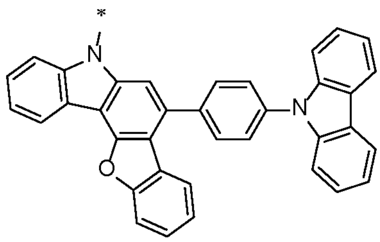

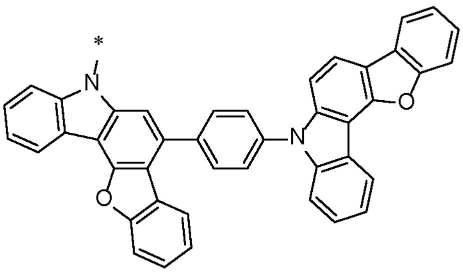
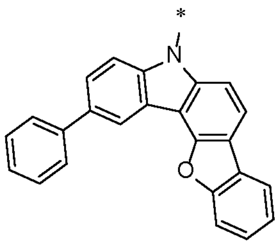
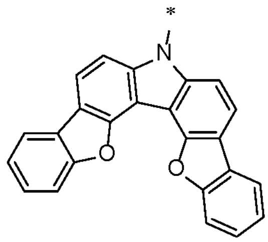

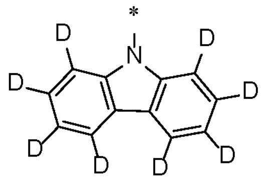
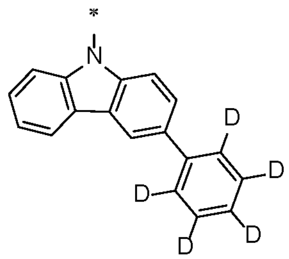
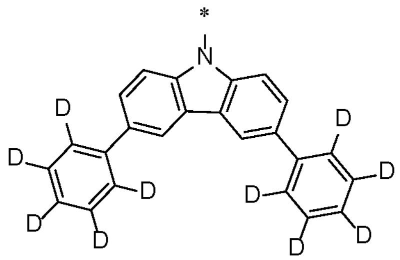

Specific preferred examples of the acceptor group of A in the general formulae (12) to (14) are shown below. In the following specific examples, * indicates a bonding position, and "D" represents deuterium.

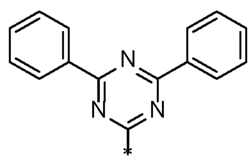
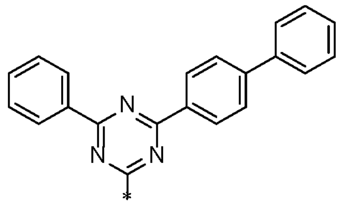
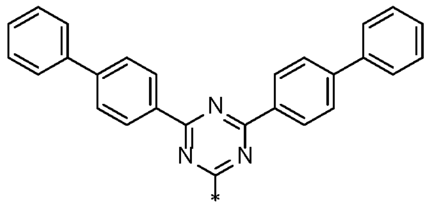

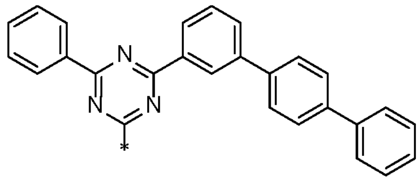
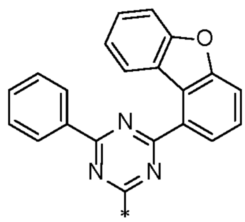
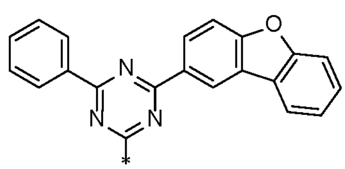

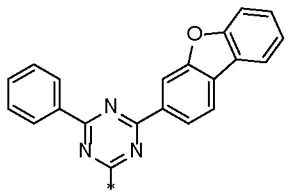
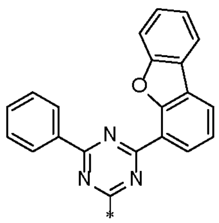
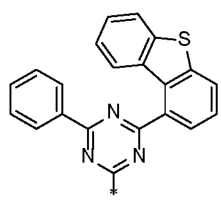
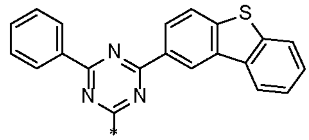

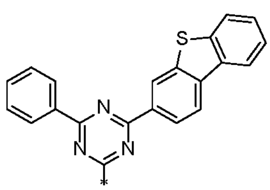
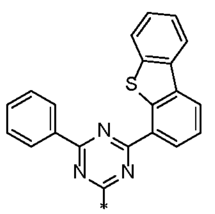
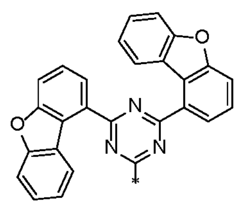
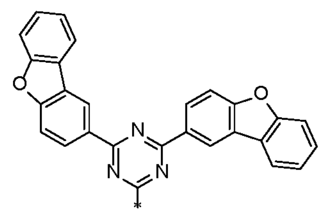

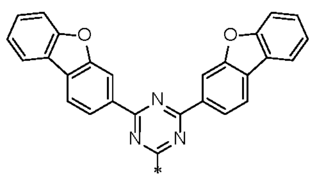
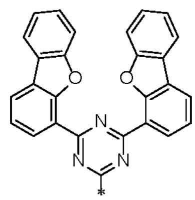
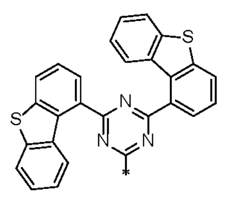
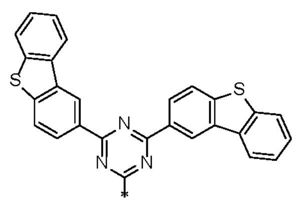

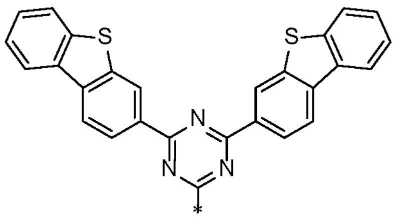
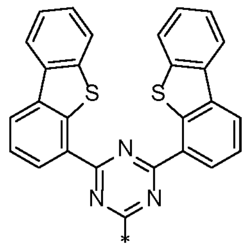
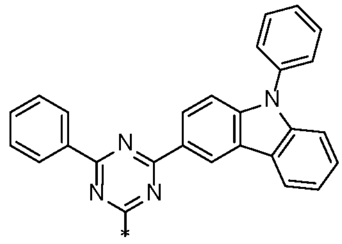

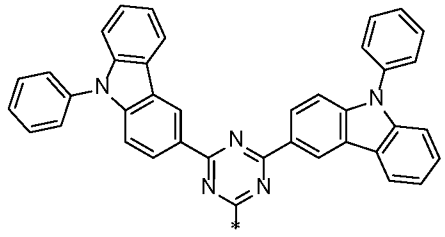
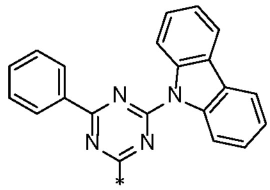
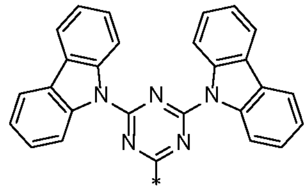

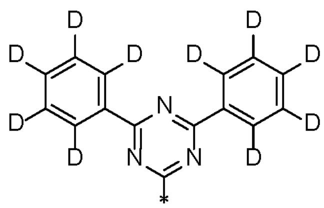
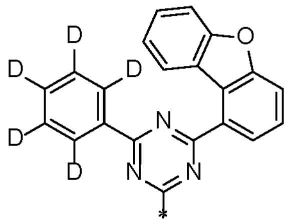
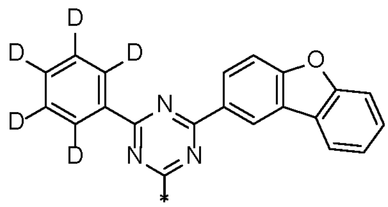

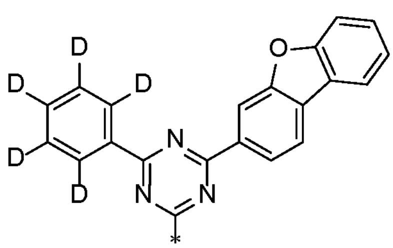
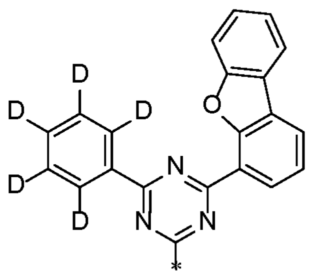

Preferred examples of R in the general formulae (12) to (14) are shown below. In the following specific examples, * indicates a bonding position, and "D" represents deuterium.

*–H

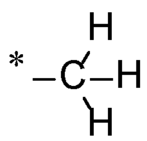
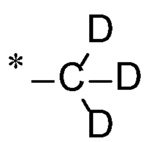

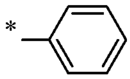 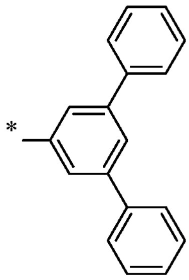 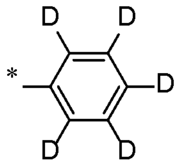 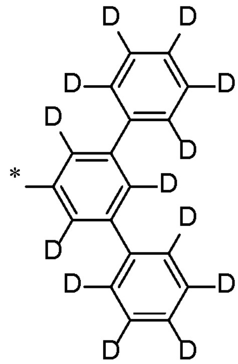

(Third Organic Compound)

The third organic compound is a compound having smaller lowest excited singlet energy than the first organic compound and the second organic compound. In the organic light emitting device of the present invention, the fluorescence derived from the third organic compound is emitted. The emission from the third organic compound usually contains the delayed fluorescence. The largest component of the emission from the organic light emitting device of the present invention is the emission from the third organic compound. Namely, the amount of the emission from the third organic compound is the largest among the emission from the organic light emitting device of the present invention. The third organic compound transits to the excited singlet state by receiving energy from the first organic compound in the excited singlet state, the second organic compound in the excited singlet state, and the second organic compound that became the excited singlet state by reverse intersystem crossing from the excited triplet state. In the preferred embodiment of the present invention, the third organic compound transits to the excited singlet state by receiving energy from the second organic compound in the excited singlet state and the second organic compound that became the excited singlet state by reverse intersystem crossing from the excited triplet state. When the resulting excited singlet state of the third organic compound returns to the ground state, the fluorescence is emitted.

As the fluorescent material used in the third organic compound, it is not particularly limited as long as it can emit by receiving energy from the first organic compound and the second organic compound in this way, and the emission may include any of a fluorescence, a delayed fluorescence, and a phosphorescence. The case when the emission include fluorescence or delayed fluorescence is preferable, and the case when the largest component of the emission from the third organic compound is fluorescence is more preferable.

Two or more types of the third organic compounds may be used, as long as it satisfies the condition of the present invention. For example, it is possible to emit the desired colors by using two or more types of the third organic compounds having different emission colors. In addition, one type of the third organic compound may be used to emit monochrome light from the third organic compound.

In the present invention, the maximum emission wavelength of the compound that can be used as the third organic compound is not particularly limited. Therefore, it is possible to appropriately select and use a light emitting material having a maximum emission wavelength in the visible region (380 to 780 nm) or a light emitting material having a maximum emission wavelength in the infrared region (780 nm to 1 mm). The fluorescent material having a maximum emission wavelength in the visible region is preferable. For example, within the region of 380 to 780 nm, a light emitting material having a maximum emission wavelength of the 380 to 570 nm may be selected and used, a light emitting material having a maximum emission wavelength of 380 to 500 nm may be selected and used, a light emitting material having a maximum emission wavelength of 380 to 480 nm may be selected and used, or a light emitting material having a maximum emission wavelength of 420 to 480 nm may be selected and used.

In the preferred embodiment of the present invention, the respective compounds are selected and combined so that there is an overlap between the emission wavelength region of the second organic compound and the absorption wavelength region of the third organic compound. In particularly, it is preferably that the edge of the emission spectrum of the second organic compound on the short wavelength side and the edge of the absorption spectrum of the third organic compound on the long wavelength are overlapped (crossed).

The third organic compound is preferably a compound composed only of atoms selected from the group consisting of carbon atom, hydrogen atom, deuterium atom, nitrogen atom, boron atom, oxygen atom and sulfur atom. For example, the third organic compound may be a compound composed only of atoms selected from the group consisting of carbon atom, hydrogen atom, deuterium atom, nitrogen atom, boron atom, and oxygen atom. The third organic compound may be a compound composed only of atoms selected from the group consisting of carbon atom, hydrogen atom, deuterium atom, nitrogen atom, boron atom, and sulfur atom. The third organic compound may be a compound composed only of atoms selected from the group consisting of carbon atom, hydrogen atom, deuterium atom, nitrogen

atom, and boron atom. For example, the third organic compound may be a compound containing only carbon atom, hydrogen atom, nitrogen atom, and boron atom. The third organic compound may be a compound which does not contain a cyano group. The third organic compound may be a compound having a multiple resonance effect, and may be, for example a compound having multiple resonance effects of boron atoms and nitrogen atoms. The third organic compound may be a compound containing diarylamino group.

Preferred compound examples for use as the third organic compound are shown below. In the structural formulas of the following exemplary compounds, Et represents an ethyl group.

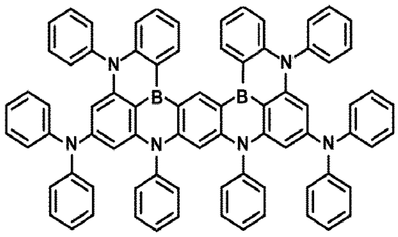

E1

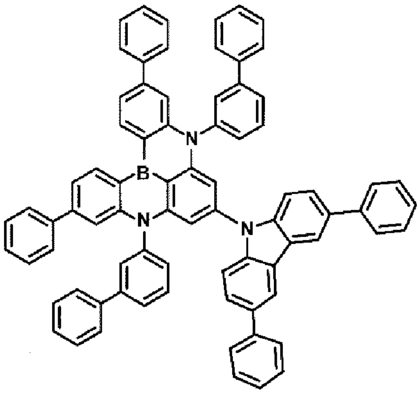

E2

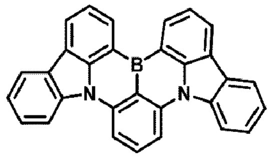

E3

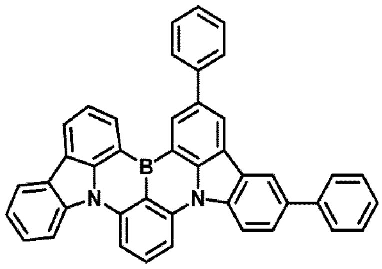

E4

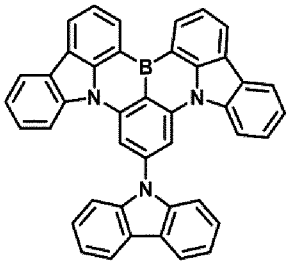

E5

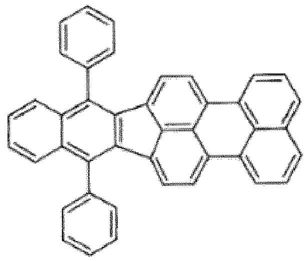

E6

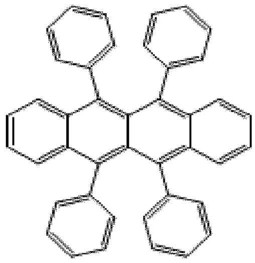

E7

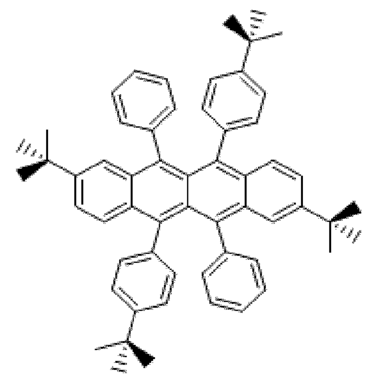

E8

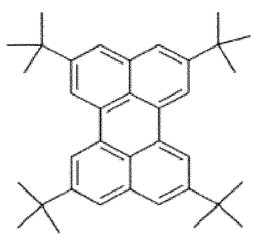

E9

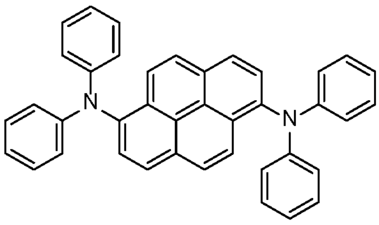

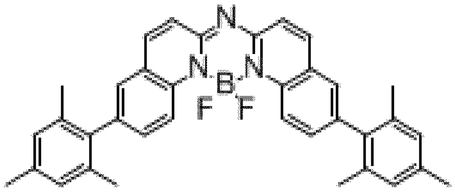

**E10** **E11**

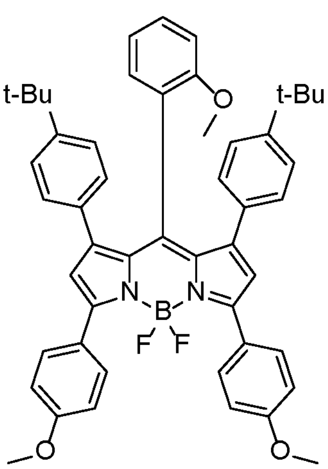

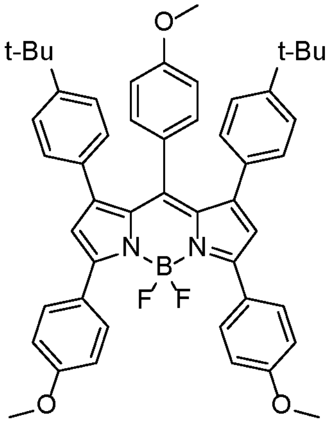

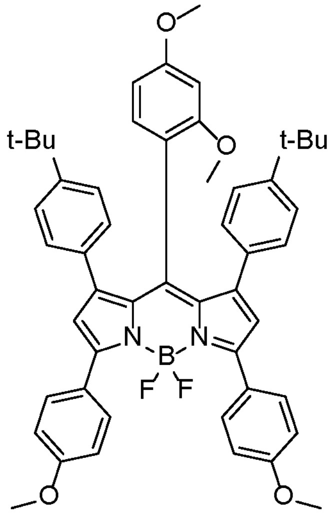

**E12** **E13** **E14**

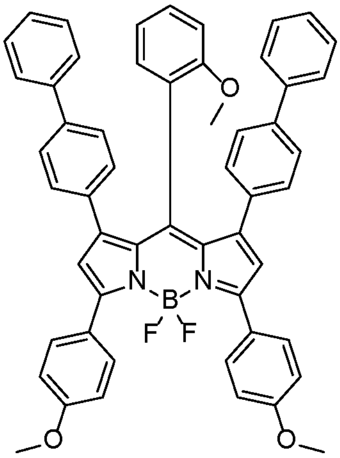

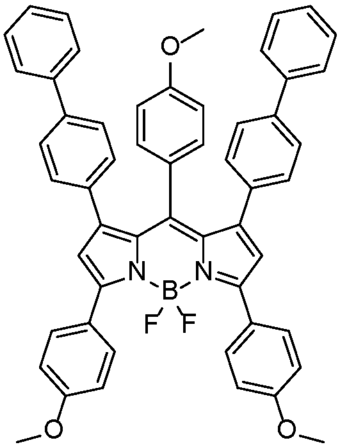

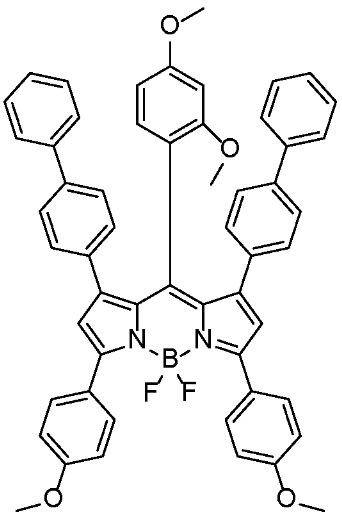

**E15** **E16** **E17**

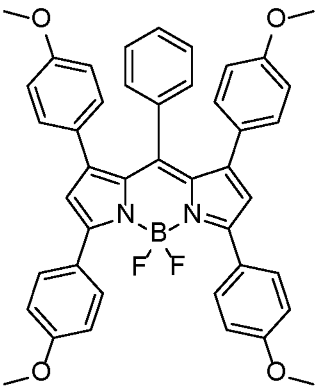

**E18**

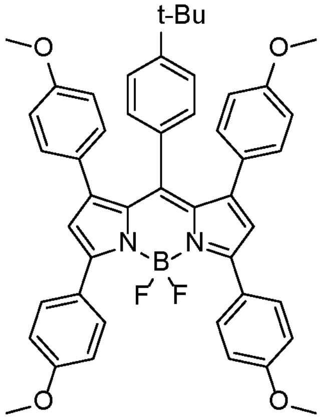

**E19**

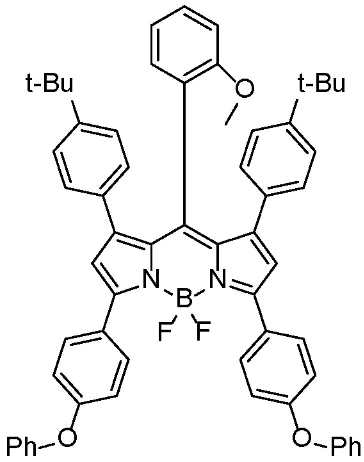

**E20**

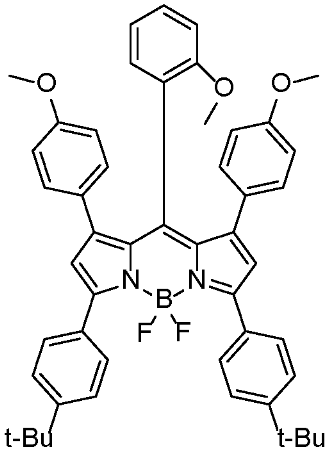

**E21**

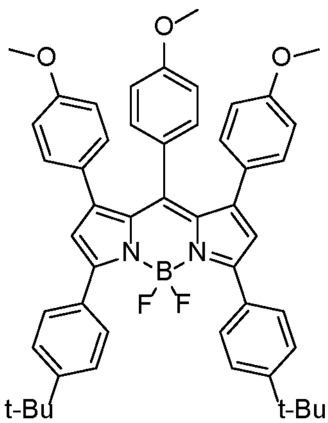

**E22**

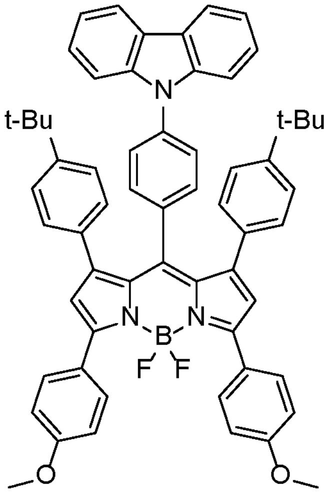

**E23**

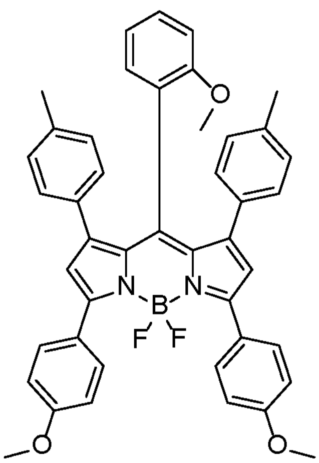

**E24**

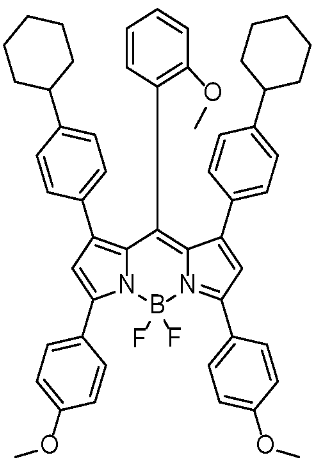

**E25**

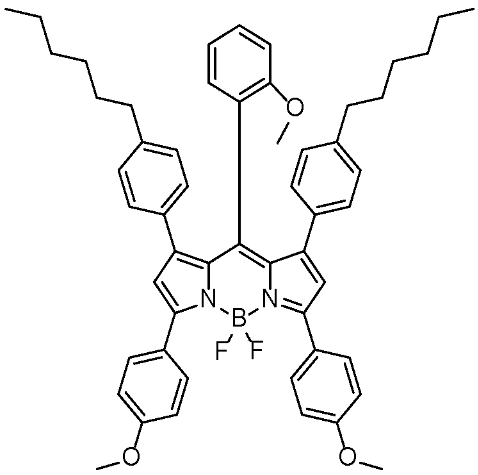

**E26**

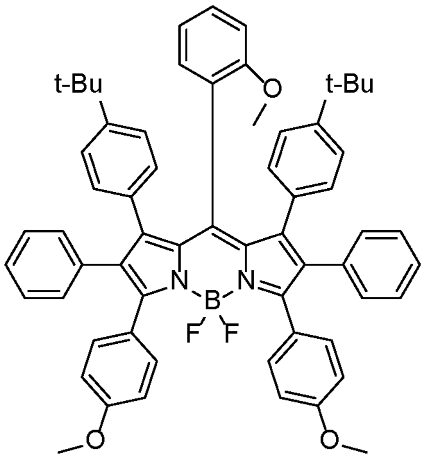

E27

Preferred examples of the compound group contain derivatives containing the compounds E1 to E5 and their skeletons. The derivatives contain compounds substituted with an alkyl group, an aryl group, a heteroaryl group, and diarylamino group.

In addition, the compounds described in the paragraphs 0220 to 0239 of WO2015/022974 A can be particularly used as the third organic compound of the present invention.

(Light emitting layer)

The light emitting layer of the organic light emitting device of the present invention contains the first organic compound, the second organic compound, and the third organic compound which satisfy the condition (a). The light emitting layer may have a structure which does not contain compounds or metallic elements that transfers charge and energy, other than the first organic compound, the second compound, and the third organic compound. In addition, the light emitting layer may be composed only of a compound containing atoms selected from the group consisting of carbon atom, hydrogen atom, deuterium atom, nitrogen atom, boron atom, oxygen atom and sulfur atom. For example, the light emitting layer may be composed only of a compound containing atoms selected from the group consisting of carbon atom, hydrogen atom, deuterium atom, nitrogen atom, boron atom, and oxygen atom. For example, the light emitting layer may be composed only of a compound containing atoms selected from the group consisting of carbon atom, hydrogen atom, deuterium atom, nitrogen atom, boron atom, and sulfur atom. For example, the light emitting layer may be composed only of a compound containing atoms selected from the group consisting of carbon atom, hydrogen atom, deuterium atom, nitrogen atom, and boron atom. For example, the light emitting layer may be composed only of a compound containing atoms selected from the group consisting of carbon atom, hydrogen atom, deuterium atom, nitrogen atom, oxygen atom, and sulfur atom. For example, the light emitting layer may be composed only of a compound containing atoms selected from the group consisting of carbon atom, hydrogen atom, deuterium atom, and nitrogen atom. The light emitting layer may contain the first organic compound which is composed of atoms selected from the group consisting of carbon atom, hydrogen atom, nitrogen atom, and oxygen atom; the second organic compound which is composed of atoms selected from the group consisting of carbon atom, hydrogen atom, deuterium atom, nitrogen atom, oxygen atom and sulfur atom; and the third organic compound which is composed of atoms selected from the group consisting of carbon atom, hydrogen atom, deuterium atom, nitrogen atom, boron atom, oxygen atom, and sulfur atom. In addition, the light emitting layer may contain the first organic compound which is composed of atoms selected from the group consisting of carbon atom, hydrogen atom, nitrogen atom, and oxygen atom; the second organic compound which is composed of atoms selected from the group consisting of carbon atom, hydrogen atom, deuterium atom, and nitrogen atom; and the third organic compound which is composed of atoms selected from the group consisting of carbon atom, hydrogen atom, deuterium atom, nitrogen atom, and boron atom.

The light emitting layer may be formed by a co-deposition of the first organic compound, the second organic compound and the third organic compound, or may be formed by a coating method using a solution in which the first organic compound, the second organic compound, and the third organic compound are dissolved. When forming the light emitting layer by a co-deposition, two or more of the first organic compound, the second organic compound, and the third organic compound may be mixed in advance in a crucible or the like to serve as a vapor deposition source, and the light emitting layer may be formed by co-deposition using the vapor deposition source. For example, the first organic compound and the second organic compound may be mixed in advance to serve as one vapor deposition source,

and the light emitting layer may be formed by co-deposition using the vapor deposition source and a deposition source of the third organic compound.

(Layer configuration of organic light emitting device)

By forming a light emitting layer containing the first organic compound, the second organic compound, and the third organic compound which satisfy the condition (a), and an adjacent layer adjacent to the light emitting layer and containing the first organic compound, the excellent organic light emitting device such as organic photo luminescent device (organic PLdevice) or organic electroluminescent device(organic EL device), can be provided.
The thickness of the light emitting layer can be, for example, 5nm or more, 10 nm or more, 20 nm or more, or 40 nm or more, and can be 80 nm or less, 60 nm or less.
An organic photoluminescence device has a structure in which at least a light emitting layer on the substrate, and an adjacent layer adjacent to the light emitting layer are formed. In addition, the organic electroluminescent device has a structure in which at least an anode, a cathode, and an organic layer between the anode and the cathode, are formed. The organic layer contains at least a light emitting layer and the adjacent layer adjacent to the light emitting layer, and may be composed only of the light emitting layer and the adjacent layer adjacent to the adjacent layer, or may contain one or more of organic layers in addition to the light emitting layer and the adjacent layer adjacent to the light emitting layer. The organic layer other than the light emitting layer contains a hole transporting layer, a hole injection layer, an electron barrier layer, a hole barrier layer, an electron injection layer, an electron transporting layer, and an exciton barrier layer. The hole transporting layer may be a hole injection transporting layer having a function of hole injection, and the electron transporting layer may be an electron injection transporting layer having a function of electron injection. Specific structure example of the organic electroluminescent device will be shown in Fig.1. In fig. 1, 1 represents a glass substrate, 2 represents an anode, 3 represents a hole injection layer, 4 represents a hole transporting layer, 5 represents an electron barrier layer, 6 represents an adjacent layer, 7 represents a light emitting layer, 8 represents a hole barrier layer, 9 represents an electron transporting layer, 10 represents an electron injection layer, and 11 represents a cathode.
When the organic light emitting device of the present invention is an organic light emitting device of multi-wavelength type, the shortest wavelength light emission can contain a delayed fluorescence. In addition, the shortest wavelength light emission may not contain a delayed fluorescence.

(Methods of Manufacturing Organic light emitting device)

The organic light emitting device of the present invention may be manufactured by any method.
Preferred manufacturing method contains a process of forming an adjacent layer containing a first organic compound, and forming a light emitting layer having the first organic compound, a second organic compound which is a delayed fluorescent material, and a third organic compound so that to be adjacent to the adjacent layer. For example, when the organic electroluminescent device is manufactured by stacking the organic layer on the anode, the adjacent layer containing the first organic compound is formed, and the light emitting layer containing the first organic compound, the second organic compound and the third organic compound, is formed so as to be stacked on the adjacent layer.
Another preferred manufacturing method contains a process of forming a light emitting layer having the first organic compound, a second organic compound which is a delayed fluorescent material, and a third organic compound, and forming an adjacent layer so that to be adjacent to the light emitting layer. For example, when the organic electroluminescent device is manufactured by stacking the organic layer on the cathode, the light emitting layer containing the first organic compound, the second organic compound and the third organic compound, is formed, and the adjacent layer containing the first organic compound is formed so as to be stacked on the light emitting layer.
In the manufacturing method of the present invention, the first organic compound, the second organic and the third organic compound are selected so as to satisfy the above condition (a).
The forming means of the light emitting layer and the barrier layer are not particularly limited. Preferred forming mean contains a vapor deposition method. In addition, it can be formed by a coating method. The light emitting layer and the barrier layer adjacent to each other may be continuously formed, or may be intermittently formed. Preferably, it is formed continuously.
The manufacturing method of the present invention can be easily carried out by using the normal manufacturing line (manufacturing equipment) of the organic light emitting device. In other words, the manufacturing method of the present invention can be easily carried out on a normal manufacturing line as long as the materials used to form the light emitting layer and the adjacent layer are changed so as to satisfy the above condition (a). Therefore, the manufacturing method of the present invention has the advantage that it can be carried out without changing the manufacturing line or installing a new manufacturing line. Moreover, after carrying out the manufacturing method of the present invention, it is also possible to return to the manufacturing line for organic light emitting device other than the present invention by

changing the materials used. Therefore, the manufacturing method of the present invention is highly practical in that it can be economically carried out and repurposed in a short time.

In the manufacturing method of the present invention, as long as the light emitting layer and the adjacent layer are formed adjacent to each other by using the materials satisfying the above condition (a), the forming means of the other layers and the structures are not particularly limited. For example, the method can further contain a process of forming an electrode such as an anode and a cathode, or may further contain a process of forming a layer other than the light emitting layer and the adjacent layer. When the manufacturing method of the present invention is used for example, for manufacturing the organic electroluminescent device, each process of forming one or more organic layers in sequence on the anode, forming an adjacent layer thereon, forming a light emitting layer thereon, forming one or more organic layers thereon, and forming a cathode thereon, can be carried out. Alternatively, each process of forming one or more organic layers in sequence on the cathode, forming a light emitting layer thereon, forming an adjacent layer thereon, forming one or more organic layers thereon, and forming an anode thereon, can be carried out. Furthermore, any modifications or additions which are obvious to those skilled in the art may be made.

Fig. 2 is a flowchart showing processes for carrying out a method of manufacturing an organic light emitting device. When manufacturing the organic electroluminescent device, an electrode is prepared (S 1), an organic layer is formed on the electrode (S2). Then, the adjacent layer is formed on the formed organic layer (S3), and the light emitting layer is further formed thereon (S4). Another organic layer, which is different from the organic layer formed in S2, is formed on the formed light emitting layer (S5). Finally, the organic electroluminescent device can be manufactured by forming the electrode on the organic layer (S6). In the manufacturing, one or both of S2 and S5, which are the organic layer forming processes, may not be performed. Furthermore, when manufacturing the organic photoluminescence device, the electrode preparation process S 1 and the electrode forming process S6 may not be performed. In the manufacturing method of the present invention, it is necessary to select the materials to form the layers so that the material used in the adjacent layer forming process S3 and the material used in the light emitting layer forming process S4 satisfy the above condition (a).

In the following, the constituent members and the other layers than the light-emitting layer of the organic electroluminescent device are described.

Substrate:

In some embodiments, the organic electroluminescent device of the invention is supported by a substrate, wherein the substrate is not particularly limited and may be any of those that have been commonly used in an organic electroluminescent device, for example those formed of glass, transparent plastics, quartz and silicon.

Anode:

In some embodiments, the anode of the organic electroluminescent device is made of a metal, an alloy, an electroconductive compound, or a combination thereof. In some embodiments, the metal, alloy, or electroconductive compound has a large work function (4 eV or more). In some embodiments, the metal is Au. In some embodiments, the electroconductive transparent material is selected from CuI, indium tin oxide (ITO), $SnO_2$, and ZnO. In some embodiments, an amorphous material capable of forming a transparent electroconductive film, such as IDIXO ($In_2O_3$-ZnO), is be used. In some embodiments, the anode is a thin film. In some embodiments the thin film is made by vapor deposition or sputtering. In some embodiments, the film is patterned by a photolithography method. In some embodiments, where the pattern may not require high accuracy (for example, approximately 100 μm or more), the pattern may be formed with a mask having a desired shape on vapor deposition or sputtering of the electrode material. In some embodiments, when a material can be applied as a coating, such as an organic electroconductive compound, a wet film forming method, such as a printing method and a coating method is used. In some embodiments, when the emitted light goes through the anode, the anode has a transmittance of more than 10%, and the anode has a sheet resistance of several hundred Ohm per square or less. In some embodiments, the thickness of the anode is from 10 to 1,000 nm. In some embodiments, the thickness of the anode is from 10 to 200 nm. In some embodiments, the thickness of the anode varies depending on the material used.

Cathode:

In some embodiments, the cathode is made of an electrode material a metal having a small work function (4 eV or less) (referred to as an electron injection metal), an alloy, an electroconductive compound, or a combination thereof. In some embodiments, the electrode material is selected from sodium, a sodium-potassium alloy, magnesium, lithium, a magnesium-cupper mixture, a magnesium-silver mixture, a magnesium-aluminum mixture, a magnesium-indium mixture, an aluminum-aluminum oxide ($Al_2O_3$) mixture, indium, a lithium-aluminum mixture, and a rare earth metal. In some

embodiments, a mixture of an electron injection metal and a second metal that is a stable metal having a larger work function than the electron injection metal is used. In some embodiments, the mixture is selected from a magnesium-silver mixture, a magnesium-aluminum mixture, a magnesium-indium mixture, an aluminum-aluminum oxide ($Al_2O_3$) mixture, a lithium-aluminum mixture, and aluminum. In some embodiments, the mixture increases the electron injection property and the durability against oxidation. In some embodiments, the cathode is produced by forming the electrode material into a thin film by vapor deposition or sputtering. In some embodiments, the cathode has a sheet resistance of several hundred Ohm per square or less. In some embodiments, the thickness of the cathode ranges from 10 nm to 5 $\mu$m. In some embodiments, the thickness of the cathode ranges from 50 to 200 nm. In some embodiments, for transmitting the emitted light, any one of the anode and the cathode of the organic electroluminescent device is transparent or translucent. In some embodiments, the transparent or translucent electroluminescent devices enhances the light emission luminance.

In some embodiments, the cathode is formed with an electroconductive transparent material, as described for the anode, to form a transparent or translucent cathode. In some embodiments, a device comprises an anode and a cathode, both being transparent or translucent.

Injection Layer:

An injection layer is a layer between the electrode and the organic layer. In some embodiments, the injection layer decreases the driving voltage and enhances the light emission luminance. In some embodiments the injection layer includes a hole injection layer and an electron injection layer. The injection layer can be positioned between the anode and the light-emitting layer or the hole transporting layer, and between the cathode and the light-emitting layer or the electron transporting layer. In some embodiments, an injection layer is present. In some embodiments, no injection layer is present.

Preferred compound examples for use as a hole injection material are shown below.

MoOs,

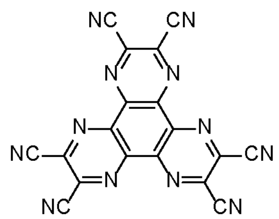
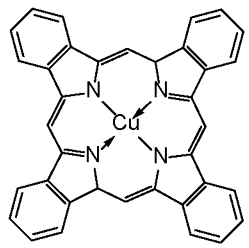
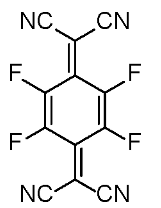
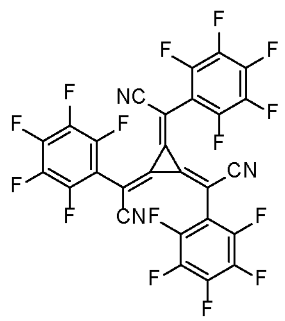

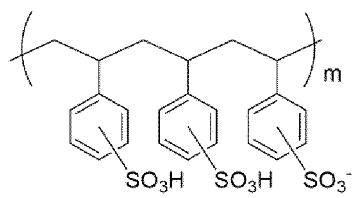
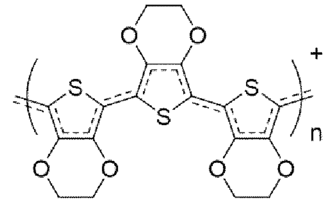

Next, preferred compound examples for use as an electron injection material are shown below. LiF, CsF,

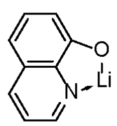

Barrier Layer:

A barrier layer is a layer capable of inhibiting charges (electrons or holes) and/or excitons present in the light-emitting layer from being diffused outside the light-emitting layer. In some embodiments, the electron barrier layer is between the light-emitting layer and the hole transporting layer, and inhibits electrons from passing through the light-emitting layer toward the hole transporting layer. In some embodiments, the hole barrier layer is between the light-emitting layer and the electron transporting layer, and inhibits holes from passing through the light-emitting layer toward the electron transporting layer. In some embodiments, the barrier layer inhibits excitons from being diffused outside the light-emitting layer. In some embodiments, the electron barrier layer and the hole barrier layer are exciton barrier layers. As used herein, the term "electron barrier layer" or "exciton barrier layer" includes a layer that has the functions of both electron barrier layer and of an exciton barrier layer.

Hole Barrier Layer

A hole barrier layer acts as an electron transporting layer. In some embodiments, the hole barrier layer inhibits holes from reaching the electron transporting layer while transporting electrons. In some embodiments, the hole barrier layer enhances the recombination probability of electrons and holes in the light-emitting layer. The material for the hole barrier layer may be the same materials as the ones described for the electron transporting layer.

Preferred compound examples for use for the hole barrier layer are shown below.

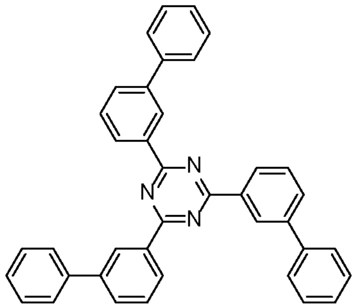
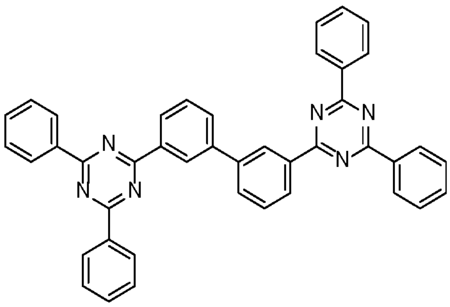
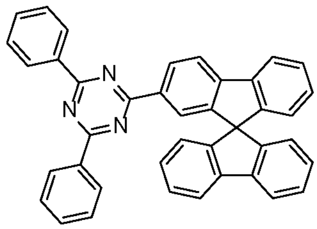
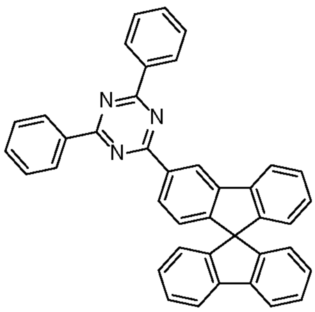
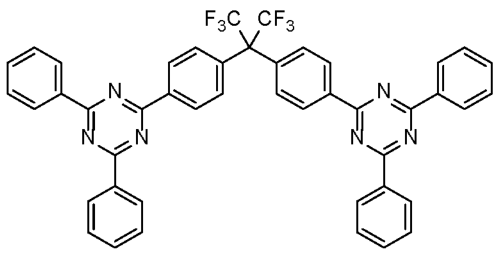
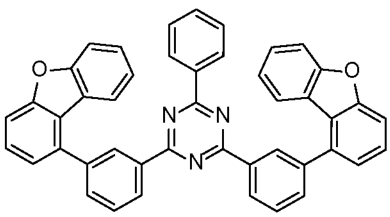
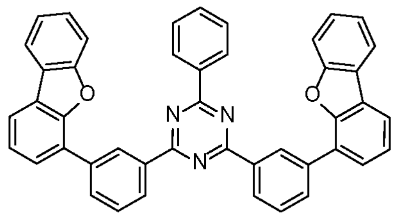
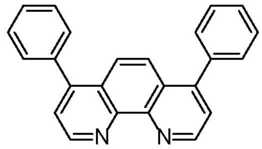
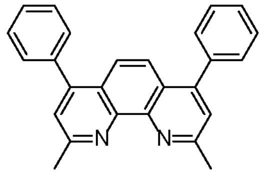

Electron Barrier Layer:

As electron barrier layer transports holes. In some embodiments, the electron barrier layer inhibits electrons from reaching the hole transporting layer while transporting holes. In some embodiments, the electron barrier layer enhances the recombination probability of electrons and holes in the light-emitting layer. The material for the electron barrier layer may be the same materials as the ones described for the hole transporting layer.

Preferred compound examples for use as the electron barrier material are shown below.

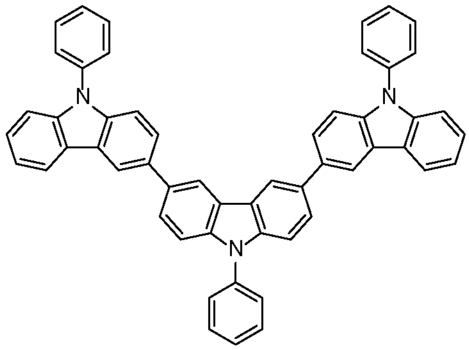
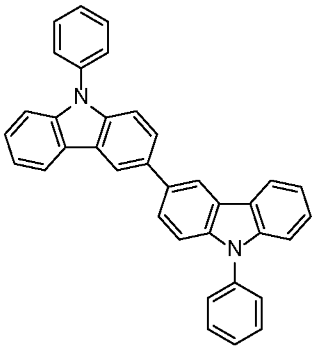
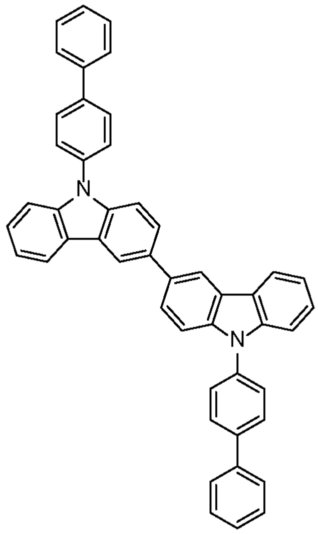

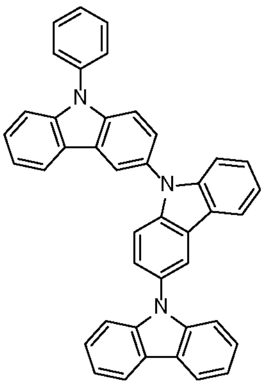
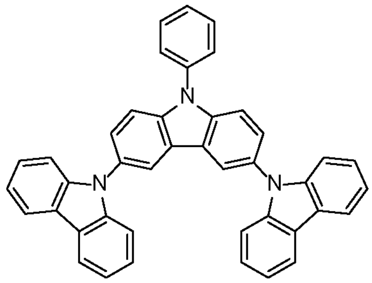
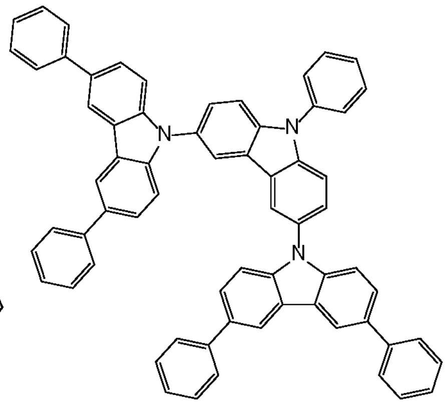

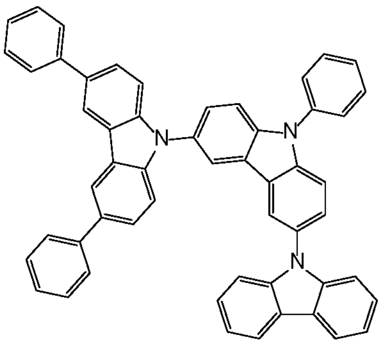
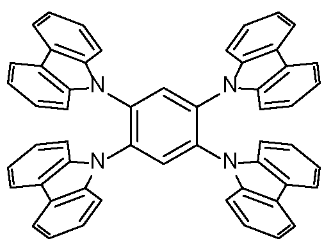
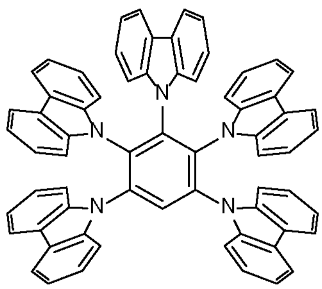

Exciton Barrier Layer:

An exciton barrier layer inhibits excitons generated through recombination of holes and electrons in the light-emitting layer from being diffused to the charge transporting layer. In some embodiments, the exciton barrier layer enables effective confinement of excitons in the light-emitting layer. In some embodiments, the light emission efficiency of the device is enhanced. In some embodiments, the exciton barrier layer is adjacent to the light-emitting layer on any of the side of the anode and the side of the cathode, and on both the sides. In some embodiments, where the exciton barrier layer is on the side of the anode, the layer can be between the hole transporting layer and the light-emitting layer and adjacent to the light-emitting layer. In some embodiments, where the exciton barrier layer is on the side of the cathode, the layer can be between the light-emitting layer and the cathode and adjacent to the light-emitting layer. In some embodiments, a hole injection layer, an electron barrier layer, or a similar layer is between the anode and the

exciton barrier layer that is adjacent to the light-emitting layer on the side of the anode. In some embodiments, a hole injection layer, an electron barrier layer, a hole barrier layer, or a similar layer is between the cathode and the exciton barrier layer that is adjacent to the light-emitting layer on the side of the cathode. In some embodiments, the exciton barrier layer comprises excited singlet energy and excited triplet energy, at least one of which is higher than the excited singlet energy and the excited triplet energy of the light-emitting material, respectively.

Hole Transporting Layer:

The hole transporting layer comprises a hole transporting material. In some embodiments, the hole transporting layer is a single layer. In some embodiments, the hole transporting layer comprises a plurality of layers.

In some embodiments, the hole transporting material has one of injection or transporting property of holes and barrier property of electrons. In some embodiments, the hole transporting material is an organic material. In some embodiments, the hole transporting material is an inorganic material. Examples of known hole transporting materials that may be used herein include but are not limited to a triazole derivative, an oxadiazole derivative, an imidazole derivative, a carbazole derivative, an indolocarbazole derivative, a polyarylalkane derivative, a pyrazoline derivative, a pyrazolone derivative, a phenylenediamine derivative, an arylamine derivative, an amino-substituted chalcone derivative, an oxazole derivative, a styryl anthracene derivative, a fluorenone derivative, a hydrazone derivative, a stilbene derivative, a silazane derivative, an aniline copolymer and an electroconductive polymer oligomer, particularly a thiophene oligomer, or a combination thereof. In some embodiments, the hole transporting material is selected from a porphyrin compound, an aromatic tertiary amine compound, and a styrylamine compound. In some embodiments, the hole transporting material is an aromatic tertiary amine compound. Preferred compound examples for use as the hole transporting material are shown below.

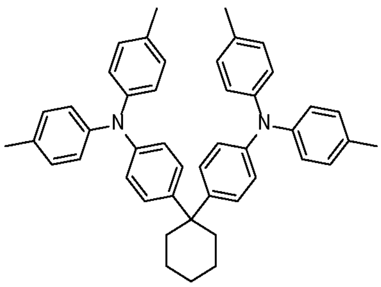
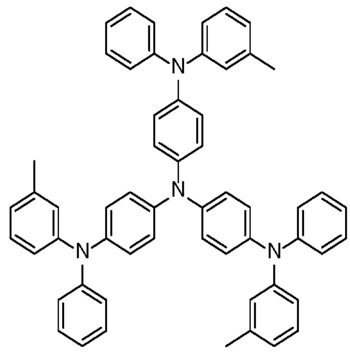
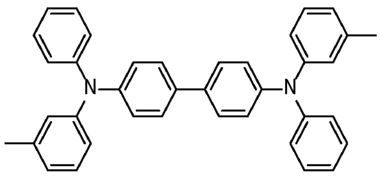
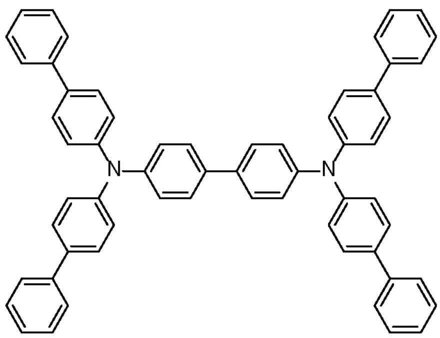
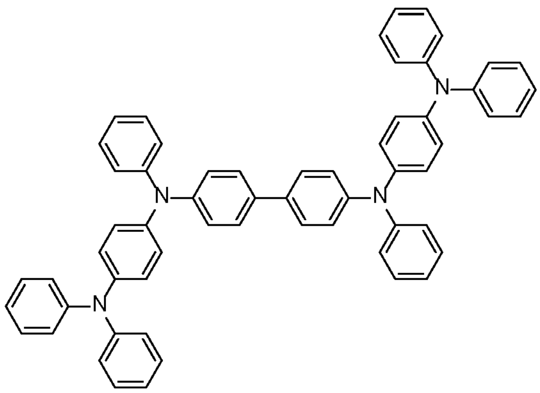
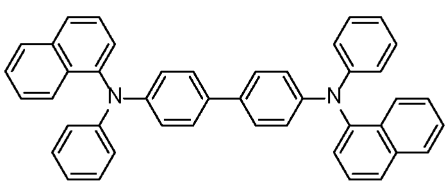
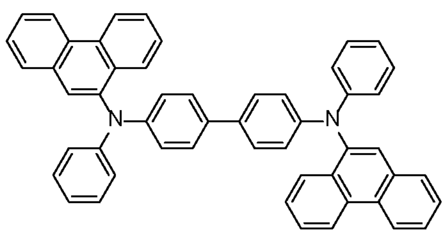

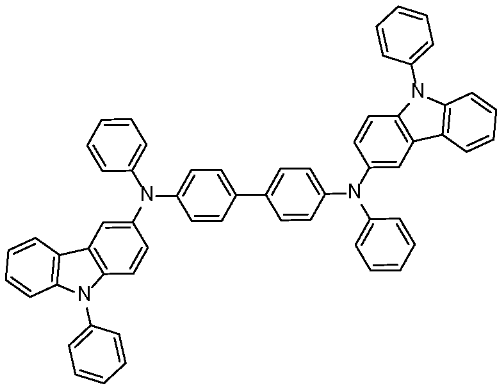

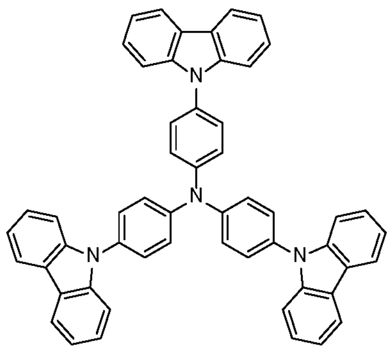

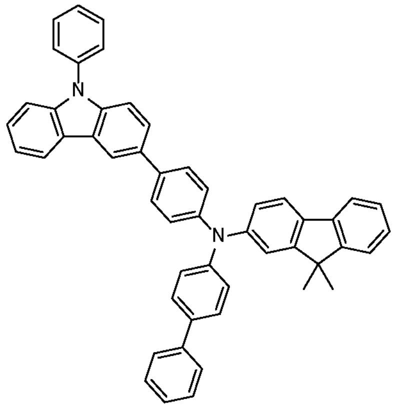

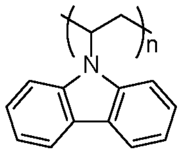

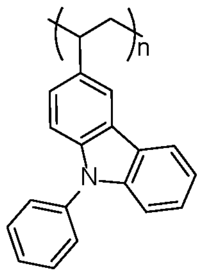

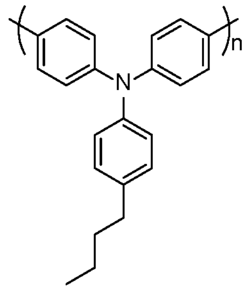

Electron Transporting Layer

The electron transporting layer comprises an electron transporting material. In some embodiments, the electron transporting layer is a single layer. In some embodiments, the electron transporting layer comprises a plurality of layer.

In some embodiments, the electron transporting material needs only to have a function of transporting electrons, which are injected from the cathode, to the light-emitting layer. In some embodiments, the electron transporting material also function as a hole barrier material. Examples of the electron transporting layer that may be used herein include but are not limited to a nitro-substituted fluorene derivative, a diphenylquinone derivative, a thiopyran dioxide derivative, carbodiimide, a fluorenylidene methane derivative, anthraquinodimethane, an anthrone derivatives, an azole derivative, an azine derivative, an oxadiazole derivative, or a combination thereof, or a polymer thereof. In some embodiments, the electron transporting material is a thiadiazole derivative, or a quinoxaline derivative. In some embodiments, the electron transporting material is a polymer material. Preferred compound examples for use as the electron transporting material are shown below.

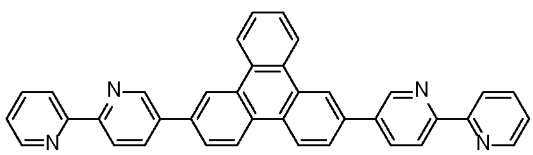

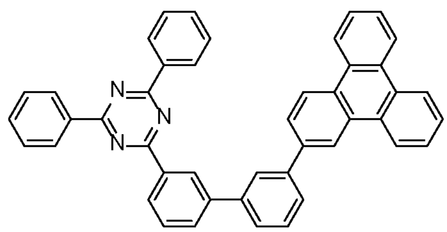

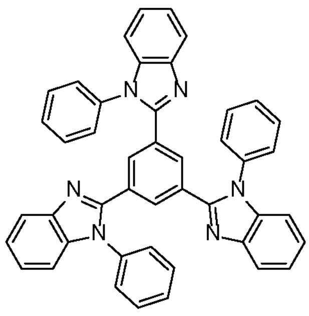
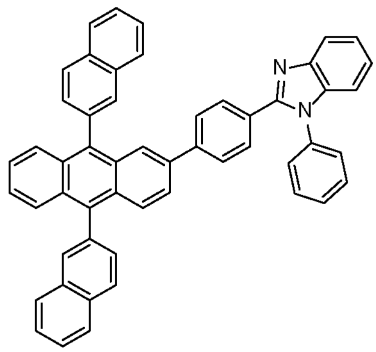
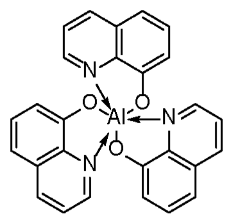

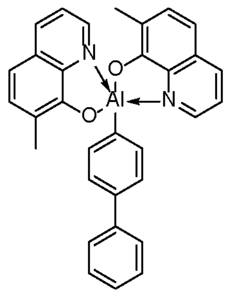
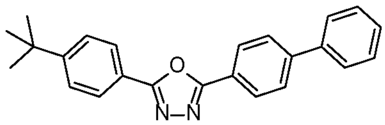
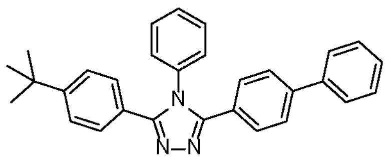

Hereinunder compound examples preferred as a material that can be added to the organic layers are shown. For example, these can be added as a stabilization material.

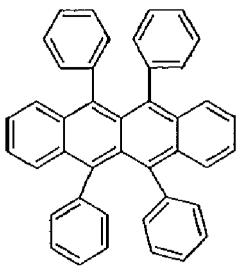
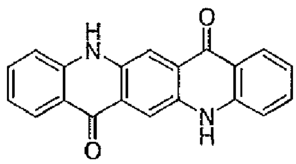
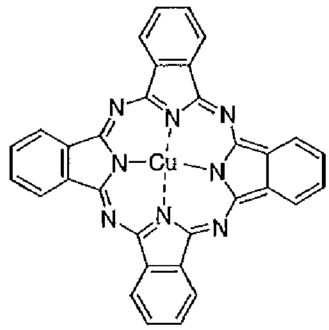

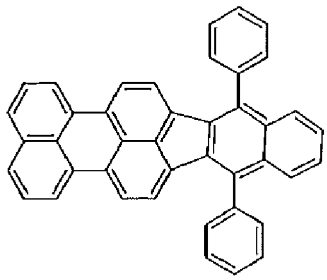
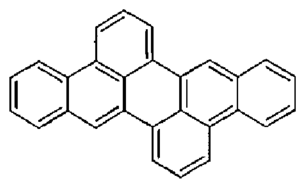

Preferred materials for use in the organic electroluminescent device are specifically shown. However, the materials usable in the invention should not be limitatively interpreted by the following exemplary compounds. Compounds that are exemplified as materials having a specific function can also be used as materials having any other function.

Devices:

In some embodiments, an light emitting layer is incorporated into a device. For example, the device includes, but is not limited to an OLED bulb, an OLED lamp, a television screen, a computer monitor, a mobile phone, and a tablet.
In some embodiments, an electronic device comprises an OLED comprising an anode, a cathode, and at least

one organic layer comprising a light emitting layer between the anode and the cathode.

In some embodiments, compositions described herein may be incorporated into various light-sensitive or light-activated devices, such as a OLEDs or photovoltaic devices. In some embodiments, the composition may be useful in facilitating charge transfer or energy transfer within a device and/or as a hole-transport material. The device may be, for example, an organic light-emitting diode (OLED), an organic integrated circuit (O-IC), an organic field-effect transistor (O-FET), an organic thin-film transistor (O-TFT), an organic light-emitting transistor (O-LET), an organic solar cell (O-SC), an organic optical detector, an organic photoreceptor, an organic field-quench device (O-FQD), a light-emitting electrochemical cell (LEC) or an organic laser diode (O-laser).

Bulbs or Lamps:

In some embodiments, an electronic device comprises an OLED comprising an anode, a cathode, and at least one organic layer comprising a light emitting layer between the anode and the cathode.

In some embodiments, a device comprises OLEDs that differ in color. In some embodiments, a device comprises an array comprising a combination of OLEDs. In some embodiments, the combination of OLEDs is a combination of three colors (e.g., RGB). In some embodiments, the combination of OLEDs is a combination of colors that are not red, green, or blue (for example, orange and yellow green). In some embodiments, the combination of OLEDs is a combination of two, four, or more colors.

In some embodiments, a device is an OLED light comprising:

a circuit board having a first side with a mounting surface and an opposing second side, and defining at least one aperture;
at least one OLED on the mounting surface, the at least one OLED configured to emanate light, comprising:

an anode, a cathode, and at least one organic layer comprising a light emitting layer between the anode and the cathode;
a housing for the circuit board; and
at least one connector arranged at an end of the housing, the housing and the connector defining a package adapted for installation in a light fixture.

In some embodiments, the OLED light comprises a plurality of OLEDs mounted on a circuit board such that light emanates in a plurality of directions. In some embodiments, a portion of the light emanated in a first direction is deflected to emanate in a second direction. In some embodiments, a reflector is used to deflect the light emanated in a first direction.

Displays or Screens:

In some embodiments, the compounds of the invention can be used in a screen or a display. In some embodiments, the compounds of the invention are deposited onto a substrate using a process including, but not limited to, vacuum evaporation, deposition, vapor deposition, or chemical vapor deposition (CVD). In some embodiments, the substrate is a photoplate structure useful in a two-sided etch provides a unique aspect ratio pixel. The screen (which may also be referred to as a mask) is used in a process in the manufacturing of OLED displays. The corresponding artwork pattern design facilitates a very steep and narrow tie-bar between the pixels in the vertical direction and a large, sweeping bevel opening in the horizontal direction. This allows the close patterning of pixels needed for high definition displays while optimizing the chemical deposition onto a TFT backplane.

The internal patterning of the pixel allows the construction of a 3-dimensional pixel opening with varying aspect ratios in the horizontal and vertical directions. Additionally, the use of imaged "stripes" or halftone circles within the pixel area inhibits etching in specific areas until these specific patterns are undercut and fall off the substrate. At that point the entire pixel area is subjected to a similar etch rate but the depths are varying depending on the halftone pattern. Varying the size and spacing of the halftone pattern allows etching to be inhibited at different rates within the pixel allowing for a localized deeper etch needed to create steep vertical bevels.

A preferred material for the deposition mask is invar. Invar is a metal alloy that is cold rolled into long thin sheet in a steel mill. Invar cannot be electrodeposited onto a rotating mandrel as the nickel mask. A preferred and more cost feasible method for forming the open areas in the mask used for deposition is through a wet chemical etching.

In some embodiments, a screen or display pattern is a pixel matrix on a substrate. In some embodiments, a screen or display pattern is fabricated using lithography (e.g., photolithography and e-beam lithography). In some embodiments, a screen or display pattern is fabricated using a wet chemical etch. In further embodiments, a screen or display pattern is fabricated using plasma etching.

Methods of Manufacturing Devices Using the Disclosed Compounds

An OLED display is generally manufactured by forming a large mother panel and then cutting the mother panel in units of cell panels. In general, each of the cell panels on the mother panel is formed by forming a thin film transistor (TFT) including an active layer and a source/drain electrode on a base substrate, applying a planarization film to the TFT, and sequentially forming a pixel electrode, a light-emitting layer, a counter electrode, and an encapsulation layer, and then is cut from the mother panel.

An OLED display is generally manufactured by forming a large mother panel and then cutting the mother panel in units of cell panels. In general, each of the cell panels on the mother panel is formed by forming a thin film transistor (TFT) including an active layer and a source/drain electrode on a base substrate, applying a planarization film to the TFT, and sequentially forming a pixel electrode, a light-emitting layer, a counter electrode, and an encapsulation layer, and then is cut from the mother panel.

In another aspect, provided herein is a method of manufacturing an organic light-emitting diode (OLED) display, the method comprising:

forming a barrier layer on a base substrate of a mother panel;
forming a plurality of display units in units of cell panels on the barrier layer;
forming an encapsulation layer on each of the display units of the cell panels;
applying an organic film to an interface portion between the cell panels.

In some embodiments, the barrier layer is an inorganic film formed of, for example, SiNx, and an edge portion of the barrier layer is covered with an organic film formed of polyimide or acryl. In some embodiments, the organic film helps the mother panel to be softly cut in units of the cell panel.

In some embodiments, the thin film transistor (TFT) layer includes a light-emitting layer, a gate electrode, and a source/drain electrode. Each of the plurality of display units may include a thin film transistor (TFT) layer, a planarization film formed on the TFT layer, and a light-emitting unit formed on the planarization film, wherein the organic film applied to the interface portion is formed of a same material as a material of the planarization film and is formed at a same time as the planarization film is formed. In some embodiments, a light-emitting unit is connected to the TFT layer with a passivation layer and a planarization film therebetween and an encapsulation layer that covers and protects the light-emitting unit. In some embodiments of the method of manufacturing, the organic film contacts neither the display units nor the encapsulation layer.

Each of the organic film and the planarization film may include any one of polyimide and acryl. In some embodiments, the barrier layer may be an inorganic film. In some embodiments, the base substrate may be formed of polyimide. The method may further include, before the forming of the barrier layer on one surface of the base substrate formed of polyimide, attaching a carrier substrate formed of a glass material to another surface of the base substrate, and before the cutting along the interface portion, separating the carrier substrate from the base substrate. In some embodiments, the OLED display is a flexible display.

In some embodiments, the passivation layer is an organic film disposed on the TFT layer to cover the TFT layer. In some embodiments, the planarization film is an organic film formed on the passivation layer. In some embodiments, the planarization film is formed of polyimide or acryl, like the organic film formed on the edge portion of the barrier layer. In some embodiments, the planarization film and the organic film are simultaneously formed when the OLED display is manufactured. In some embodiments, the organic film may be formed on the edge portion of the barrier layer such that a portion of the organic film directly contacts the base substrate and a remaining portion of the organic film contacts the barrier layer while surrounding the edge portion of the barrier layer.

In some embodiments, the light-emitting layer includes a pixel electrode, a counter electrode, and an organic light-emitting layer disposed between the pixel electrode and the counter electrode. In some embodiments, the pixel electrode is connected to the source/drain electrode of the TFT layer.

In some embodiments, when a voltage is applied to the pixel electrode through the TFT layer, an appropriate voltage is formed between the pixel electrode and the counter electrode, and thus the organic light-emitting layer emits light, thereby forming an image. Hereinafter, an image forming unit including the TFT layer and the light-emitting unit is referred to as a display unit.

In some embodiments, the encapsulation layer that covers the display unit and prevents penetration of external moisture may be formed to have a thin film encapsulation structure in which an organic film and an inorganic film are alternately stacked. In some embodiments, the encapsulation layer has a thin film encapsulation structure in which a plurality of thin films are stacked. In some embodiments, the organic film applied to the interface portion is spaced apart from each of the plurality of display units. In some embodiments, the organic film is formed such that a portion of the organic film directly contacts the base substrate and a remaining portion of the organic film contacts the barrier layer while surrounding an edge portion of the barrier layer.

In one embodiment, the OLED display is flexible and uses the soft base substrate formed of polyimide. In some embodiments, the base substrate is formed on a carrier substrate formed of a glass material, and then the carrier substrate is separated.

In some embodiments, the barrier layer is formed on a surface of the base substrate opposite to the carrier substrate. In one embodiment, the barrier layer is patterned according to a size of each of the cell panels. For example, while the base substrate is formed over the entire surface of a mother panel, the barrier layer is formed according to a size of each of the cell panels, and thus a groove is formed at an interface portion between the barrier layers of the cell panels. Each of the cell panels can be cut along the groove.

In some embodiments, the method of manufacture further comprises cutting along the interface portion, wherein a groove is formed in the barrier layer, wherein at least a portion of the organic film is formed in the groove, and wherein the groove does not penetrate into the base substrate. In some embodiments, the TFT layer of each of the cell panels is formed, and the passivation layer which is an inorganic film and the planarization film which is an organic film are disposed on the TFT layer to cover the TFT layer. At the same time as the planarization film formed of, for example, polyimide or acryl is formed, the groove at the interface portion is covered with the organic film formed of, for example, polyimide or acryl. This is to prevent cracks from occurring by allowing the organic film to absorb an impact generated when each of the cell panels is cut along the groove at the interface portion. That is, if the entire barrier layer is entirely exposed without the organic film, an impact generated when each of the cell panels is cut along the groove at the interface portion is transferred to the barrier layer, thereby increasing the risk of cracks. However, in one embodiment, since the groove at the interface portion between the barrier layers is covered with the organic film and the organic film absorbs an impact that would otherwise be transferred to the barrier layer, each of the cell panels may be softly cut and cracks may be prevented from occurring in the barrier layer. In one embodiment, the organic film covering the groove at the interface portion and the planarization film are spaced apart from each other. For example, if the organic film and the planarization film are connected to each other as one layer, since external moisture may penetrate into the display unit through the planarization film and a portion where the organic film remains, the organic film and the planarization film are spaced apart from each other such that the organic film is spaced apart from the display unit.

In some embodiments, the display unit is formed by forming the light-emitting unit, and the encapsulation layer is disposed on the display unit to cover the display unit. As such, once the mother panel is completely manufactured, the carrier substrate that supports the base substrate is separated from the base substrate. In some embodiments, when a laser beam is emitted toward the carrier substrate, the carrier substrate is separated from the base substrate due to a difference in a thermal expansion coefficient between the carrier substrate and the base substrate.

In some embodiments, the mother panel is cut in units of the cell panels. In some embodiments, the mother panel is cut along an interface portion between the cell panels by using a cutter. In some embodiments, since the groove at the interface portion along which the mother panel is cut is covered with the organic film, the organic film absorbs an impact during the cutting. In some embodiments, cracks may be prevented from occurring in the barrier layer during the cutting.

In some embodiments, the methods reduce a defect rate of a product and stabilize its quality.

Another aspect is an OLED display including: a barrier layer that is formed on a base substrate; a display unit that is formed on the barrier layer; an encapsulation layer that is formed on the display unit; and an organic film that is applied to an edge portion of the barrier layer.

Example

The characteristics of the present invention will be explained in more detail with reference to Examples below. The materials, processes, procedures and the like shown below may be appropriately modified unless they deviate from the substance of the present invention. Accordingly, the scope of the present invention is not construed as being limited to the specific examples shown below. The light emission characteristics were evaluated using a source meter (available from Keithley Instruments Corporation: 2400 series), a semiconductor parameter analyzer (available from Agilent Technologies, E5273A), an optical power meter device (available from Newport Corporation, 1930C), an optical spectroscope (available from Ocean Optics Corporation, USB2000), a spectroradiometer (available from Topcon Corporation, SR-3), and a streak camera (available from Hamamatsu Photonics K.K., Model C4334). Further, the lowest excited singlet energy Esi and the lowest excited triplet energy $E_{T1}$ of the compounds used in the following Examples and Comparative Examples are as shown in the table below.

Table 1

| | | $E_{S1}$(eV) | $E_{T1}$ (eV) |
|---|---|---|---|
| First organic compound | Compound H4 | 3.70 | 2.80 |

(continued)

| | | $E_{S1}$(eV) | $E_{T1}$ (eV) |
|---|---|---|---|
| Second organic compound | Compound T13 | 2.78 | 2.66 |
| Third organic compound | Compound E1 | 2.72 | 2.59 |

(Example 1)

On a glass substrate having a film thickness of 100 nm, in which an anode composed of indium tin oxide (ITO) is formed, each film was stacked according to a vacuum deposition method under a vacuum degree of $1 \times 10^{-6}$ Pa. First, on ITO, HATCN was formed to have a thickness of 10 nm, then NPD was formed thereon to have a thickness of 35 nm, and further thereon, EB1 was formed to have a thickness of 10 nm. Next, the compound H4 was formed to have a thickness of 5 nm to form an adjacent layer. Further, the compound H4 (69.5 % by weight), the compound T13 (30.0 % by weight) and the compound E1 (0.5 % by weight) were co-deposited from different vapor deposition sources to form a light emitting layer having a thickness of 40 nm. Next, HB1 was formed to have a thickness of 13 nm, and ET1 was formed to have a thickness of 20 nm. Further, Liq was formed to have a thickness of 2 nm, then Aluminum (Al) was vapor-deposited to have a thickness of 100 nm to form a cathode. In this way, the organic electroluminescent device of Example 1 having a layer constitution shown in Fig. 1 was manufactured.

(Comparative example 1)

The organic electroluminescent device of Comparative Example 1 was manufactured by carrying out the manufacturing method of Example 1 with a modification that no adjacent layer was formed.

(Comparative example 2)

The organic electroluminescent device of Comparative Example 2 was manufactured by carrying out the manufacturing method of Example 1 with a modification that the compound T13 was used instead of the compound H4 in the adjacent layer.

(Evaluation)

When each of the produced organic electroluminescent devices was energized, emission of delayed fluorescence derived from the third organic compound E1 was observed (each had a maximum emission wavelength of 472 nm). The external quantum efficiency (EQE) of the three organic electroluminescent devices were measured. In addition, the time (LT95) until the emission intensity reached 95% of the time when the current was started by continuing to apply electricity at 2 $mA/cm^2$ was measured, and when the LT95 of the device of Comparative Example 1 was set to 1, the relative values are shown in Table 2. As shown in Table 2, it was confirmed that the device of Example 1 in which an adjacent layer composed of the first organic compound was formed, has higher light emission efficiency and longer device lifetime than the device of Comparative Example 1 in which no adjacent layer was formed, or the device of the Comparative example2 in which the adjacent layer was composed of a compound other than the first organic compound. In particular, compared to the device of Comparative Example 1 in which no adjacent layer was formed, the device of Example 1 of the present invention improved the light emission efficiency by 3.5%, achieved a high EQE of 23.6%, and had longer device lifetime by 1.52 times.

Table 2

| | Adj acent layer | Light emitting layer | | | EQE (%) | LT95 (Relative value) |
|---|---|---|---|---|---|---|
| | | First organic compound | Second organic compound | Third organic compound | | |
| Example 1 | Compound H4 | Compound H4 | Compound T13 | Compound E1 | 23.6 | 1.52 |
| Comparative example 1 | Not formed | Compound H4 | Compound T13 | Compound E1 | 20.1 | 1 |

(continued)

| | Adj acent layer | Light emitting layer | | | EQE (%) | LT95 (Relative value) |
|---|---|---|---|---|---|---|
| | | First organic compound | Second organic compound | Third organic compound | | |
| Comparative example 2 | Compound T13 | Compound H4 | Compound T13 | Compound E1 | 21.4 | 0.13 |

(Example 2)

The organic electroluminescent device of Example 2 was manufactured by carrying out the manufacturing method of Example 1 with a modification that the composition in the light emitting layer was changed to be composed only of the compound H4 (69.7 % by weight), the compound T13 (30.0 % by weight), and the compound E1 (0.3 % by weight). LT95 was measured, and it was confirmed that the device lifetime was 1.2 times longer than that of the device of Example 1.

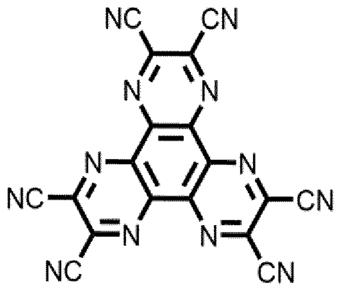
HATCN

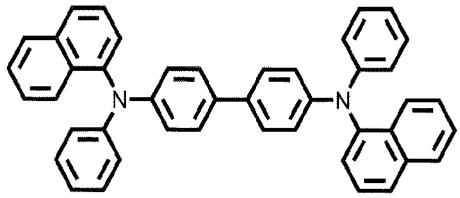
NPD

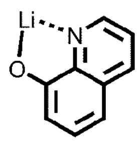
Liq

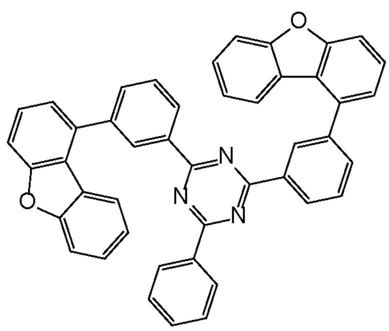
HB1

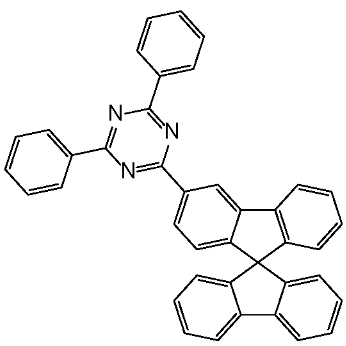
ET1

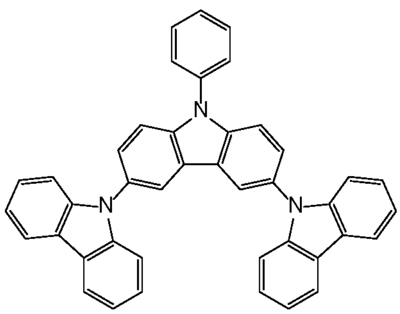
EB1

Industrial Applicability

According to the present invention, the organic light emitting device having long device life time and high light emission efficiency, can be provided. Therefore, the present invention has high industrial applicability.

Reference Signs List

1: Glass substrate
2: Anode
3: Hole Injection Layer
4: Hole Transporting Layer

5: Electron Barrier Layer
6: Adjacent layer
7: Light emitting layer
8: Hole Barrier layer
9: Electron Transporting Layer
10: Electron Injection Layer
11: Cathode

## Claims

**1.** An organic light emitting device comprising:

a light emitting layer having a first organic compound, a second organic compound, and third organic compound, satisfying the following condition (a); and
an adjacent layer adjacent to the light emitting layer,

wherein:

the second organic compound is a delayed fluorescent material, and
the adjacent layer contains the first organic compound,

$$\text{condition (a): } E_{S1}(1)>E_{S1}(2)>E_{S1}(3),$$

wherein $E_{S1}(1)$ represents a lowest excited singlet energy of the first organic compound,
Esi(2) represents a lowest excited singlet energy of the second organic compound, and
Esi(3) represents a lowest excited singlet energy of the third organic compound.

**2.** The organic light emitting device according to claim 1,
wherein the adjacent layer is composed only of the first organic compound.

**3.** The organic light emitting device according to claim 1 or 2,
wherein the light emitting layer is between an anode and a cathode, and the adjacent layer is adjacent to the anode side of the light emitting layer.

**4.** The organic light emitting device according to any one of claims 1 to 3, wherein a thickness of the adjacent layer is less than 10 nm.

**5.** The organic light emitting device according to any one of claims 1 to 4,
wherein the thickness of the adjacent layer is less than one-sixth of the thickness of the light emitting layer.

**6.** The organic light emitting device according to any one of claims 1 to 5,
wherein a difference $\Delta E_{st}$ between the lowest excited singlet state energy and the lowest excited triplet state energy at 77K of the second organic compound is 0.3 eV or less.

**7.** The organic light emitting device according to any one of claims 1 to 6,
wherein a difference $\Delta E_{st}$ between the lowest excited singlet state energy and the lowest excited triplet state energy at 77K of the third organic compound is 0.3 eV or less.

**8.** The organic light emitting device according to any one of claims 1 to 7,
wherein the first organic compound, the second organic compound and the third organic compound satisfy the following condition (b),

$$\text{condition (b): } E_{T1}(1)>E_{T1}(2)>E_{T1}(3),$$

in which $E_{T1}(1)$ represents a lowest excited triplet energy at 77K of the first organic compound,

$E_{T1}(2)$ represents a lowest excited triplet energy at 77K of the second organic compound, and
$E_{T1}(3)$ represents a lowest excited triplet energy at 77K of the third organic compound.

**9.** The organic light emitting device according to any one of claims 1 to 8, wherein the light emitting layer is composed only of a compound comprising atoms selected from the group consisting of carbon atom, hydrogen atom, deuterium atom, nitrogen atom, boron atom, oxygen atom and sulfur atom.

**10.** The organic light emitting device according to any one of claims 1 to 9, wherein the first organic compound is a compound consisting of atoms selected from the group consisting of carbon atom, hydrogen atom, deuterium atom, nitrogen atom, and oxygen atom.

**11.** The organic light emitting device according to any one of claims 1 to 10, wherein the second organic compound is a compound consisting of atoms selected from the group consisting of carbon atom, hydrogen atom, deuterium atom, nitrogen atom, oxygen atom and sulfur atom.

**12.** The organic light emitting device according to any one of claims 1 to 11, wherein the third organic compound is a compound consisting of atoms selected from the group consisting of carbon atom, hydrogen atom, deuterium atom, nitrogen atom, boron atom, oxygen atom and sulfur atom.

**13.** The organic light emitting device according to any of claims 1 to 12, wherein the second organic compound contains a cyanobenzene structure.

FIG. 1

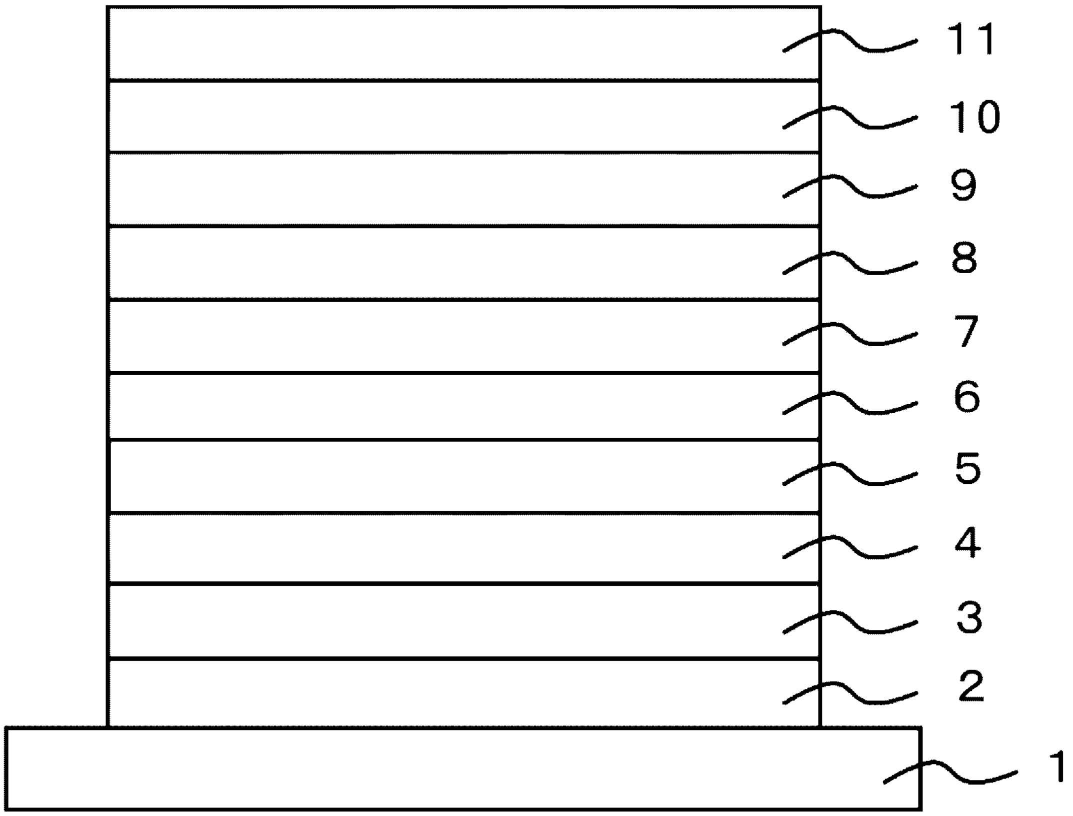

FIG. 2

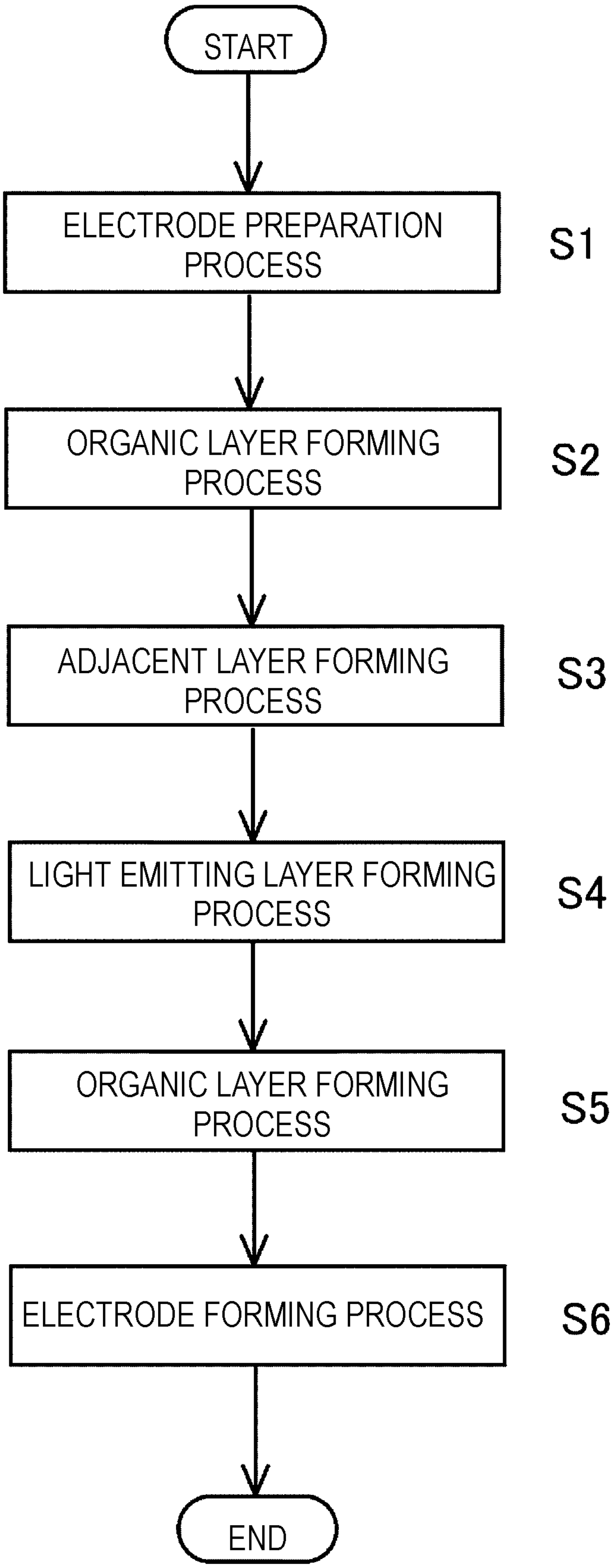
START
ELECTRODE PREPARATION PROCESS
S1
ORGANIC LAYER FORMING PROCESS
S2
ADJACENT LAYER FORMING PROCESS
S3
LIGHT EMITTING LAYER FORMING PROCESS
S4
ORGANIC LAYER FORMING PROCESS
S5
ELECTRODE FORMING PROCESS
S6
END

**INTERNATIONAL SEARCH REPORT**

International application No.
**PCT/JP2022/015886**

**A. CLASSIFICATION OF SUBJECT MATTER**

***H01L 51/50***(2006.01)i
FI: H05B33/14 B; H05B33/22 D

According to International Patent Classification (IPC) or to both national classification and IPC

**B. FIELDS SEARCHED**

Minimum documentation searched (classification system followed by classification symbols)

H01L51/50

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| X | WO 2020/039708 A1 (UNIV KYUSHU NAT UNIV CORP) 27 February 2020 (2020-02-27) claims, paragraphs [0014]-[0106], [0126], [0153]-[0208] | 1-13 |
| X | JP 2020-158425 A (IDEMITSU KOSAN CO) 01 October 2020 (2020-10-01) claims, paragraphs [0066]-[0111], [0276]-[0323], [0327]-[0328], [0399]-[0416], fig. 1, 5 | 1-13 |
| Y | | 7 |
| X | JP 2020-174072 A (IDEMITSU KOSAN CO) 22 October 2020 (2020-10-22) claims, paragraphs [0024]-[0134], [0174]-[0216], [0292]-[0314], fig. 1, 5 | 1-6, 8-13 |
| Y | | 7 |
| A | JP 5669163 B1 (UNIV KYUSHU NAT UNIV CORP) 12 February 2015 (2015-02-12) entire text | 1-13 |

☐ Further documents are listed in the continuation of Box C.　☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **14 June 2022** | **28 June 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2022/015886**

| Patent document cited in search report | Publication date (day/month/year) | Patent family member(s) | Publication date (day/month/year) |
|---|---|---|---|
| WO 2020/039708 A1 | 27 February 2020 | US 2021/0202864 A1<br>claims, paragraphs [0018]-[0232], [0258]-[0259], [0274]-[0378]<br>EP 3843167 A1<br>CN 112602206 A<br>KR 10-2021-0043688 A<br>JP 2020-31162 A | |
| JP 2020-158425 A | 01 October 2020 | (Family: none) | |
| JP 2020-174072 A | 22 October 2020 | (Family: none) | |
| JP 5669163 B1 | 12 February 2015 | US 2016/0190478 A1<br>whole document<br>US 2021/0074927 A1<br>WO 2015/022974 A1<br>EP 3035401 A1<br>EP 3706182 A1<br>TW 201510175 A<br>CN 105453294 A<br>KR 10-2016-0044522 A<br>KR 10-2020-0140938 A<br>KR 10-2021-0148427 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2014043541 A
- JP 2015179809 A
- WO 2013154064 A
- WO 2013011954 A
- WO 2013011955 A
- WO 2013081088 A
- JP 2013256490 A
- JP 2013116975 A
- WO 2013133359 A
- WO 2013161437 A
- JP 2014009352 A
- JP 2014009224 A
- JP 2017 A
- JP 119663 A
- JP 2017119664 A
- JP 2017222623 A
- JP 2017226838 A
- JP 2018100411 A
- WO 2018047853 A
- JP 2013253121 A
- WO 2014034535 A
- WO 2014115743 A
- WO 2014122895 A
- WO 2014126200 A
- WO 2014136758 A
- WO 2014133121 A
- WO 2014136860 A
- WO 2014196585 A
- WO 2014189122 A
- WO 2014168101 A
- WO 2015008580 A
- WO 2014203840 A
- WO 2015002213 A
- WO 2015016200 A
- WO 2015019725 A
- WO 2015072470 A
- WO 2015108049 A
- WO 2015080182 A
- WO 2015072537 A
- WO 2015080183 A
- JP 2015 A
- JP 129240 A
- WO 2015129714 A
- WO 2015129715 A
- WO 2015133501 A
- WO 2015136880 A
- WO 2015137244 A
- WO 2015137202 A
- WO 2015137136 A
- WO 2015146541 A
- WO 2015159541 A
- JP 2017119663 A
- WO 2015022974 A

### Non-patent literature cited in the description

- **H. UOYAMA et al.** *Nature,* 2012, vol. 492, 234
- **HANSCH, C.** *Chem. Rev.,* 1991, vol. 91, 165-195
- *Appl. Phys. Let,* 2011, vol. 98, 083302